(19) Europäisches Patentamt
European Patent Office
Office européen des brevets

(11) **EP 2 823 360 B1**

(12) **EUROPÄISCHE PATENTSCHRIFT**

(45) Veröffentlichungstag und Bekanntmachung des Hinweises auf die Patenterteilung:
**22.06.2022 Patentblatt 2022/25**

(21) Anmeldenummer: **13707849.9**

(22) Anmeldetag: **04.03.2013**

(51) Internationale Patentklassifikation (IPC):
**G03F 7/20** (2006.01)    **G02B 5/09** (2006.01)
**G02B 27/48** (2006.01)    **G02B 5/08** (2006.01)
**G02B 27/09** (2006.01)

(52) Gemeinsame Patentklassifikation (CPC):
**G02B 5/0891; G02B 5/09; G02B 27/0927;
G02B 27/0933; G02B 27/0977; G02B 27/48;
G03F 7/70075; G03F 7/70583**

(86) Internationale Anmeldenummer:
**PCT/EP2013/054233**

(87) Internationale Veröffentlichungsnummer:
**WO 2013/131834 (12.09.2013 Gazette 2013/37)**

(54) **BELEUCHTUNGSOPTIK FÜR DIE EUV-PROJEKTIONSLITHOGRAFIE SOWIE OPTISCHES SYSTEM MIT EINER DERARTIGEN BELEUCHTUNGSOPTIK**

ILLUMINATION OPTICS FOR EUV PROJECTION LITHOGRAPHY AND OPTICAL SYSTEM HAVING SUCH AN ILLUMINATION OPTICS

OPTIQUE D'ÉCLAIRAGE POUR LA LITHOGRAPHIE PAR PROJECTION EUV AINSI QUE SYSTÈME OPTIQUE COMPRENANT UNE TELLE OPTIQUE D'ÉCLAIRAGE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **09.03.2012 DE 102012203716
09.03.2012 US 201261608685 P
04.10.2012 DE 102012218076
04.10.2012 US 201261709510 P**

(43) Veröffentlichungstag der Anmeldung:
**14.01.2015 Patentblatt 2015/03**

(73) Patentinhaber: **Carl Zeiss SMT GmbH
73447 Oberkochen (DE)**

(72) Erfinder:
• **PATRA, Michael
73447 Oberkochen (DE)**
• **DEGÜNTHER, Markus
73432 Aalen (DE)**

(74) Vertreter: **Rau, Schneck & Hübner
Patentanwälte Rechtsanwälte PartGmbB
Königstraße 2
90402 Nürnberg (DE)**

(56) Entgegenhaltungen:
**EP-A1- 1 521 111    EP-A2- 1 793 278
US-A- 5 896 438    US-A1- 2011 001 947**

EP 2 823 360 B1

## Beschreibung

Die Erfindung betrifft eine Beleuchtungsoptik für die EUV-Projektionslithographie. Ferner betrifft die Erfindung ein optisches System mit einer derartigen Beleuchtungsoptik, ein Beleuchtungssystem mit einem derartigen optischen System, eine Projektionsbelichtungsanlage mit einem derartigen Beleuchtungssystem, ein Verfahren zur Projektionsbelichtung zur Herstellung eines mikro- bzw. nanostrukturierten Bauteils, insbesondere eines Halbleiterchips, mithilfe der Projektionsbelichtungsanlage.

Beleuchtungsoptiken für die Projektionslithografie sind bekannt aus der EP 1 451 629 B1 und der US 6,069,739. Aus der EP 1 521 111 A1 und der DE 103 45 430 A1 ist eine Beleuchtungsvorrichtung mit einem Kohärenzminderer bekannt. Dieser ist als Anordnung von gekreuzten Stufenspiegeln ausgeführt, wobei jede der Spiegelstufen mehrere Ausleuchtungskanäle führt.

Eine Projektionsbelichtungsanlage mit einem Beleuchtungssystem ist bekannt aus der WO 2009/121 438 A1. Eine EUV-Lichtquelle ist bekannt aus der DE 103 58 225 B3. Weitere Referenzen, aus denen eine EUV-Lichtquelle bekannt ist, finden sich in der WO 2009/121 438 A1. EUV-Beleuchtungsoptiken sind weiterhin bekannt aus der US 2003/0043359 A1 und der US 5,896,438.

Ein Beleuchtungssystem für die lithografische Herstellung beispielsweise von Flachbildschirmen und integrierten Schaltkreisen ist bekannt aus der EP 1 793 278 A2.

Eine Beleuchtungsoptik für die Projektionslithographie ist weiterhin bekannt aus der US 2007/0295919 A1 und aus der WO 03/048 839 A1.

Es ist eine Aufgabe der vorliegenden Erfindung, eine Beleuchtungsoptik der eingangs genannten Art derart weiterzubilden, dass eine Qualität der Beleuchtung des Beleuchtungsfeldes verbessert ist.

Diese Aufgabe ist erfindungsgemäß gelöst durch eine Beleuchtungsoptik mit den im Anspruch 1 angegebenen Merkmalen.

Bei der Beleuchtungsoptik handelt es sich um eine Beleuchtungsoptik für die EUV-Projektionslithographie. Die longitudinale Kohärenzlänge, im folgenden kurz als Kohärenzlänge bezeichnet, hängt von der genutzten spektralen Bandbreite des Beleuchtungslichts statt. Äquivalent zu einer Kohärenzlänge ist eine Kohärenzzeit, zwischen denen mittels der Lichtgeschwindigkeit umgerechnet werden kann. Findet durch die Beleuchtungsoptik eine spektrale Filterung des Beleuchtungslichtes statt, so ist die relevante Bandbreite diejenige spektrale Bandbreite des Beleuchtungslichts, die im Beleuchtungsfeld ankommt, und nicht die an der Lichtquelle. Kohärenzlängen können im Bereich von beispielsweise 10 $\mu$m liegen. Auch größere Kohärenzlängen sind je nach der verwendeten Lichtquelle möglich.

Erfindungsgemäß wurde erkannt, dass Interferenzprobleme zwischen Teilbündeln des Beleuchtungslichts, die im Beleuchtungsfeld überlagert werden, genau dann entstehen, wenn zu irgendeinem Zeitpunkt an irgendeinem Punkt des Beleuchtungsfeldes mindestens zwei Teilbündel von Beleuchtungslicht auftreffen, und dabei die ab der Lichtquelle gemessenen optischen Weglängen zwischen mindestens zwei dieser Teilbündel sich um weniger als die Kohärenzlänge des Beleuchtungslichts unterscheiden. Eine Ausgestaltung nach Anspruch 1 verhindert, daß die Bedingungen für unerwünschte Interferenz erfüllt sind und damit Interferenzproblemen auftreten können. Die angegebene Bedingung, dass die gegenseitigen Laufzeitunterschiede beliebiger Paare von über verschiedene Ausleuchtungskanäle geführte Beleuchtungslicht-Teilbündeln größer ist als eine Kohärenzdauer des Beleuchtungslichts, gilt für jeden Punkt des Beleuchtungsfeldes. Hierzu wird zunächst jeder der Ausleuchtungskanäle über eine Zuordnung der ersten Facetten zu jeweils genau einem Ausleuchtungskanal exakt definiert. Verschiedene Ausleuchtungskanäle überlappen sich im allgemeinen irgendwo im Raum, sind auf einem Facettenspiegel jedoch räumlich getrennt. Ein und dieselbe Facette führt also das Beleuchtungslicht genau eines Ausleuchtungskanals. Beleuchtungslicht, das über genau einen Ausleuchtungskanal geführt wird, trifft auf dem ersten Facettenspiegel also nicht auf mehrere Facetten gleichzeitig. Auf diese Weise sind Ausleuchtungskanäle eindeutig definiert. Die Teilbündel des Beleuchtungslichts entstehen durch Reflexionen an facettierten optischen Elementen im Strahlengang und verlaufen innerhalb der entsprechenden Ausleuchtungskanäle.

Bei dem ersten Facettenspiegel kann es sich um einen Feldfacettenspiegel handeln, dessen Feldfacetten einander überlagernd in das Beleuchtungsfeld abgebildet werden. Alternativ kann es sich bei dem ersten Facettenspiegel auch um einen spekularen Reflektor handeln. Ein spekularer Reflektor ist bekannt aus der US 2006/0132747 A1, der EP 1 614 008 B1 und der US 6,573,978. Die Ausleuchtungskanäle der Beleuchtungslicht-Teilbündel lassen sich von einer Lichtquelle für das Beleuchtungslicht bis zum Beleuchtungsfeld durch die Beleuchtungsoptik verfolgen. Für die betrachteten Laufzeitunterschiede ist nur derjenige Teil der Ausleuchtungskanäle relevant, in denen diese in der Beleuchtungsoptik voneinander getrennt sind. Anstelle der gesamten Ausleuchtungskanäle ab der Lichtquelle können die Ausleuchtungskanäle beispielsweise ab dem Eingang einer Strahlführung in der Beleuchtungsoptik betrachtet werden.

Neben dem ersten Facettenspiegel hat die Beleuchtungsoptik einen zweiten Facettenspiegel, der dem ersten Facettenspiegel im Strahlengang des Beleuchtungslichts nachgeordnet ist und eine Mehrzahl von zweiten Facetten aufweist. Die ersten und zweiten Facetten sind derart angeordnet, dass jeweils ein Ausleuchtungskanal, der ein Beleuchtungslicht-Teilbündel führt, durch eine erste Facette und eine zugeordnete zweite Facette vorgegeben ist. Über jeweils eine der Facetten ist genau ein Ausleuchtungskanal geführt. Eine derartige Ausgestaltung hat sich zur Vorgabe einer einzustellenden Beleuchtung als besonders geeignet herausgestellt. Der erste Facettenspiegel kann im Bereich einer Feldebene der Beleuchtungsoptik angeordnet sein. Der zweite Facettenspiegel kann im Bereich einer Pupillenebene der Beleuchtungsoptik angeordnet sein. Die Facetten des mindestens einen Facettenspiegels können ihrerseits in Einzelspiegel unterteilt sein. Eine solche Einzelspiegel-Unterteilung ist beispielsweise bekannt aus der US 2011/001 947 A1. Bestimmte Realisierungen solcher Einzelspiegel-Anordnungen werden auch als Microelectromechanical System (MEMS) bezeichnet.

Der optischen Weglängenunterschied zwischen verschiedenen Beleuchtungsteilbündeln ergibt sich insbesondere durch die geometrische Anordnung der Ausleuchtungskanäle. Bei einer Ausgestaltung nach Anspruch 2 wird durch Wahl und Anordnung der Ausleuchtungskanäle sichergestellt, daß die Weglängenunterschiede entlang der Ausleuchtungskanäle immer groß genug sind, so daß die oben angegebene Bedingung für unerwünschte Interferenzen nicht erfüllt sein kann. Bei einer Ausgestaltung nach Anspruch 2 wird innerhalb der Beleuchtungsoptik zwischen zeitlich im Beleuchtungsfeld ankommenden Beleuchtungslichtanteilen, insbesondere Beleuchtungslichtimpulsen, eine Verzögerung herbeigeführt, die größer als eine Kohärenzdauer des Beleuchtungslichts ist.

Eine solche zeitliche Verzögerung entspricht einer einzustellenden optischen Weglängendifferenz zwischen den Teilbündeln bzw. zwischen den Ausleuchtungskanälen und ergibt sich aus der Geometrie der Ausleuchtungskanäle. Zwischen jedem beliebigen Paar von Teilbündeln ist die zeitliche Verzögerung größer als die Kohärenzdauer des Beleuchtungslichts, so dass eine minimale Laufzeit-Differenz zwischen dem Ausleuchtungskanal mit der kürzesten Weglänge und dem Ausleuchtungskanal mit der längsten Weglänge, gemessen zwischen einer Lichtquelle für das Beleuchtungslicht und dem Beleuchtungsfeld, resultiert, die mindestens das Produkt aus der Ausleuchtungskanalzahl und der Kohärenzzeit der Lichtquelle beträgt.

Die sich bei Berücksichtigung dieser Weglängendifferenzbedingung ergebende Gleichförmigkeit der Ausleuchtung des Beleuchtungsfeldes ist oftmals nicht ausreichend. Die Gleichförmigkeit beschreibt, wie stark die Dosis, die zur Beleuchtung eines Punktes, eines zu beleuchtenden Objektes, oder eines Bildes dieses Objektes beiträgt, als Funktion des Ortes in einem Beleuchtungsfeld bzw. einem Objektfeld oder Bildfeld variiert. Die Gleichförmigkeit wird im Zusammenhang mit der Projektionslithographie auch als Uniformität (uniformity) bezeichnet. Die Gleichförmigkeit kann auf zwei alternative Weisen quantifiziert werden, nämlich entweder durch eine maximale Abweichung einer Beleuchtungsdosis oder durch eine Varianz, insbesondere durch eine relative Varianz, der Beleuchtungsdosis als Funktion des Feldortes.

Die Vorgabe der Laufzeit-Differenzen zwischen den Beleuchtungslicht-Teilbündeln geschieht bei der Beleuchtungsoptik nach Anspruch 2 derart, dass im Betrieb der Beleuchtungsoptik zu jedem Zeitpunkt an jedem Punkt des Beleuchtungsfeldes beliebige Paare von Beleuchtungslicht-Teilbündeln, die über verschiedene Ausleuchtungskanäle geführt werden, zueinander mindestens eine optische Wellenlängendifferenz haben, die größer ist als eine Kohärenzlänge des Beleuchtungslichts.

Mithilfe der optischen Verzögerungskomponente nach Anspruch 3 wird eine Gleichförmigkeit der Ausleuchtung des Beleuchtungsfeldes, die sich bei Berücksichtigung der vorstehend angegebenen Laufzeit- bzw. Weglängendifferenzbedingung ergibt, zusätzlich verbessert, ohne dass ein Eingriff in die sonstige Geometrie der Ausleuchtungskanäle erforderlich ist. Die Verzögerungskomponente erzeugt aus einem einfallenden Lichtbündel mehrere, zueinander verzögerte Lichtbündel, die auch als Teilbündel oder Bündel-Komponenten bezeichnet werden. Es können die durch Reflexion an den facettierten optischen Elementen im Strahlengang erzeugten Beleuchtungslicht-Teilbündel durch die optische Verzögerungskomponente hinsichtlich ihrer Laufzeit gegeneinander verzögert werden. Alternativ oder zusätzlich ist es möglich, die aufgrund der Facetten-Reflexion erzeugten Teilbündel ihrerseits mithilfe der optischen Verzögerungskomponente in Teilbündel-Komponenten aufzuteilen, die wiederum paarweise zueinander eine Laufzeit-Differenz aufweisen. Jedes dieser verzögerten Lichtbündel verbessert die Gleichförmigkeit der Ausleuchtung des Beleuchtungsfeldes. Durch die Ausgestaltung nach Anspruch 4 ist sichergestellt, dass keine unerwünschte Interferenz stattfinden kann.

Die optische Verzögerungskomponente kann derart gestaltet sein, dass alle paarweisen Laufzeit-Differenzen der Teilbündel-Komponenten des mindesten einen Beleuchtungslicht-Teilbündels größer sind als die maximale Laufzeit-Differenz zweier Beleuchtungslicht-Teilbündel, gemessen zwischen einem Ort im Strahlengang des Beleuchtungslichts vor dessen Aufteilung in die Beleuchtungslicht-Teilbündel und dem Beleuchtungsfeld. Die optische Verzögerungskomponente kann auch derart gestaltet sein, dass alle paarweisen Laufzeit-Differenzen der Teilbündel-Komponenten des mindestens einen Beleuchtungslicht-Teilbündels kleiner sind als die minimale Laufzeit-Differenz zweier verschiedener Beleuchtungslicht-Teilbündel, gemessen zwischen einem Ort im Strahlengang des Beleuchtungslichts vor dessen Aufteilung in die Beleuchtungslicht-Teilbündel und dem Beleuchtungsfeld. Diese Varianten der Beleuchtungsoptik ermöglichen ein unterschiedliches zeitliches Mischen von Ausleuchtungskanal-Teil-Lichtimpulsen des Beleuchtungslichts und unterscheiden sich durch Laufzeit-Differenzen, die durch eine Verzögerungskomponente nach Anspruch 3 aufgeprägt werden. Besonders vorteilhafte Varianten besitzen eine besonders kleine Stufenhöhe oder eine besonders große Stufenhöhe, während mittlere Stufenhöhen eher unvorteilhaft sind. Die Längenskalen für die Stufenhöhe werden durch die Kohärenzlänge des Beleuchtungslichts beeinflusst. Besonders kleine Stufenhöhen sind hierbei kleiner als 50 $\mu$m, insbesondere kleiner als 20 $\mu$m, insbesondere kleiner als 10 $\mu$m, insbesondere kleiner als 5 $\mu$m, insbesondere kleiner als 2 $\mu$m und insbesondere kleiner als 1 $\mu$m. Besonders große Stufenhöhen sind größer als 250 $\mu$m, insbesondere größer als 1 mm, insbesondere größer als 5 mm und insbesondere größer als 20 mm.

Die optische Verzögerungskomponente kann zur Aufteilung mindestens eines Beleuchtungslicht-Teilbündels in eine Mehrzahl von Teilbündel-Komponenten als reflektierender Stufenspiegel ausgebildet sein, der das einfallende mindestens eine Beleuchtungslicht-Teilbündel in reflektierende Teilbündel-Komponenten mit paarweisen Laufzeit-Differenzen umlenkt, wobei die Komponenten durch verschiedene Stufen des Stufenspiegels vorgegeben werden. Ein derartiger reflektierender Stufenspiegel ist eine mit ausreichender Genauigkeit herstellbare optische Verzögerungskomponente. Die optische Verzögerungskomponente kann insbesondere mit kleinen Einfallswinkeln, also im Bereich der senkrechten Inzidenz, z. B. mit Einfallswinkeln, die kleiner als 30° sind, die kleiner als 25° sind, die kleiner als 20° sind, die kleiner als 15° sind oder die kleiner als 10° sind, mit dem Beleuchtungslicht beaufschlagt werden, sodass auch bei der Reflexion von EUV-Licht ein hoher Reflexionsgrad erzielt wird. Grundsätzlich kann die optische Verzögerungskomponente auch als reflektierender Stufenspiegel ausgeführt sein, der unter streifendem Einfall (grazing incidence) betrieben wird, also mit Einfallswinkeln, die größer als 60° sind, die größer als 65° sind, die größer als 70° sind, die größer als 75° sind oder die größer als 80° sind. Die optische Verzögerungskomponente kann eine Multilayer-Beschichtung zur Optimierung des Reflexionsgrades für die zu reflektierende EUV-Wellenlänge aufweisen.

Die Laufzeit-Differenzen der Teilbündel-Komponenten können durch Stufenhöhen des Stufenspiegels vorgegeben werden. Typische Verzögerungswege, die über die Stufen des Stufenspiegels aufgeprägt werden, liegen im Bereich von einigen $\mu$m, beispielsweise im Bereich von 1 $\mu$m, 2 $\mu$m, 5 $\mu$m, 10 $\mu$m . Auch größere Wegdifferenzen im Bereich einigen 10 $\mu$m, z. B. im Bereich von 25 $\mu$m, 50 $\mu$m, 75 $\mu$m, im Bereich von 100 $\mu$m, von 250 $\mu$m, 500 $\mu$m oder auch im mm-Bereich, z. B. im Bereich von 1 mm, 2 mm, 5 mm, oder auch noch größere Wegdifferenzen sind möglich. Die Verzögerungswege können auf die Kohärenzlänge der Lichtquelle, die das Beleuchtungslicht zur Verfügung stellt, abgestimmt werden.

Die optische Verzögerungskomponente kann am Ort des ersten oder des zweiten Facettenspiegels ausgebildet sein. Eine derartige Ausbildung der optischen Verzögerungskomponente kann eine zusätzliche Reflexion vermeiden. Die Verzögerungskomponente kann insbesondere am Ort des zweiten Facettenspiegels ausgebildet sein. Die Facetten selbst sind in diesem Fall als optische Verzögerungskomponenten ausgeführt. Die optische Verzögerungskomponente kann generell im Bereich einer Pupillenebene der Beleuchtungsoptik angeordnet sein. In diesem Fall wirkt die Verzögerungs-Laufzeit-Differenz, die über die optische Verzögerungskomponente dem Beleuchtungslicht aufgeprägt wird, über das gesamte Beleuchtungsfeld. Alternativ kann die optische Verzögerungskomponente auch im Bereich einer Feldebene der Beleuchtungsoptik angeordnet sein.

Die optische Weglänge zwischen Lichtquelle und Beleuchtungsfeld entlang eines Ausleuchtungskanals hängt in einer systematischen Art und Weise vom betrachteten Beleuchtungsfeldpunkt ab. Werden zwei bestimmte Ausführungskanäle betrachtet, ist eine optische Weglängendifferenz zwischen diesen beiden Ausleuchtungskanälen für einen ersten Beleuchtungsfeldpunkt also im Allgemeinen eine andere als für einen hiervon beabstandeten Beleuchtungsfeldpunkt. Es wurde erkannt, daß diese Abhängigkeit das Finden einer geometrischen Anordnung der Ausleuchtungskanäle, bei der die Bedingung für unerwünschte Interferenz nirgendwo auf dem Beleuchtungsfeld erfüllt ist, erschwert. Besitzen zwei Ausleuchtungskanäle eine unterschiedliche Abhängigkeit der optischen Weglänge vom Beleuchtungsfeldpunkt, so muß oftmals der betragsmäßige Unterschied der beiden optischen Weglängen an den meisten Beleuchtungsfeldpunkten Größenordnungen größer als die Kohärenzlänge des Beleuchtungslichts sein, um auch am Beleuchtungsfeldpunkt mit dem betragsmäßig kleinsten Unterschied der optischen Weglängen über diese beiden Ausleuchtungskanäle einen Unterschied von mindestens der Kohärenzlänge des Beleuchtungslichts erreichen zu können. Geometrische Realisierungsmöglichkeiten für solch großen Weglängenunterschiede sind mit Nachteilen versehen, sodass eine Gestaltung der Beleuchtungsoptik vorteilhaft ist, bei der entsprechend große Weglängenunterschiede nicht realisiert werden müssen, um für jeden Beleuchtungsfeldpunkt einen optischen Weglängenunterschied von mindestens der Kohärenzlänge des Beleuchtungslichts zu erreichen.

Eine Verkippung des Pupillenfacettenspiegels nach Anspruch 4 erleichtert die Berücksichtigung dieser systematischen Abhängigkeit der optischen Weglänge vom Beleuchtungsfeldpunkt. Sobald für einen Beleuchtungsfeldpunkt die weiter oben angegebene Bedingung für unerwünschte Interferenz nicht erfüllt ist, so ist diese auch für einen großen Teil des gesamten Beleuchtungsfeldes nicht erfüllt.

Eine Verkippung des Pupillenfacettenspiegels nach Anspruch 4 kann derart sein, dass ein Lichtweg zwischen keinem Paar von Pupillenfacetten und einem jeweils betrachteten Beleuchtungsfeldpunkt identisch lang ist. Eine störende Interferenz des Beleuchtungslichts im Beleuchtungsfeld wird vermieden. Für jeden Feldpunkt des Beleuchtungsfeldes ist gewährleistet, dass dieser, sofern er von der Lichtquelle über verschiedene Ausleuchtungskanäle beleuchtet wird, über verschiedene Lichtweglängen beleuchtet wird.

Eine Normale auf eine Haupt-Spiegelfläche des Pupillenfacettenspiegels kann gegenüber einer Einfallsebene der Beleuchtungslicht-Teilbündel auf einer Haupt-Spiegelfläche des Feldfacettenspiegels um mindestens 2° gekippt angeordnet sein. Ein derartiger Kippwinkel hat sich zur Vermeidung einer störenden Interferenz als geeignet herausgestellt. Der Kippwinkel kann 3°, 4°, 5°, 7° oder 10° betragen. Die Einfallsebene der Beleuchtungslicht-Teilbündel auf einer Haupt-Spiegelfläche des Feldfacettenspiegels ist definiert durch die Einfallsebene eines Schwerstrahls des Beleuchtungslichts auf der Haupt-Spiegelfläche des Feldfacettenspiegels, also auf derjenigen Ebene, auf der die Facetten des Feldfacettenspiegels angeordnet sind.

Bei der alternativ oder zusätzlich möglichen Anordnungsvariante nach Anspruch 5 wird ebenfalls ein Weglängenunterschied zwischen den verschieden Ausleuchtungskanallängen erreicht, der störende Interferenzen im Beleuchtungsbild vermeidet. Hierbei wird zumindest ein Teil der systematischen Abhängigkeit der optischen Weglänge entlang eines Beleuchtungskanals durch eine geeignete Form des Pupillenfacettenspiegels kompensiert.

Eine Haupt-Spiegelfläche des Pupillenfacettenspiegels kann parabolisch gekrümmt sein. Eine derartige parabolische Krümmung der Haupt-Spiegelfläche des Pupillenfacettenspiegels lässt sich herstellungstechnisch mit vergleichsweise geringem Aufwand realisieren.

Eine Ausführung nach Anspruch 6 sorgt dafür, daß die Bedingung für störende Interferenz niemals erfüllt ist, indem durch eine Scan-Einrichtung sichergestellt wird, daß zu jedem Zeitpunkt jeder Punkt des Beleuchtungsfeldes nur entlang maximal eines Ausleuchtungskanales mit Beleuchtungslicht beaufschlagt wird und damit keine zwei Beleuchtungslicht-Teilbündel interferieren können. Dies wird erreicht, indem mittels einer Scanvorrichtung zu jedem Zeitpunkt nur ein kleiner Bereich des ersten Facettenspiegels mit beleuchtet wird. Es wurde erkannt, daß hierfür notwendig ist, daß die Gesamtfläche des instantan auf dem ersten Facettenspiegel ausgeleuchteten Bereichs hinreichend kleiner als die Fläche einer Feldfacette ist, wobei der ausgeleuchtete Bereich aber mehrere Feldfacetten teilweise überdecken kann, solange nur die Gesamtfläche des Strahlquerschnitts klein genug ist.

Der Strahlquerschnitt des Beleuchtungs-Strahls nach Anspruch 6 hat beim Auftreffen auf den Facettenspiegel eine Größe, die größer ist als ein Fünftel einer Reflexionsfläche einer der Feldfacetten, die also allenfalls um weniger als eine Größenordnung kleiner ist als die Reflexionsfläche einer der Feldfacetten. Dieses Größenverhältnis kann für alle Feldfacetten des Feldfacettenspiegels zutreffen. Das Beleuchtungssystem kann so ausgeführt sein, dass der gesamte Strahlquerschnitt des Beleuchtungs-Strahls beim Auftreffen auf dem Facettenspiegel größer ist als 30 %, größer ist als 33 %, größer ist als 35 %, größer ist als 40 %, größer ist als 50 %, größer ist als 60 %, größer ist als 75 % oder größer ist als 80 % einer Reflexionsfläche einer der Feldfacetten.

Diese Größenordnung des Strahlquerschnitts beim Auftreffen auf dem Facettenspiegel vermeidet, dass ein zu kleiner Bereich des Beleuchtungsfeldes zu einem gegebenen Zeitpunkt ausgeleuchtet wird. Dies führt zu einem stabilen Beleuchtungssystem.

Bei dem Facettenspiegel kann es sich um einen Feldfacettenspiegel handeln, der in einer zur Anordnungsebene des Beleuchtungsfeldes optisch konjugierten Ebene angeordnet ist.

Die Scan-Einrichtung kann derart ausgeführt sein, dass jeweils mindestens ein zusammenhängender Scanbereich auf dem Facettenspiegel sequentiell abgerastert wird, dessen Scanbereichsfläche höchstens der Fläche einer der Facetten entspricht. Bei einer derartigen Ausführung können die Facetten des Feldfacettenspiegels selbst einzeln abgerastert werden oder es können zusammenhängende Scanbereiche zwischen benachbarten, aneinander angrenzenden Facetten abgerastert werden, deren Scanbereichsfläche höchstens der Fläche einer der Facetten entspricht. Die Berandungsform des jeweiligen Scanbereichs, der beim sequentiellen Abrastern des Facettenspiegels dann über diesen gescannt wird, kann genau die Berandungsform einer einzelnen Facette des Facettenspiegels sein. Alternativ kann die Berandungsform auch in die Berandungsform einer einzelnen Facette des Facettenspiegels einschreibbar sein. Die Scan-Einrichtung kann so ausgeführt sein, dass die einzelnen Scanbereiche, die sequentiell abgerastert werden, ihrerseits durch Abrasterung beleuchtet werden. Alternativ kann die Scan-Einrichtung so ausgeführt werden, dass die Scanbereiche durch ein entsprechend aufgeweitetes Beleuchtungslicht-Bündel zumindest abschnittsweise oder auch ganz simultan beleuchtet werden. Beim sequentiellen Abrastern des mindestens einen zusammenhängenden Scanbereichs wird dieser Scanbereich mittels der Scan-Einrichtung über den Facettenspiegel so verschoben, dass nach Abschluss eines kompletten Rastervorgangs der gesamte Facettenspiegel beleuchtet ist. Dabei kann der mindestens eine Scanbereich kontinuierlich auf dem Facettenspiegel oder schrittweise auf dem Facettenspiegel verschoben werden. Die Scanbereichsfläche oder, soweit mehrere Scanbereiche simultan abgerastet werden, die Gesamtfläche aller Scanbereiche kann die Größe mindestens eines Drittels der Fläche einer der Facetten haben.

Die Scanbereichsfläche kann um mindestens das Verhältnis aus einer maximalen Urbild-Verschiebung eines Objektpunktes des Beleuchtungsfeldes auf den Facetten einerseits und einer hierzu parallelen Facettenausdehnung andererseits geringer sein als die Fläche einer der Facetten. Bei einer derartigen Beleuchtungsoptik wird sichergestellt, dass sich Unterschiede in der Abbildung der verschiedenen Facetten des Facettenspiegels in das Beleuchtungsfeld nicht so auswirken, dass aufgrund dieser Unterschiede störende Interferenzen zwischen Teilstrahlen des Beleuchtungslichts resultieren. Eine Ausdehnung der Scanbereichsfläche kann insbesondere längs einer Objektverlagerungsrichtung, längs der das Objekt bei der Projektionsbelichtung durch das Beleuchtungsfeld verlagert wird, geringer sein als eine hierzu parallele Erstreckung der Facetten.

Eine Berandungsform der Scanbereichsfläche kann einer Berandungsform der jeweiligen Facette entsprechen. Bei einer derartigen Ausführung kann die Bedingung, wonach jeweils höchstens eine der Facetten des Facettenspiegels jeweils einen Feldpunkt des Beleuchtungsfelds beleuchtet, auf einfache Weise eingehalten werden. Die Berandungsform der Scanbereichsfläche kann etwas kleiner ausgeführt sein als die Berandungsform der jeweiligen Facette, sodass der Scanbereich etwas kleiner ist als eine genutzte Reflexionsfläche auf der Facette. Dies erhöht die Sicherheit, dass jeweils ein Feldpunkt im Beleuchtungsfeld ausschließlich über jeweils höchstens über eine der Facetten beleuchtet wird.

Eine alternative Ausführung nach Anspruch 7 vereinfacht die Scanbewegung.

Bei dem sich über mehrere Facetten erstreckenden Scanbereich kann es sich um einen zusammenhängenden Bereich handeln. Eine derartige Gestaltung ermöglicht einen kontinuierlichen Betrieb der Scan-Einrichtung, bei der beim Abscannen des Facettenspiegels nicht zwischen nicht zusammenhängenden Bereichen gesprungen werden muss.

Die Facetten des Facettenspiegels können spaltenweise angeordnet sein. Bei dem Scanbereich kann es sich um einen schräg über die Facetten-Spalten verlaufenden Streifen handeln. Eine derartige Gestaltung des Scanbereichs hat sich als besonders geeignet herausgestellt.

Mehrere Scanbereiche können simultan abgerastert werden. Eine derartige Ausführung vermeidet eine zu hohe Simultanbelastung einer einzelnen Facette.

Ein Versatz des Scanbereichs zwischen zwei spaltenweise benachbarten Facetten kann mindestens um eine maximale Urbild-Verschiebung größer sein als eine Ausdehnung des Scanbereichs in Richtung des Versatzes. Ein derartiger Versatz vermeidet ebenfalls das Risiko einer abbildungsbedingten, störenden Teilstrahl- bzw. Teilbündel-Interferenz.

Bei der Ausführung nach Anspruch 8 kann ein Facettenspiegel zum Einsatz kommen, der gleichzeitig als optische Verzögerungskomponente im vorstehend bereits angesprochenen Sinne dient. Der Facettenspiegel kann in mehrere Facettenspalten unterteilt sein, die derart zueinander versetzt angeordnet sind, dass Beleuchtungslicht-Teilbündel, die über Ausleuchtungskanäle zu verschiedenen Facettenspalten geführt werden, aufgrund des dann genügend großen Weglängenunterschieds nicht störend miteinander interferieren.

Bei einer Ausführung der Beleuchtungsoptik nach Anspruch 9 wird eine Interferenz dadurch vermieden, dass diejenigen Anteile eines Ausleuchtungskanals und damit des über diesen Ausleuchtungskanal geführten Beleuchtungslicht-Teilbündels, die zu einer störenden Interferenz an einem Objektfeldpunkt beitragen könnten, unterdrückt werden, sodass diese nicht zur Beleuchtung des Beleuchtungsfeldes beitragen. Eine derartige Unterdrückung kann dadurch erfolgen, dass die Beleuchtungslicht-Teilbündel bei der Führung über den jeweiligen Ausleuchtungskanal im interessierenden Querschnittsbereich des Ausleuchtungskanals geblockt werden. Hierzu kann mindestens eine der Facetten, die den jeweiligen Ausleuchtungskanal definiert, eine Reflexionsfläche mit mindestens einem entsprechend angeordneten Blockungs-Bereich aufweisen. Auch eine Mehrzahl oder eine Vielzahl derartiger Blockungs-Bereiche auf jeweils einer Facette kann zur Interferenzvermeidung vorgesehen sein. Der jeweilige Blockungs-Bereich kann beispielsweise durch eine absorbierende oder streuende Beschichtung oder durch eine Blende realisiert sein. Es kann im Blockungs-Bereich auch einfach eine hochreflektierende Beschichtung für das Beleuchtungslicht weggelassen sein. Es hat sich überraschend herausgestellt, dass trotz der Vielzahl von möglichen Paaren von Ausleuchtungskanälen, die bei der Verwendung einer größeren Anzahl von Facetten resultieren, nur ein vergleichsweise geringer Anteil der Querschnittsbereiche der Ausleuchtungskanäle zur Vermeidung störender Teilbündel-Interferenzen unterdrückt werden muss. Ein durch die Blockung dieser Querschnittsbereiche entstehender Verlust an Beleuchtungslicht kann kleiner sein als 10%, kann kleiner sein als 5% und kann kleiner sein als 3%. Da bei einer störenden Teilbündel-Interferenz zwischen den Teilbündeln eines Ausleuchtungskanal-Paares kein Unterschied besteht, ob ein Querschnittsbereich des einen Ausleuchtungskanals oder des anderen Ausleuchtungskanals dieses Ausleuchtungskanal-Paares unterdrückt wird, kann derjenige Querschnittsbereich mit der geringeren integralen Beleuchtungslichtintensität gewählt werden, was den Lichtverlust nochmals reduziert.

Sofern der mindestens eine Facettenspiegel aus einer Mehrzahl oder Vielzahl von Einzelspiegeln bzw. Mikrospiegeln ausgeführt ist, können entsprechende, die Beleuchtung über die Ausleuchtungskanäle im gewünschten Querschnittsbereich zur Interferenzvermeidung unterdrückende Anteile auch durch Mikrospiegel realisiert sein, die so verkippt sind, dass über die entsprechenden Mikrospiegel das Beleuchtungslicht abgeblendet wird, also nicht zur Beleuchtung des Beleuchtungsfeldes beiträgt. Dies ist insbesondere bei einer MEMS-(mikroelektromechanisches System, microelectromechanical system) Ausführung des mindestens einen Facettenspiegels vorteilhaft.

Die Vorteile eines optischen Systems nach Anspruch 10 sowie eines optischen Systems, bei dem neben der Beleuchtungsoptik noch eine Projektionsoptik zur Abbildung eines Objektfeldes, welches im Beleuchtungsfeld angeordnet ist, in ein Bildfeld vorgesehen ist, entsprechen denen, die vorstehend unter Bezugnahme auf die erfindungsgemäße Beleuchtungsoptik bereits erläutert wurden. EUV-Lichtquellen besitzen eine kurze Kohärenzzeit, so dass die erfindungsgemäße Beleuchtungsoptik kompakt realisierbar ist. Als EUV-Lichtquelle kann ein Freie Elektronenlaser (FEL) eingesetzt werden. Kommt es zu unerwünschter Interferenz, so kann die Interferenz um so stärker ausgeprägt sein, wenn die Lichtquelle eine geringe Anzahlvon Moden besitzt. Aufgrund der geringen Modenzahl eines FEL kommen dort die Vorteile der Vermeidung störender Teilbündel-Interferenzen besonders gut zum Tragen.

Die EUV-Lichtquelle kann ein Freie Elektronenlaser mit weniger als zehn transversalen Moden sein. Aus dem Lichtleitwert kann eine obere Schranke für die Anzahl der transversalen Moden abgeleitet werden. Der Lichtleitwert der Lichtquelle kann insbesondere kleiner als $1 \cdot 10^{-3}$ mm$^2$ sein, kann kleiner als $1 \cdot 10^{-4}$ mm$^2$ sein, kann kleiner als $1 \cdot 10^{-5}$ mm$^2$ sein oder kann auch kleiner als $1 \cdot 10^{-6}$ mm$^2$ sein. Für die Definition und die Berechnung des Lichtleitwertes wird auf die EP 1 072 957 A2 verwiesen. Für derartige Lichtquellen sind die erfindungsgemäßen Maßnahmen zur Herbeiführung einer Gleichförmigkeit einer Ausleuchtung eines Beleuchtungsfeldes besonders geeignet. Insbesondere eine Specklereduktion kann erreicht werden. Auch andere Typen von EUV-Lichtquellen können zum Einsatz kommen. Je nach der Kohärenzdauer der einzelnen Lichtquelle kann die optische Verzögerungskomponente ausgeführt sein. Hierbei gilt, dass eine Beleuchtungsoptik mit Laufzeit-Differenzen zwischen den Beleuchtungslicht-Teilbündeln, die für eine Lichtquelle mit langer Kohärenzdauer ausgeführt ist, auch für eine Lichtquelle mit kürzerer Kohärenzdauer genutzt werden kann.

Zwischen der Lichtquelle und dem ersten Facettenspiegel kann ein Zwischenfokus angeordnet sein. Die vorstehend angesprochene optische Verzögerungskomponente kann am Ort des Zwischenfokus ausgebildet sein. Eine solche Anordnung der optischen Verzögerungskomponente am Ort eines Zwischenfokus des optischen Systems ermöglicht eine Aufprägung einer zusätzlichen Verzögerungs-Laufzeit-Differenz durch die optische Verzögerungskomponente, die über das gesamte Beleuchtungsfeld in gleicher Weise wirkt. Dies gilt auch für andere Anordnungsorte der optischen Verzögerungskomponente, soweit diese Anordnungsorte im Bereich einer Pupillenebene der Beleuchtungsoptik vorliegen.

Die Vorteile einer Projektionsbelichtungsanlage nach Anspruch 11 und eines Herstellungsverfahrens nach Anspruch 12 entsprechen denen, die vorstehend unter Bezugnahme auf die erfindungsgemäße Beleuchtungsoptik und das erfindungsgemäße optische System bereits erläutert wurden. Ein mit dem Herstellungsverfahren nach Anspruch 12 hergestelltes mikro- bzw. nanostrukturiertes Bauteil kann mit extrem hoher Strukturauflösung hergestellt sein. Auf diese Weise kann beispielsweise ein Halbleiterchip mit extrem hoher Integrations- bzw. Speicherdichte hergestellt werden.

Ausführungsbeispiele der Erfindung werden nachfolgend anhand der Zeichnung näher erläutert. Es zeigen:

Fig. 1 schematisch einen Meridionalschnitt durch eine Projektionsbelichtungsanlage für die EUV-Projektionslithographie;

Fig. 2 stark schematisch einen Strahlengang von insgesamt sechs Ausleuchtungskanälen für Beleuchtungslicht-Teilbündel zur Beleuchtung eines Beleuchtungsfeldes, in dem eine Lithografiemaske anordenbar ist, bei einer weiteren Ausführung einer Projektionsbelichtungsanlage;

Fig. 3 eine zeitliche Abfolge von Auftreff-Zeitpunkten von Beleuchtungslicht-Teilbündeln auf der Lithografiemaske;

Fig. 4 einen Schnitt durch eine optische Verzögerungskomponente, die in einer Beleuchtungsoptik der Projektionsbelichtungsanlage nach Fig. 2 zum Einsatz kommt;

Fig. 5 eine zeitliche Abfolge von Auftreff-Zeitpunkten von Beleuchtungslicht-Teilbündeln auf der Lithografiemaske bei Einsatz der optischen Verzögerungskomponente nach Fig. 4;

Fig. 6 in einer zu Fig. 3 ähnlichen Darstellung eine zeitliche Abfolge von Auftreff-Zeitpunkten von Beleuchtungslicht-Teilbündeln auf der Lithografiemaske;

Fig. 7 in einer zu Fig. 4 ähnlichen Darstellung eine weitere Ausführung einer optischen Verzögerungskomponente;

Fig. 8 eine zeitliche Abfolge von Auftreff-Zeitpunkten von Beleuchtungslicht-Teilbündeln auf der Lithografiemaske bei Einsatz der optischen Verzögerungskomponente nach Fig. 7;

Fig. 9 schematisch und in Bezug auf eine Beleuchtungsoptik im Meridionalschnitt eine weitere Ausführung einer Projektionsbelichtungsanlage für die EUV-Projektionslithographie;

Fig. 10 schematisch und in Bezug auf einen Feldfacettenspiegel in Aufsicht einige Komponenten eines Beleuchtungssystems der Projektionsbelichtungsanlage nach Fig. 9 mit einer Scan-Einrichtung zum Ablenken eines EUV-Ausgabestrahls einer EUV-Lichtquelle;

| | |
|---|---|
| Fig. 11 | ebenfalls schematisch und in Bezug auf einen Feldfacettenspiegel im Querschnitt eine weitere Ausführung einer Scan-Einrichtung zum Ablenken des EUV-Ausgabestrahls der EUV-Lichtquelle; |
| Fig. 12 | eine Aufsicht auf einer weiteren Ausführung eines Feldfacettenspiegels sowie eines Beleuchtungsfeldes, wobei im Beleuchtungsfeld ein Feldpunkt hervorgehoben ist und wobei diejenigen zugeordneten Punkte auf Facetten des Feldfacettenspiegels ebenfalls hervorgehoben sind, die auf den hervorgehobenen Beleuchtungsfeldpunkt abgebildet werden; |
| Fig. 13 | in einer zu Fig. 12 ähnlichen Darstellung eine Aufsicht des Feldfacettenspiegels und des Beleuchtungsfeldes nach Fig. 12, wobei eine Abbildungs-Punktzuordnung wie bei der Fig. 12 nur für genau eine der Feldfacetten und das Beleuchtungsfeld angegeben ist und wobei zusätzlich auf allen anderen Feldfacetten jeweils ein Facettenbereich angegeben ist und wobei die einander überlagernden Bilder dieser Facettenbereiche im Beleuchtungsfeld ebenfalls dargestellt sind; |
| Fig. 14 und 15 | zwei Beispiele für eine sequentielle Abrasterung jeweils zusammenhängender Scanbereiche auf dem Feldfacettenspiegel, wobei die Scanbereichsflächen dieser Scanbereiche jeweils etwas kleiner sind als Fläche einer der Facetten; |
| Fig. 16 und 17 | Varianten von Scanbereichsflächen über den Feldfacetten, die sich über mehrere Feldfacetten erstrecken; |
| Fig. 18 | schematisch und in Bezug auf eine Beleuchtungsoptik im Meridionalschnitt eine weitere Ausführung einer Projektionsbelichtungsanlage für die EUV-Projektionslithographie; |
| Fig. 19 | schematisch die Hauptkomponenten eines Beleuchtungssystems der Projektionsbelichtungsanlage nach Fig. 18; |
| Fig. 20 | in einer schematischen Aufsicht, die |

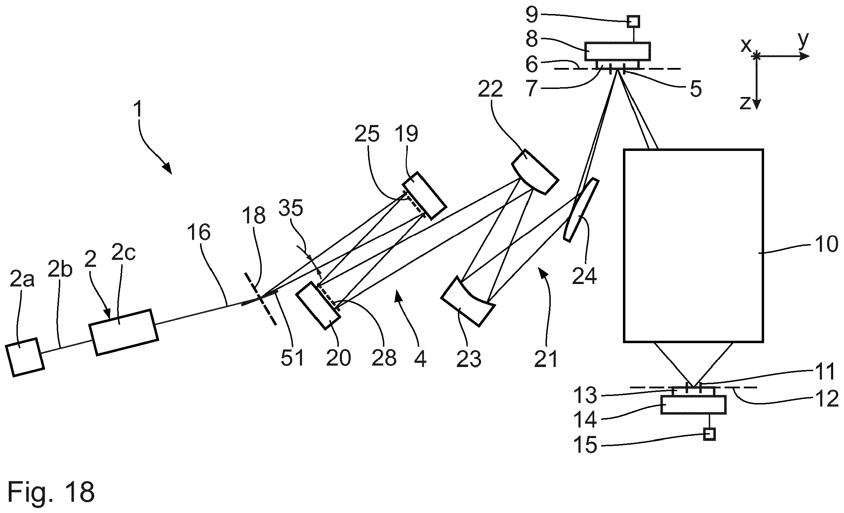

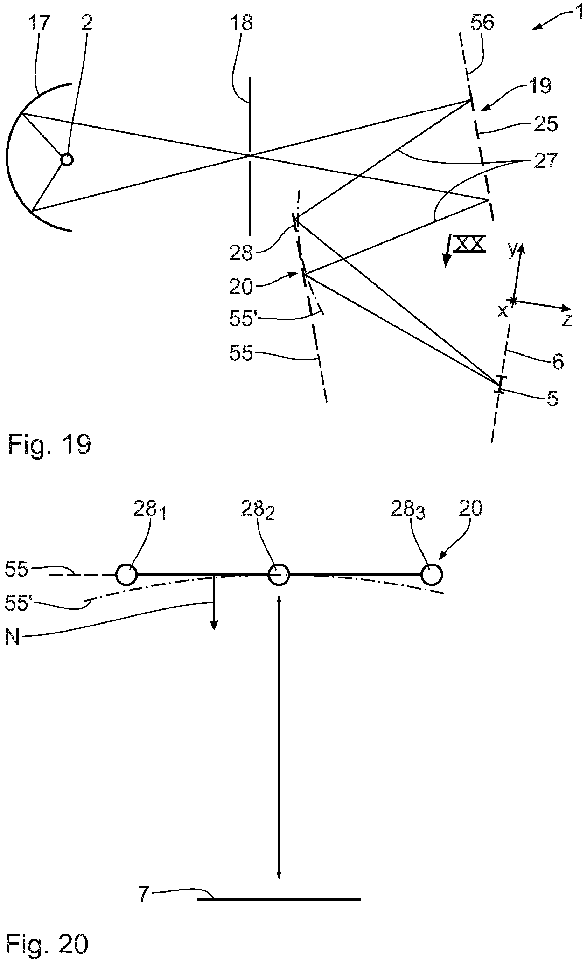

in etwa der Blickrichtung XX in Fig. 19 entspricht, drei ausgewählte Pupillenfacetten eines Pupillenfacettenspiegels der Beleuchtungsoptik und eines Retikels der Projektionsbelichtungsanlage nach den Fig. 18 und 19 zur Verdeutlichung von optischen Weglängendifferenzen von Ausleuchtungskanälen innerhalb der Beleuchtungsoptik;

| | |
|---|---|
| Fig. 21 | in einem Diagramm einen Feldverlauf optischer Weglängen zwischen den Pupillenfacetten nach Fig. 20 über die Feldkoordinate x des Retikels; |
| Fig. 22 | in einer zu Fig. 20 ähnlichen Darstellung zwei ausgewählte Pupillenfacetten und das Retikel bei einer Anordnungsvariante, bei der der Pupillenfacettenspiegel so verkippt ist, dass eine Normale auf eine Haupt-Spiegelfläche des Pupillenfacettenspiegels gegenüber einer Einfallsebene der Beleuchtungslicht-Teilbündel auf einer Haupt-Spiegelfläche des Feldfacettenspiegels verkippt angeordnet ist; |
| Fig. 23 bis 26 | Diagramme nach Art von Fig. 21, bei denen Feldverläufe optischer Weglängen zwischen verschiedenen Pupillenfacetten und dem Retikel bei der Anordnung des Pupillenfacettenspiegels zum Retikel nach Fig. 22 für verschiedene Kippwinkel des Pupillenfacettenspiegels aufgetragen sind; |
| Fig. 27 | in einem Diagramm eine Krümmung einer Haupt-Spiegelfläche des Pupillenfacettenspiegels, die zu einer parabolischen Abstandsfunktion Pupillenfacettenspiegel - Retikel führt, wobei diese Abstandsfunktion mit zwei unterschiedlichen Skalierungen dargestellt ist; |
| Fig. 28 | in einem zu den Fig. 21 sowie 23 bis 26 ähnlichen Diagramm den Feldverlauf optischer Weglängen zwischen verschiedenen Pupillenfacetten eines Pupillenfacettenspiegels mit gemäß Fig. 27 gekrümmter Haupt-Spiegelfläche über das Retikel; |
| Fig. 29 bis 31 | verschiedene Ausführungen einer Feldfacette eines Feldfacettenspiegels, der bei einer der Ausführungen der Beleuchtungsoptiken in einer Pro- |

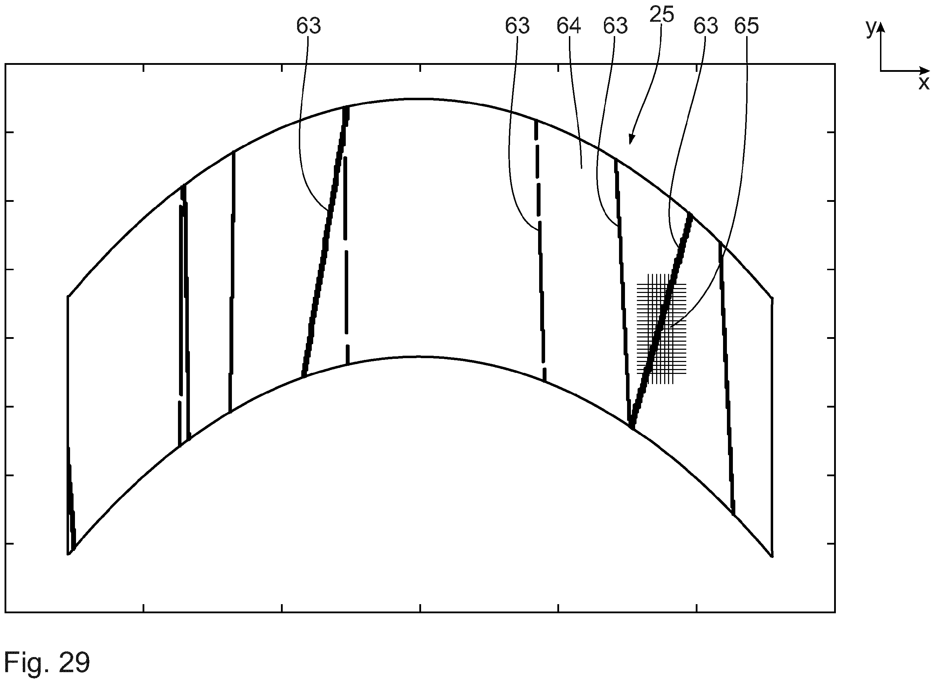

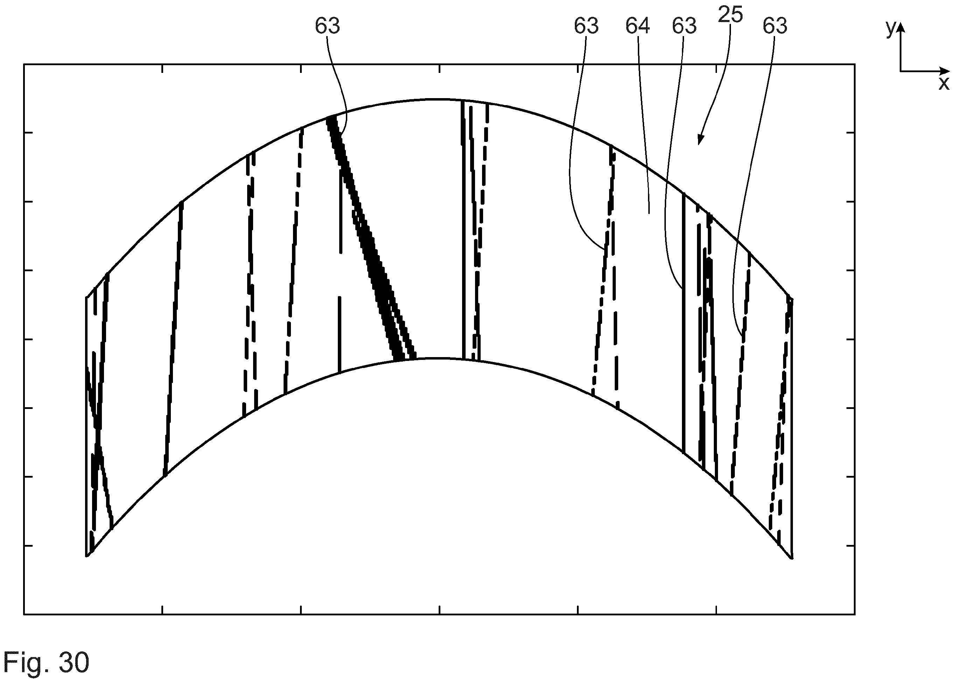

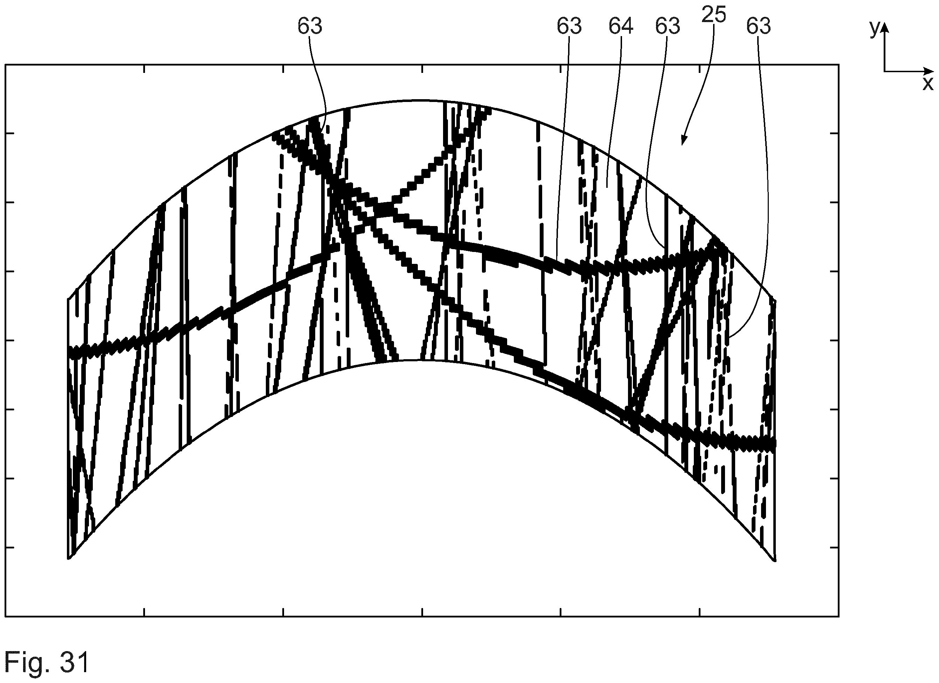

jektionsbelichtungsanlage zum Einsatz kommen kann, wobei linienhafte Bereiche auf einer Reflexionsfläche der Feldfacette eine beleuchtungslichtblockende Beschichtung tragen, wobei Fig. 29 eine Konfiguration der blockenden Beschichtungs-Bereiche, optimiert für ein Beleuchtungssetting "y-Dipol" zeigt, Fig. 30 eine entsprechende Konfiguration, optimiert für ein Beleuchtungssetting "x-Dipol", und Fig. 31 wiederum eine entsprechende Konfiguration, optimiert für mehrere unterschiedliche Beleuchtungssettings, bei denen diese Feldfacette zur reflektierenden Führung des Beleuchtungslichts zum Einsatz kommen kann;

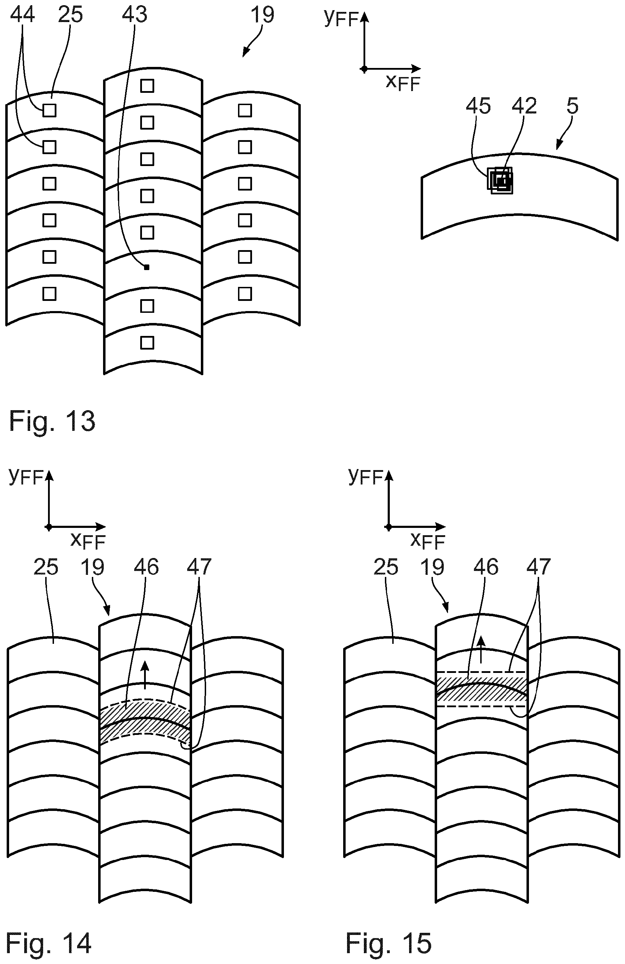

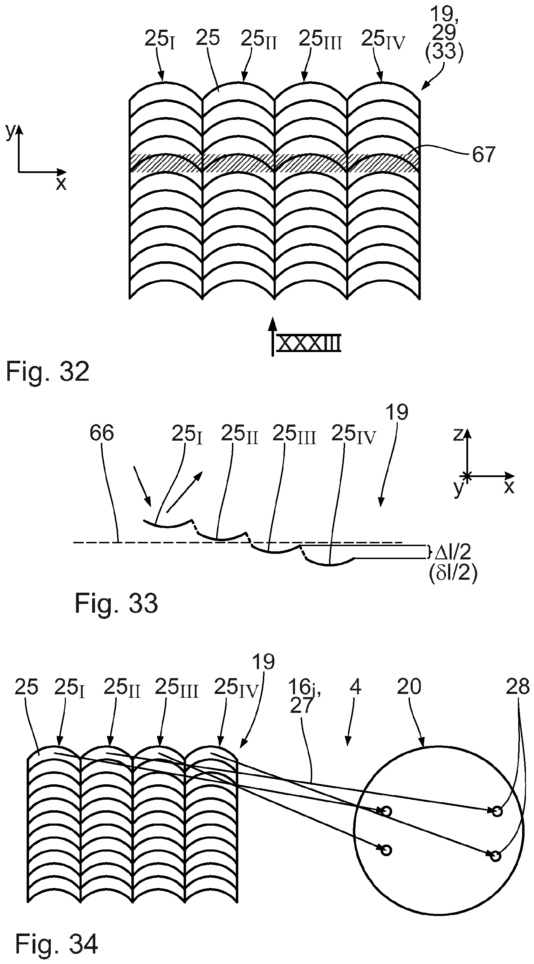

Fig. 32     in einer zu den Fig. 14 bis 17 ähnlichen Darstellung ein weiteres Beispiel für eine sequentielle Abrasterung eines zusammenhängenden Scanbereichs auf einer weiteren Ausführung eines Feldfacettenspiegels;

Fig. 33     schematisch eine Seitenansicht von Reflexionsflächen der Feldfacetten des Feldfacettenspiegels nach Fig. 32, gesehen aus Blickrichtung für XXXII in Fig. 32; und

Fig. 34     eine schematische Aufsicht, die sowohl den Feldfacettenspiegel nach Fig. 32 als auch einen Anordnungsbereich für einen zugehörigen Pupillenfacettenspiegel zeigt, wobei beispielhaft vier Ausleuchtungskanäle hervorgehoben sind.

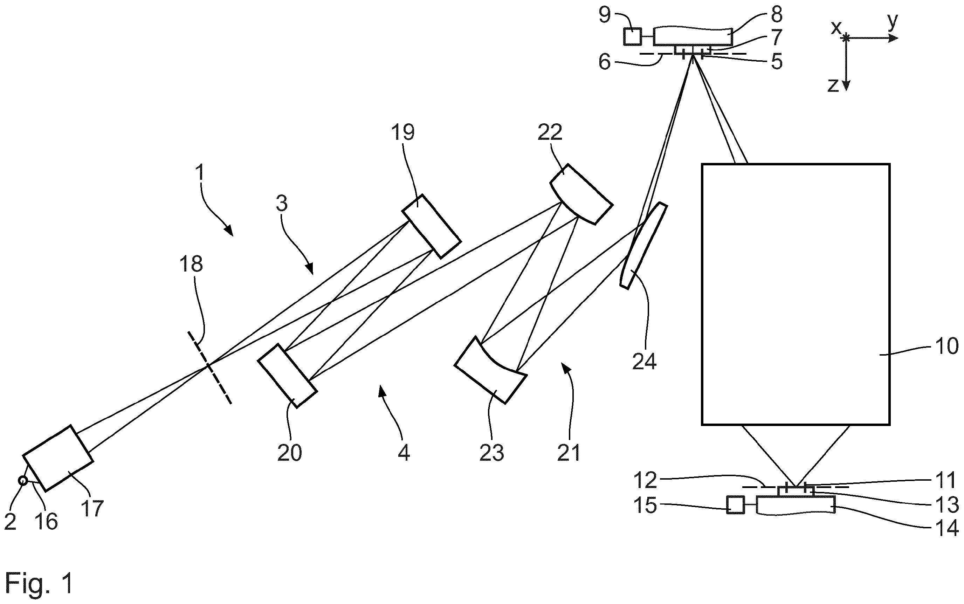

Fig. 1 zeigt schematisch in einem Meridionalschnitt eine Projektionsbelichtungsanlage 1 für die Mikro-Lithographie. Zur Projektionsbelichtungsanlage 1 gehört eine Licht- bzw. Strahlungsquelle 2. Ein Beleuchtungssystem 3 der Projektionsbelichtungsanlage 1 hat eine Beleuchtungsoptik 4 zur Belichtung eines mit einem Objektfeld 5 zusammenfallenden Beleuchtungsfeldes in einer Objektebene 6. Das Beleuchtungsfeld kann auch größer als das Objektfeld 5 sein, insbesondere quer zu einer Verlagerungsrichtung des Objekthalters 8. Das Beleuchtungsfeld kann auch kleiner als das Objektfeld 5 sein, insbesondere längs einer Verlagerungsrichtung des Objekthalters 8. Belichtet wird hierbei ein Objekt in Form eines im Objektfeld 5 angeordneten Retikels 7, das von einem Objekt- beziehungsweise Retikelhalter 8 gehalten ist. Das Retikel 7 wird auch als Lithographiemaske bezeichnet. Der Objekthalter 8 ist über einen Objektverlagerungsantrieb 9 längs einer Verlagerungsrichtung verlagerbar. Eine Projektionsoptik 10 dient zur Abbildung des Objektfeldes 5 in ein Bildfeld 11 in einer Bildebene 12. Abgebildet wird eine Struktur auf dem Retikel 7 auf eine lichtempfindliche Schicht eines im Bereich des Bildfeldes 11 in der Bildebene 12 angeordneten Wafers 13. Der Wafer 13 wird von einem ebenfalls nicht dargestellten Waferhalter 14 gehalten. Der Waferhalter 14 ist über einen Waferverlagerungsantrieb 15 synchronisiert zum Objekthalter 8 ebenfalls längs der Verlagerungsrichtung verlagerbar.

Bei der Strahlungsquelle 2 handelt es sich um eine EUV-Strahlungsquelle mit einer emittierten Nutzstrahlung im Bereich zwischen 5 nm und 30 nm. Es kann sich dabei um eine Strahlungsquelle handeln, die auf einem Synchrotron oder auf einem freien Elektronenlaser (FEL) basiert. Auch eine Plasmaquelle, beispielsweise eine GDPP-Quelle (Plasmaerzeugung durch Gasentladung, gasdischarge-produced plasma) oder eine LPP-Quelle (Plasmaerzeugung durch Laser, laser-produced plasma), ist für die Strahlungsquelle 2 einsetzbar. Informationen zu einer derartigen Strahlungsquelle findet der Fachmann beispielsweise aus der US 6,859,515 B2. Die Lichtquelle 2 arbeitet gepulst, emittiert also eine zeitliche Abfolge von Licht- bzw. Strahlungsimpulsen. Ein zeitlicher Abstand T zwischen zwei zeitlich benachbarten Lichtimpulsen ist reziprok zur Wiederholrate der Lichtquelle 2, die beispielsweise im Bereich von 1 bis 100 kHz, z. B. bei 50 kHz, liegt. Die Dauer eines Lichtpulses ist viel kürzer als der Abstand T zwischen zwei zeitlich benachbarten Lichtpulsen, d. h., die Pausen, in denen keine EUV-Strahlung abgegeben wird, sind viel länger als die Zeitabschnitte, in denen EUV-Strahlung abgegeben wird. Die Kohärenzzeit bzw. Kohärenzdauer ergibt sich aus der genutzten spektralen Bandbreite der EUV-Strahlung und ist wiederum viel kürzer als die Dauer eines Lichtpulses. Die genutzte spektrale Bandbreite kann insbesondere kleiner als die am Ort der Lichtquelle 2 vorhandene spektrale Bandbreite sein.

EUV-Strahlung 16, die von der Strahlungsquelle 2 ausgeht, wird von einem Kollektor 17 gebündelt. Ein entsprechender Kollektor ist aus der EP 1 225 481 A bekannt. Nach dem Kollektor 17 propagiert die EUV-Strahlung 16 durch eine Zwischenfokusebene 18, bevor sie auf einen Feldfacettenspiegel 19 trifft. Der Feldfacettenspiegel 19 ist ein erster Facettenspiegel der Beleuchtungsoptik 4. Der Feldfacettenspiegel 19 hat eine Mehrzahl von Feldfacetten, die in der Fig. 1 nicht dargestellt sind. Die Feldfacetten können ihrerseits jeweils in eine Mehrzahl von Einzelspiegeln unterteilt sein, was in der Zeichnung ebenfalls nicht dargestellt ist. Der Feldfacettenspiegel 19 ist in einer Ebene der Beleuchtungsoptik 4 angeordnet, die zur Objektebene 6 optisch konjugiert ist.

Die EUV-Strahlung 16 wird nachfolgend auch als Beleuchtungslicht oder als Abbildungslicht bezeichnet.

Nach dem Feldfacettenspiegel 19 wird die EUV-Strahlung 16 von einem Pupillenfacettenspiegel 20 reflektiert. Der Pupillenfacettenspiegel 20 ist ein zweiter Facettenspiegel der Beleuchtungsoptik 4. Der Pupillenfacettenspiegel 20 ist in einer Pupillenebene der Beleuchtungsoptik 4 angeordnet, die zur Zwischenfokusebene 18 und zu einer Pupillenebene der Projektionsoptik 10 optisch konjugiert ist oder mit dieser Pupillenebene zusammenfällt. Der Pupillenfacettenspiegel 20 hat eine Mehrzahl von Pupillenfacetten, die in der Fig. 1 nicht dargestellt sind. Mit Hilfe der Pupillenfacetten des Pupillenfacettenspiegels 20 und einer nachfolgenden abbildenden optischen Baugruppe in Form einer Übertragungsoptik 21 mit in der Reihenfolge des Strahlengangs bezeichneten Spiegeln 22, 23 und 24 werden Feldfacetten 25 des Feldfacettenspiegels 19 in das Objektfeld 5 abgebildet. Der letzte Spiegel 24 der Übertragungsoptik 21 ist ein Spiegel für streifenden Einfall ("Grazing Incidence-Spiegel"). Jeweils ein Ausleuchtungskanal, der ein Teilbündel des Beleuchtungslichts 16 führt, wird durch eine erste Facette, also durch eine der Feldfacetten des Feldfacettenspiegels 19, und eine zugeordnete zweite Facette, also durch eine der Pupillenfacetten des Pupillenfacettenspiegels 20, vorgegeben.

Zur Erleichterung der Beschreibung von Lagebeziehungen ist in der Fig. 1 ein kartesisches xyz-Koordinatensystem als globales Koordinatensystem für die Beschreibung der Lageverhältnisse von Komponenten der Projektionsbelichtungsanlage 1 zwischen der Objektebene 6 und der Bildebene 12 eingezeichnet. Die x-Achse verläuft in der Fig. 1 senkrecht zur Zeichenebene in diese hinein. Die y-Achse verläuft in der Fig. 1 nach rechts und parallel zur Verlagerungsrichtung des Objekthalters 8 und des Waferhalters 14. Die z-Achse verläuft in der Fig. 1 nach unten, also senkrecht zur Objektebene 6 und zur Bildebene 12.

Die x-Dimension über das Objektfeld 5 bzw. das Bildfeld 11 wird auch als Feldhöhe bezeichnet.

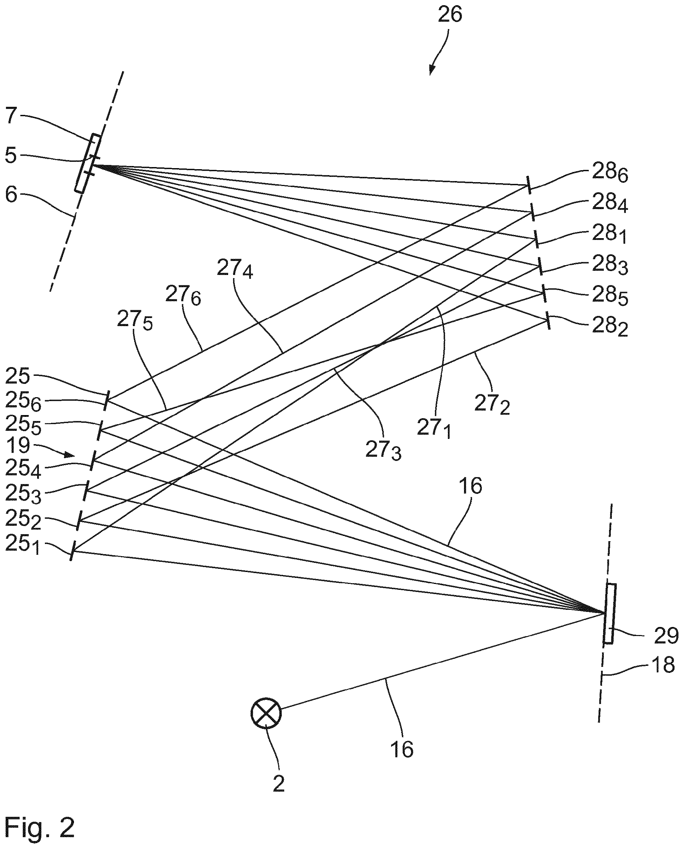

Fig. 2 zeigt eine Variante einer Beleuchtungsoptik 26, die anstelle der Beleuchtungsoptik 4 bei der Projektionsbelichtungsanlage 1 zum Einsatz kommen kann. Komponenten, die denjenigen entsprechen, die vorstehend unter Bezugnahme auf die Fig. 1 bereits erläutert wurden, tragen die gleichen Bezugsziffern und werden nicht nochmals im Einzelnen diskutiert. Zunächst wird nachfolgend die Führung des Beleuchtungslichts 16 ohne Einfluss durch eine nachfolgend noch näher erläuterte optische Verzögerungskomponente beschrieben.

Die Fig. 2 zeigt einen Strahlengang von sechs Ausleuchtungskanälen $27_1$, $27_2$, $27_3$, $27_4$, $27_5$ und $27_6$, über die Teilbündel $16_k$ (k = 1, ...6) des Beleuchtungslichts 16 geführt werden. Dargestellt ist der Strahlengang zwischen der Lichtquelle 2 und dem Retikel 7, wobei der Strahlengang zwischen der Lichtquelle 2 und der Zwischenfokusebene 18 lediglich schematisch angedeutet ist. Der optische Weg zwischen Lichtquelle 2 und Zwischenfokusebene 18 ist für das Beleuchtungslicht 16 näherungsweise konstant. Das Beleuchtungslicht 16 wird durch die Feldfacettenspiegel 25 in Teilbündel zerlegt, die längs der Ausleuchtungskanäle $27_1$ bis $27_6$ geführt

werden. Diejenige Feldfacette 25, an der das Beleuchtungslicht-Teilbündel des Ausleuchtungskanals $27_1$ reflektiert wird, wird nachfolgend als Feldfacette $25_1$ bezeichnet, wobei für die weiteren Ausleuchtungskanäle $27_2$ bis $27_6$ sowohl für die Feldfacetten 25 als auch für die Pupillenfacetten 28 eine entsprechende Indizierung vorgenommen wird. Zum Ausleuchtungskanal $27_3$ gehört beispielsweise die Feldfacette $25_3$ und die Pupillenfacette $28_3$. Die Teilbündel $16_k$ des Beleuchtungslichts 16 sind nachfolgend entsprechend indiziert, sodass zum Ausleuchtungskanal $27_3$ beispielsweise das Beleuchtungslicht-Teilbündel $16_3$ gehört.

Für die Beleuchtungslicht-Teilbündel $16_k$, die über die Ausleuchtungskanäle $27_1$ bis $27_6$ geführt werden, ergeben sich abhängig von den Unterschieden in den Weglängen der Strahlengänge unterschiedliche Laufzeiten. Jedes Beleuchtungslicht-Teilbündel $16_k$ für sich erzeugt eine Ausleuchtung des Beleuchtungsfeldes 5, welche nicht gleichförmig ist, sondern eine quasi-zufällige Intensitätsvariation beinhaltet, welche als Speckle bezeichnet wird. Der Speckle-Kontrast ist um so größer, je kleiner die Anzahl der transversalen Moden der Lichtquelle ist. Besitzen alle Moden die selbe Intensität, so ist der relative Speckle-Kontrast gleich dem Kehrwert der Wurzel der Modenanzahl. Nähere Informationen zur Speckle-Thematik findet sich in Joseph W. Goodman, Speckle Phenomena in Optics, Roberts & Company 2010.

Ist der Weglängenunterschied zwischen zwei Ausleuchtungskanälen 27 kleiner als die Kohärenzlänge des Beleuchtungslichts 16, wobei sich die Kohärenzlänge durch Multiplikation der Kohärenzzeit des Beleuchtungslichtes mit der Lichtgeschwindigkeit ergibt, so können die zugehörigen Beleuchtungslicht-Teilbündel $16_k$ miteinander interferieren. Im besten Fall ist der Restkontrast der kombinierten Ausleuchtung des Beleuchtungsfeldes 5 durch zwei oder mehr Beleuchtungslicht-Teilbündel $16_k$ dann gleich dem, der sich bei Ausleuchtung mit nur einem Teilbündel ergeben würde. Insbesondere bei einer Lichtquelle 2 mit nur wenigen Moden kann es zusätzlich zu einer systematischen Interferenzstruktur in der Ausleuchtung auf dem Beleuchtungsfeld 5, welche sogar zu einem stärkeren Kontrast als bei einem einzelnen Beleuchtungslicht-Teilbündel 16 führt, kommen. Ein Beispiel hierfür bildet die Überlagerung zweier Teilbündeln 16 unter einem kleinen Winkel, welche zu einer periodischen Durchmodulation führt.

Ist der Laufzeitunterschied zwischen zwei Ausleuchtungskanälen 27 größer als die Kohärenzlänge des Beleuchtungslichts 16, so überlagern sich die beiden unabhängigen Specklemuster der beiden Ausleuchtungskanäle, was zu einer Verbesserung der Gleichförmigkeit der Ausleuchtung des Beleuchtungsfeldes 6 führt. Ist der Laufzeitunterschied zwischen zwei Ausleuchtungskanälen 27 größer als die Kohärenzlänge des Beleuchtungslichts 16, so führt die Überlagerung im Beleuchtungsfeld 5 also zu einem vorteilhaften Verhalten, während ein Laufzeitunterschied kleiner als die Kohärenzlänge zu keiner Verbesserung oder sogar zu einer unvorteilhaften Veränderung der Gleichförmigkeit führt.

Die Differenzen zwischen den Laufzeiten der Beleuchtungslicht-Teilbündel 16 längs der Ausleuchtungskanäle $27_1$ bis $27_6$ ist in der in Fig. 2 dargestellten vorteilhaften Ausgestaltung daher so gewählt, dass die Laufzeit längs aller Paare von Ausleuchtungskanälen $27_k$, $27_l$ sich jeweils um mehr als die Kohärenzzeit des Beleuchtungslichts unterscheidet. Dieses impliziert, dass die minimale Laufzeit-Differenz zwischen dem Ausleuchtungskanal 27 mit der kürzesten Weglänge und dem Ausleuchtungskanal mit der längsten Weglänge, gemessen zwischen einer Lichtquelle 2 für das Beleuchtungslicht 16 und dem Beleuchtungsfeld 5, mindestens das Produkt aus der Ausleuchtungskanalzahl und der Kohärenzzeit des Beleuchtungslichts beträgt. Da die Laufzeit-Differenzen längs der Ausleuchtungskanäle $27_1$ bis $27_6$ vom Auftreffort im Beleuchtungsfeld 5 abhängen und die obige Bedingung für jeden Auftreffort gelten muss, kann für mindest einige, insbesondere auch fast alle Feldorte die Laufzeit-Differenz zwischen dem Ausleuchtungskanal mit der kürzesten Weglänge und dem Ausleuchtungskanal mit der längsten Weglänge deutlich größer als das Produkt der Ausleuchtungskanalzahl und der Kohärenzzeit des Beleuchtungslichts 16 sein.

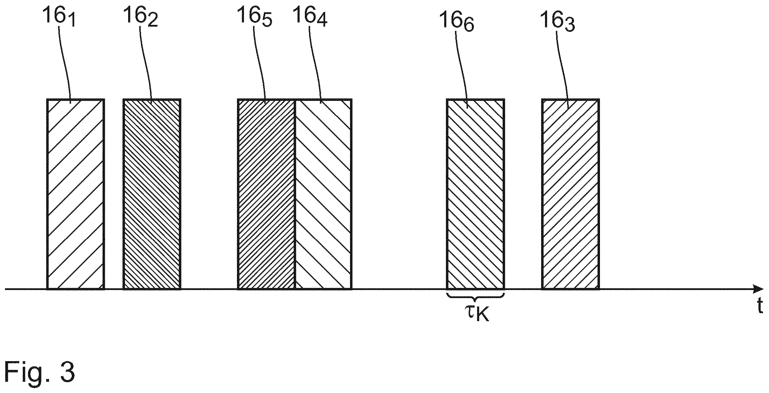

Fig. 3 verdeutlicht die Wirkung dieser Auslegung der Beleuchtungsoptik 4 oder der Beleuchtungsoptik 26. Dargestellt sind längs einer Zeitachse t Auftreff-Zeitpunkte auf das Retikel 7 von Beleuchtungslicht-Anteilen $16_1$ bis $16_6$, die entlang der Ausleuchtungskanäle $27_1$ bis $27_6$ geführt worden sind, und die gleichzeitig die Lichtquelle 2 verlassen haben. Absolute Zeitangaben auf der dargestellten Zeitachse t haben daher keine Bedeutung, sondern nur Zeitdifferenzen sind relevant. Die Breite der eingezeichneten Balken repräsentiert die Kohärenzzeit bzw. Kohärenzdauer $\tau_k$ des Beleuchtungslichts 16. Gesamt-Impulsdauern der Ausleuchtungskanal-Teil-Lichtimpulse $16_k$ können deutlich länger sein als die in der Fig. 3 eingezeichneten Balken. Diese Gesamt-Impulsdauern der Ausleuchtungskanal-Teil-Lichtimpulse $16_k$ spielen für die nachfolgende Interferenzbetrachtung keine Rolle.

Die Beleuchungsoptiken 4 bzw. 26 sind so ausgelegt, dass sich die Kohärenzdauer-Balken der Teil-Lichtimpulse $16_k$ nicht überlappen.

Durch eine derartige Ausgestaltung der Beleuchtungsoptik wird also die Gleichförmigkeit der Ausleuchtung eines Beleuchtungsfeldes optimiert, da jeder verwendete Ausleuchtungskanal $27_k$ zu einer Verbesserung der Gleichförmigkeit führt.

Die Gestaltung der Beleuchtungsoptik gemäß den beschriebenen Ausführungsbeispielen kann gewährleisten, dass für alle Paare von Ausleuchtungskanälen $27_k$, $27_l$ eine Laufzeit-Differenz größer als die Kohärenzlänge erreicht wird. Es ergibt sich eine entsprechende Verbesserung der Gleichförmigkeit der Feldbeleuchtung. Diese Vorteile der beschriebenen Ausführungen kommen besonders bei Beleuchtungs-Lichtquellen zum Tragen, die weniger als 10 transversale Moden aufweisen und eine entsprechend große transversale Kohärenzlänge haben. Die transversale Kohärenzlänge muß von der Kohärenzlänge, welche sich durch Multiplikation der Kohärenzzeit des Beleuchtungslichts 16 mit der Lichtgeschwindigkeit ergibt, unterschieden werden. Weiterhin kommen die Vorteile der beschriebenen Ausführungen bei breitbandigen Lichtquellen besonders zum Tragen. Schließlich kommen die Vorteile der beschriebenen Ausführungen bei Beleuchtungsoptiken zum Tragen, die weniger als einige hundert Ausleuchtungskanäle, insbesondere weniger als hundert Ausleuchtungskanäle haben.

Über die beschriebenen Ausführungen kann vermieden werden, dass eine Laufzeit-Differenz zwischen einem Ausleuchtungskanal mit einer kürzesten Laufzeit bzw. Weglänge innerhalb der Beleuchtungsoptik und einem Ausleuchtungskanal mit einer längsten Weglänge innerhalb der Beleuchtungsoptik zu gering ist, sodass dann insbesondere eine störende Speckle-Erzeugung nicht ausgeschlossen werden könnte. Eine derartige zu geringe Laufzeit-Differenz zwischen dem Ausleuchtungskanal mit der kürzesten Weglänge und dem Ausleuchtungskanal mit der längsten Weglänge, die durch die beschriebenen Ausführungen vermieden ist, ergibt sich als Produkt einer Anzahl der Ausleuchtungskanäle und der Kohärenzlänge.

Fig. 2 zeigt die Auslegung der Beleuchtungsoptik 26 unter Verwendung einer optischen Verzögerungskomponente 29. Die optische Verzögerungskomponente 29 spaltet das einfallende Beleuchtungslicht 16 in mehrere unterschiedlich verzögerte Teile auf, welche im Objektfeld 5 räumlich überlagert werden. Die Laufzeit-Differenzen zwischen den Laufzeiten der Beleuchtungslicht-Teilbündel längs der Ausleuchtungskanäle $27_1$ bis $27_6$ setzen sich dabei zusammen aus den Laufzeit-Differenzen, die sich aufgrund der unterschiedlichen Strahlwege der Ausleuchtungskanäle $27_1$ bis $27_6$ ergeben, und zusätzlichen Verzögerungs-Laufzeit-Differenzen, welche die Beleuchtungslicht-Teilbündel aufgrund der Wirkung einer optischen Verzögerungskomponente 29 erfahren. Das Beleuchtungslicht-Teilbündel $16_k$ entlang des Ausleuchtungskanals $27_k$ besteht daher aus mehreren Komponenten $16_k^1$, welche jeweils eine eigene Laufzeit besitzen, wobei der Index k den Ausleuchtungskanal und der Index 1 die Verzögerung durch die optische Verzögerungskomponente 29 bezeichnet.

Die optische Verzögerungskomponente 29 ist bei der Ausführung nach Fig. 2 als reflektierender Stufenspiegel ausgebildet, der in der Zwischenfokusebene 18 angeordnet ist, also am Ort eines Zwischenfokus zwischen der Lichtquelle 2 und dem Feldfacettenspiegel 19. Dieser Zwischenfokus wird bei der Beleuchtungsoptik 26 nach Fig. 2 durch einen Kollektor im Strahlengang des Beleuchtungslichts 16 nach der Lichtquelle 2, der in der Fig. 2 nicht dargestellt ist, erzeugt.

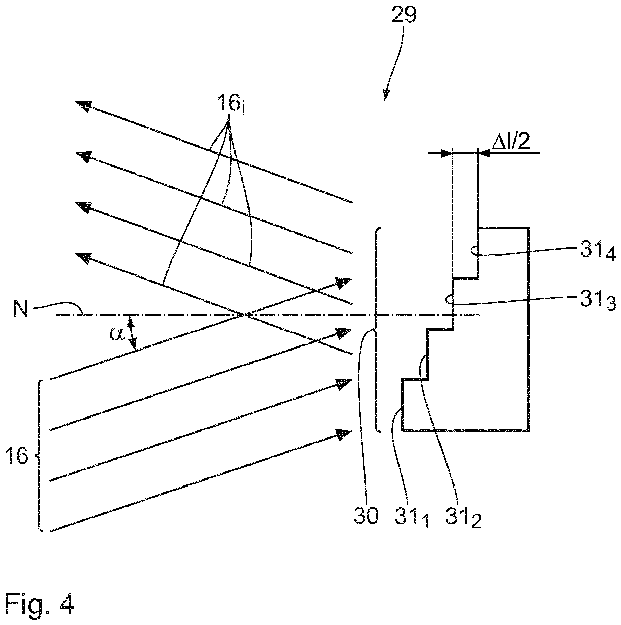

Fig. 4 zeigt die optische Verzögerungskomponente 29 stärker im Detail. Eine Reflexionsfläche 30 der optischen Verzögerungskomponente 29 weist bei der Ausführung nach Fig. 3 insgesamt vier Spiegelstufen $31_1$, $31_2$, $31_3$ und $31_4$ auf. Längs einer Normalen N auf die Reflexionsfläche 30 haben Benachbarte der Spiegelstufen 31 einen Abstand von $\Delta l/2$ zueinander. Da ein Einfallswinkel $\alpha$ des Beleuchtungslichts 16 auf die optische Verzögerungskomponente 29 klein ist, gilt in guter Näherung eine Verzögerungs-Laufzeit-Differenz zwischen den Anteilen des Beleuchtungslichts 16, die an Benachbarten der Spiegelstufen $31_1$, $31_2$, $31_3$ bis $31_4$ reflektiert werden, die einer optischen Weglänge von $\Delta l$ entspricht. Die Kombination der möglichen Strahlungswege über die vier Spiegelstufen $31_1$, $31_2$, $31_3$ bis $31_4$ mit den sechs Ausleuchtungskanälen $27_1$, $27_2$, $27_3$, $27_4$, $27_5$ und $27_6$ ergibt vierundzwanzig Beleuchtungslicht-Teilbündel $16_1^1$ bis $16_6^4$. Die Indizierung $16_k^1$ ist dabei so, wie vorstehend im Zusammenhang mit der Fig. 2 bereits erläutert. $\Delta l'$ ist das zeitliche Analogon zur Laufwegdifferenz $\Delta l$, also die Laufzeit-Differenz.

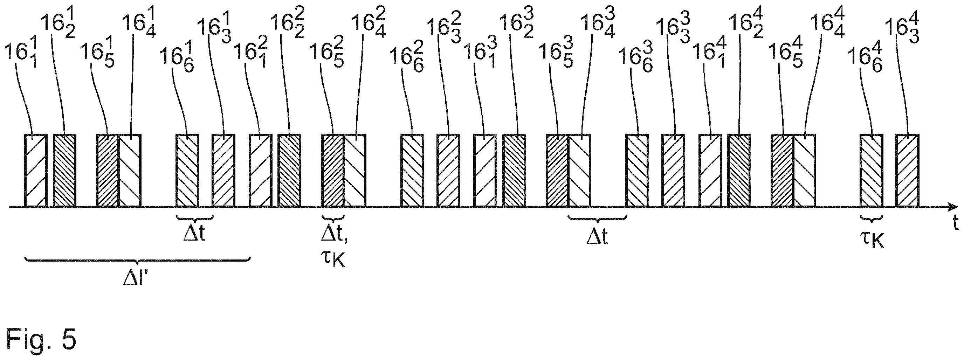

Fig. 5 verdeutlicht in einer zu Figur 3 analogen Darstellung die Wirkung der optischen Verzögerungskomponente 29. Dargestellt sind längs einer Zeitachse t Auftreff-Zeitpunkte von Beleuchtungslicht-Anteilen $16_k^1$, die jeweils zu einem gegebenen Zeitpunkt die Strahlungsquelle 2 verlassen haben, auf dem Retikel 7. Bedingt durch die kombinierte Wirkung einerseits der unterschiedlichen Wege der Ausleuchtungskanäle 27 und andererseits der zusätzlichen Verzögerungs-Laufzeit-Differenz auf Grund der Verzögerungskomponente 29 ergibt sich für die dargestellten sechs Ausleuchtungskanal-Teil-Lichtimpulse $16_1$ bis $16_6$ eine gesamte Laufzeit-Differenz, die dazu führt, dass der zeitliche Abstand zwischen den Auftreff-Zeitpunkten zweier zeitlich benachbart zueinander auf das Retikel 7 auftreffenden Ausleuchtungskanal-Teil-Lichtimpulsen $16_k^1$, $\Delta t$, immer größer als eine Kohärenzdauer des Beleuchtungslichts 16 der Lichtquelle 2 ist. Die Auftreff-Zeitpunkte entsprechen den linken Kanten der in Fig. 5 dargestellten Balken, während die Breite der Balken analog zu Fig. 3 gleich der Kohärenzdauer des Beleuchtungslichts 16 ist. Es gilt also $\Delta t > \tau_K$, wobei $\tau_K$ die Koheränzdauer der Lichtquelle 2 ist Im Falle eines freie Elektronen-Lasers (FEL) als Lichtquelle 2 mit einer entsprechenden spektralen Bandbreite beträgt eine Kohärenzlänge, die der Kohärenzdauer $\tau_K$ entspricht, beispielsweise 1,35 $\mu$m. Dies gilt für eine Zentralwellenlänge von 13,5 nm und einer Bandbreite $\lambda/\Delta\lambda$ von 100.

Bei der optischen Verzögerungskomponente 29 wird also eine vergleichsweise große Verzögerung aufgeprägt. Die Verzögerung durch die optische Verzögerungskomponente 29 ist die Grö-$\beta$enordnung einer Verzögerungsstufe zwischen zwei Benachbarten der Spiegelstufen $31_1$ bis $31_4$. Diese Stufengröße beträgt bei der optischen Verzögerungskomponente mindestens $\Delta l/2$, wobei gilt $\Delta l > \tau_{K'}$. Hierbei ist $\Delta l$ die maximale Weglängendifferenz zwischen dem Ausleuchtungskanal 27 mit der kürzesten Weglänge und dem Ausleuchtungskanal mit der längsten Weglänge. $\tau_{K'}$ ist das Weglängenanalogon zur Kohärenzdauer $\tau_K$.

Bei der Ausleuchtung nach Fig. 5 "sieht" das Retikel, eine extreme Zeitauflösung und einen extrem kurzen Lichtimpuls der Lichtquelle 2 vorausgesetzt, in schneller Abfolge Beleuchtungsanteile 16 aus den Richtungen der Beleuchtungslichtkanäle $27_1$, $27_2$, $27_5$, $27_4$, $27_6$ und $27_3$. Dieser Lichtschauer aus verschiedenen Richtungen wiederholt sich in rascher Folge mehrfach, und zwar einmal pro benutzter Stufe der optischen Verzögerungskomponente 29.

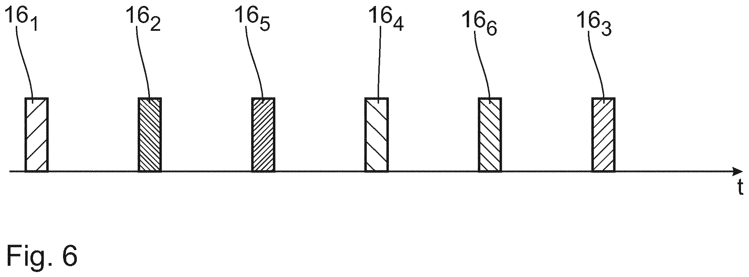

Figur 6 zeigt in Analogie zu Fig. 3 längs einer Zeitachse t Auftreff-Zeitpunkte auf das Retikel 7 von Beleuchtungslicht-Anteilen $16_1$ bis $16_6$, die entlang der Ausleuchtungskanäle $27_1$ bis $27_6$ geführt worden sind, und die zu einem gegebenen Zeitpunkt die Lichtquelle 2 verlassen haben. Hauptunterschied zwischen Fig. 3 und Fig. 6 ist, dass Fig. 6 auf einer Beleuchtungsoptik 4 bzw. 26 basiert, in der die Weglängenunterschiede zwischen den Beleuchtungslichtkanälen $27_1$ bis $27_6$ größer als bei der Ausführung nach Fig. 3 sind.

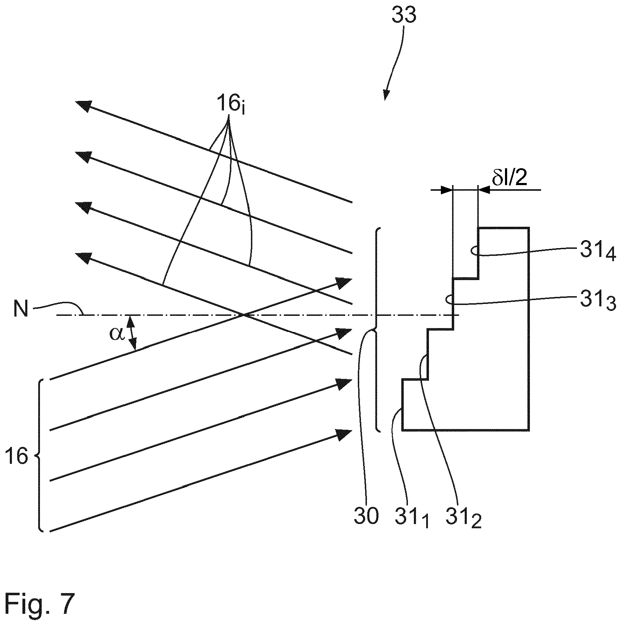

Fig. 7 zeigt eine weitere Ausführung einer optischen Verzögerungskomponente 33. Diese wird nachfolgend dort beschrieben, wo sie sich von der optischen Verzögerungskomponente 29 unterscheidet. Ein Hauptunterschied zur optischen Verzögerungskomponente 29 ist die Größenordnung einer Verzögerungsstufe zwischen zwei Benachbarten der Spiegelstufen $31_1$ bis $31_4$. Diese Stufengröße beträgt bei der optischen Verzögerungskomponente 33 $\delta l/2$, wobei gilt $\tau_{K'} < \delta l < \Delta L / M$. Hierbei ist $\Delta L$ die minimale Weglängen-Differenz entlang zweier Beleuchtungslichtkanäle $27_1$ bis $27_6$ und M die Anzahl der Stufen der Verzögerungskomponente 33.

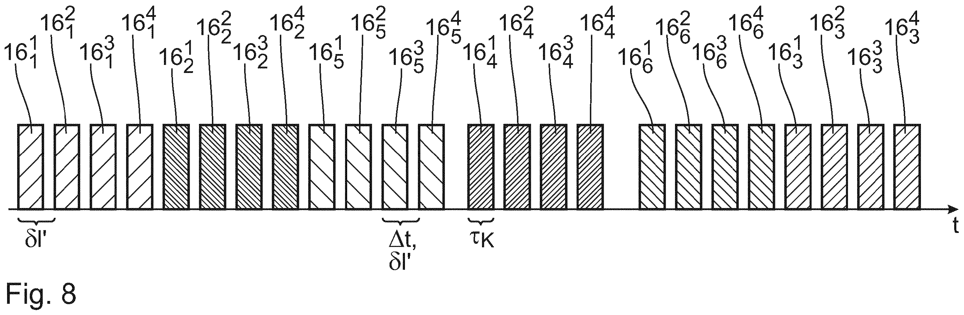

Bei der optischen Verzögerungskomponente 33 wird also eine vergleichsweise geringe Verzögerung aufgeprägt, sodass alle Anteile $16_i^1$ des Beleuchtungslichts 16, welche zu einem bestimmten Zeitpunkt die Strahlungsquelle 2 verlassen und die über einen bestimmten Beleuchtungslichtkanal $27_i$ über verschiedene Stufen der Verzögerungskomponente 33 gelaufen sind, das Retikel 7 erreicht haben, bevor Anteile $16_j^1$ des Beleuchtungslichts 16, welche über einen anderen Beleuchtungskanal $27_j$ gelaufen sind, das Retikel 7 erreichen. Dieses ist in Fig. 8 in einer zu Fig. 5 analogen Repräsentation dargestellt.

Bei der zeitlichen Auftreffabfolge nach Fig. 8 "sieht" das Retikel 7, eine extreme Zeitauflösung und einen extrem kurzen Lichtimpuls der Lichtquelle 2 vorausgesetzt, zunächst eine Abfolge von einander zeitlich korrespondierenden Anteilen der Ausleuchtungskanal-Teil-Lichtimpulse aus einer ersten Beleuchtungsrichtung, dann eine Abfolge von einander zeitlich korrespondierenden Anteilen der Ausleuchtungskanal-Teil-Lichtimpulse aus einer zweiten Beleuchtungsrichtung und so weiter.

Ein minimaler zeitlicher Abstand $\Delta t$ zwischen den Auftreff-Zeitpunkten der einander zeitlich korrespondierenden Anteile der Ausleuchtungskanal-Teil-Lichtimpulse $16_k^1$ auf dem Retikel 7 ist auch hier größer als die

Kohärenzdauer $\tau_{\kappa}$ der Lichtquelle 2. $\delta1'$ ist das zeitliche Analogon zur Laufwegdifferenz $\delta1$, also die Laufzeit-Differenz. Hier gilt $\delta1' = \Delta t$.

Die optische Verzögerungskomponente 33 kann am Ort der Pupillenfacetten des Pupillenfacettenspiegels 22 angeordnet sein. Hierdurch werden eine zusätzliche Reflektion und der damit verbundene Lichtverlust vermieden. Durch die kleine Stufenhöhe ist eine leichtere Integration in andere optische Komponenten wie zum Beispiel einen Facettenspiegel möglich, als dieses bei einer größeren Stufenhöhe der Fall.

Die optische Verzögerungskomponente 29 kann am Ort eines Zwischenfokus angeordnet sind. Große Stufenhöhe sind etwas aufwendiger herzustellen, und bei Plazierung am Ort eines Zwischenfokus wird nur ein einziges derartiges Element benötigt.

Bei der Projektionsbelichtung mit Hilfe der Projektionsbelichtungsanlage 1 wird wenigstens ein Teil des Retikels 7 im Objektfeld 5 auf einen Bereich der lichtempfindlichen Schicht auf den Wafer 13 im Bildfeld 11 zur lithografischen Herstellung eines mikro- beziehungsweise nanostrukturierten Bauteils, insbesondere eines Halbleiterbauteils, beispielsweise eines Mikrochips, abgebildet. Hierbei werden das Retikel 7 und der Wafer 13 zeitlich synchronisiert in der y-Richtung kontinuierlich im Scannerbetrieb verfahren.

Nachfolgend wird eine weitere Ausführung einer Projektionsbelichtungsanlage für die Mikrolithographie erläutert. Komponenten und Funktionen, die vorstehend bereits erläutert wurden, tragen die gleichen Bezugsziffern und werden nachfolgend nur dort erläutert, wo dies zum Verständnis abweichender Komponenten bzw. Funktionen erforderlich ist.

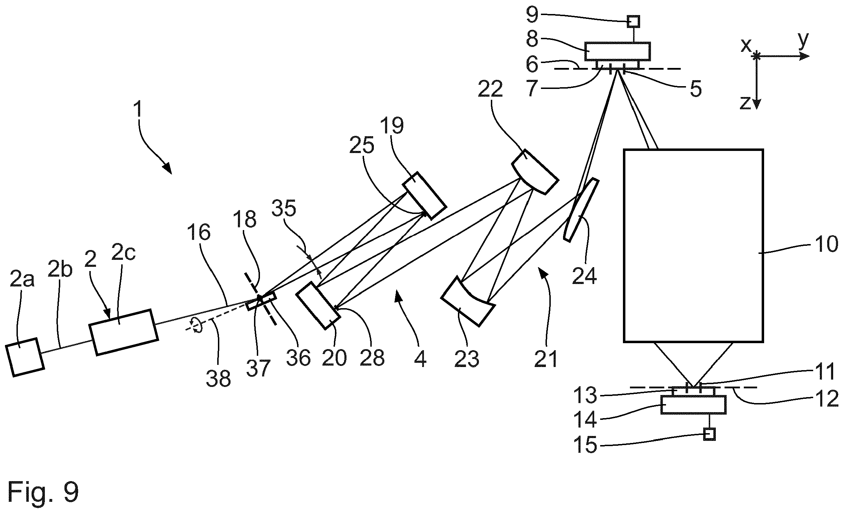

Die Projektionsbelichtungsanlage 1 für die Mikrolithographie nach Fig. 9 dient zur Herstellung eines mikro- bzw. nanostrukturierten elektronischen Halbleiter-Bauelements. Die Licht- bzw. Strahlungsquelle 2 emittiert EUV-Strahlung im Wellenlängebereich beispielsweise zwischen 5 nm und 30 nm. Die Lichtquelle 2 ist bei der Ausführung nach Fig. 9 als Freie-Elektronen-Laser (FEL) ausgeführt. Es handelt sich dabei um eine Synchrotronstrahlungsquelle, die kohärente Strahlung mit sehr hoher Brillanz erzeugt. Vorveröffentlichungen, in denen derartige FEL beschrieben sind, sind in der WO 2009/121 438 A1 angegeben. Eine Lichtquelle 2, die bei der Ausführung nach Fig. 9 beispielsweise zum Einsatz kommen kann, ist beschrieben in Uwe Schindler "Ein supraleitender Undulator mit elektrisch umschaltbarer Helizität", Forschungszentrum Karlsruhe in der Helmholtz-Gemeinschaft, wissenschaftliche Berichte, FZKA 6997, August 2004, und in der DE 103 58 225 B3.

Die EUV-Lichtquelle 2 hat eine Elektronenstrahl-Versorgungseinrichtung 2a zur Erzeugung eines Elektronenstrahls 2b und eine EUV-Generationseinrichtung 2c. Letztere wird über die Elektronenstrahl-Versorgungseinrichtung 2a mit dem Elektronenstrahl 2b versorgt. Die EUV-Generationseinrichtung 2c ist als Undulator ausgeführt.

Die Lichtquelle 2 hat eine mittlere Leistung von 2,5 kW. Die Pulsfrequenz der Lichtquelle 2 beträgt 30 MHz. Jeder einzelne Strahlungsimpuls trägt dann eine Energie von 83 $\mu$J. Bei einer Strahlungsimpulslänge von 100 fs entspricht dies einer Strahlungsimpulsleistung von 833 MW.

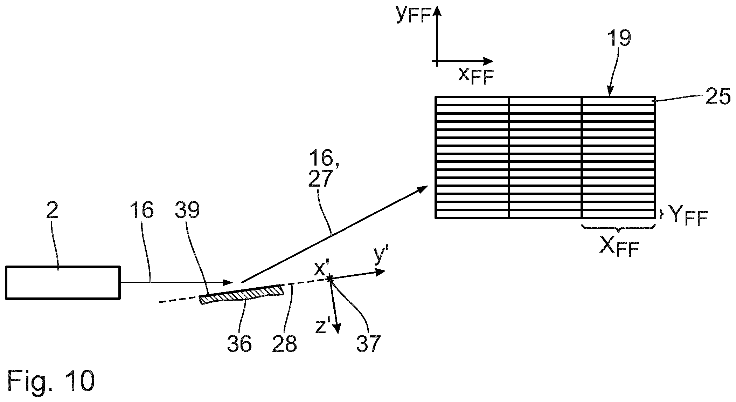

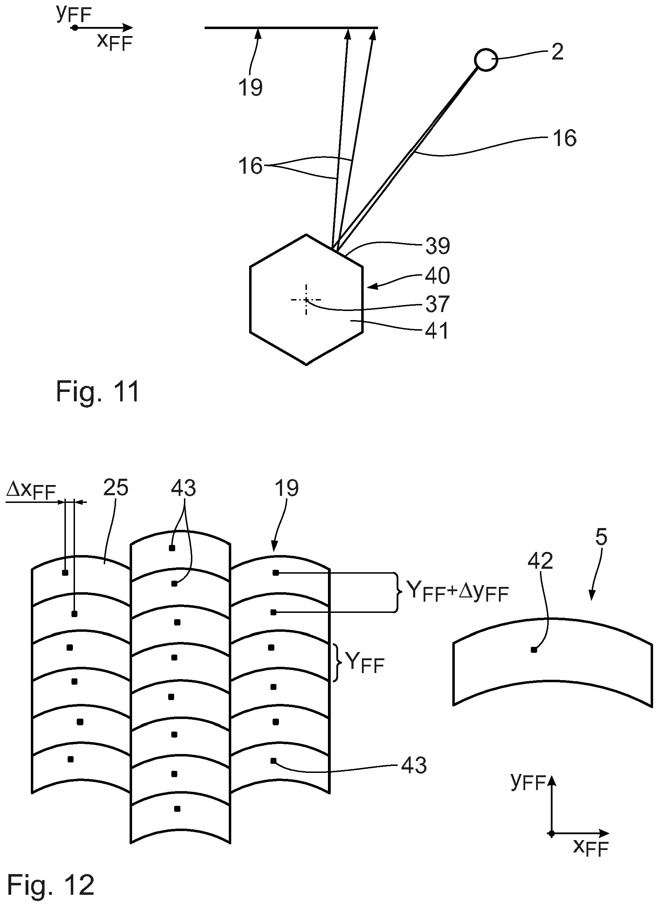

Zur Beleuchtung und Abbildung innerhalb der Projektionsbelichtungsanlage 1 wird als Beleuchtungslicht als Beleuchtungs- bzw. Abbildungslicht 16 ein Nutzstrahlungsbündel genutzt, das auch als Ausgabestrahl bezeichnet ist. Das Nutzstrahlungsbündel 16 wird innerhalb eines Öffnungswinkels 35, der an die Beleuchtungsoptik 4 der Projektionsbelichtungsanlage 1 angepasst ist, mit Hilfe einer noch zu beschreibenden Scan-Einrichtung 36 ausgeleuchtet. Das Nutzstrahlungsbündel 16 hat, ausgehend von der Lichtquelle 2, eine Divergenz, die kleiner ist als 5 mrad. Die Scan-Einrichtung 36 ist in der Zwischenfokusebene 18 der Beleuchtungsoptik 4 angeordnet. Nach der Scan-Einrichtung 36 trifft das Nutzstrahlungsbündel 16 zunächst auf den Feldfacettenspiegel 19. Details zur Scan-Einrichtung 36 werden nachfolgend anhand der Fig. 10 und 11 noch erläutert werden.

Das Nutzstrahlungsbündel 16 hat insbesondere eine Divergenz, die kleiner ist als 2 mrad und bevorzugt kleiner ist als 1 mrad. Die Spotgröße des Nutzstrahlungsbündels auf den Feldfacettenspiegel 19 beträgt etwa 4 mm.

Fig. 10 zeigt beispielhaft eine Facettenanordnung, ein Feldfacetten-Array, von Feldfacetten 25 des Feldfacettenspiegels 19. Der Feldfacettenspiegel 19 stellt einen Facettenspiegel eines Beleuchtungssystems der Projektionsbelichtungsanlage 1 dar. Dargestellt ist beispielhaft nur ein Teil der tatsächlich vorhandenen Feldfacetten 25 mit drei Spalten und 15 Zeilen. Das Feldfacetten-Array des Feldfacettenspiegels 19 hat insgesamt 6 Spalten und 75 Zeilen. Die Feldfacetten 25 haben eine rechteckige Form. Auch andere Formen der Feldfacetten 25 sind möglich, beispielsweise eine Bogenform, wie nachfolgend im Zusammenhang mit den Figuren 12 bis 17 dargestellt, oder eine ringförmige oder teilringförmige Geometrie. Insgesamt weist der Feldfacettenspiegel 19 in einer möglichen Variante also 450 Feldfacetten 25 auf. Jede Feldfacette 25 hat eine Ausdehnung von 50 mm in der in der Fig. 10 horizontalen und 4 mm in der in der Fig. 10 vertikalen Richtung. Das gesamte Feldfacetten-Array hat entsprechend eine Ausdehnung von 300 mm x 300 mm. Die Feldfacetten 25 sind in der Fig. 10 nicht maßstäblich dargestellt.

Nach Reflexion am Feldfacettenspiegel 19 trifft das in Strahlbüschel bzw. Beleuchtungslicht-Teilbündel, die den einzelnen Feldfacetten 25 zugeordnet sind, aufgeteilte Nutzstrahlungsbündel 16 auf den Pupillenfacettenspiegel 20. Pupillenfacetten 28 des Pupillenfacettenspiegels 20, von denen in der Fig. 9 lediglich eine Pupillenfacette 28 dargestellt ist, sind rund. Jedem von einer der Feldfacetten 25 reflektierten Strahlbüschel des Nutzstrahlungsbündels 16 ist eine dieser Pupillenfacetten 28 zugeordnet, so dass jeweils ein beaufschlagtes Facettenpaar mit einer der Feldfacetten 25 und einer der Pupillenfacetten 28 einen Ausleuchtungskanal bzw. Strahlführungskanal 27 für das zugehörige Strahlbüschel des Nutzstrahlungsbündels 16 vorgibt. Die kanalweise Zuordnung der Pupillenfacetten 28 zu den Feldfacetten 25 erfolgt abhängig von einer gewünschten Beleuchtung durch die Projektionsbelichtungsanlage 1. Der Ausgabestrahl 16 ist also zur Vorgabe individueller Beleuchtungswinkel längs des Ausleuchtungskanals sequentiell über Paare aus jeweils einer der Feldfacetten 25 und jeweils einer der Pupillenfacette 28 geführt. Es können auch mehrere der Feldfacetten 25 und damit mehrere Ausleuchtungskanäle 27 gleichzeitig beleuchtet werden. Zu einem bestimmten Zeitpunkt kann das Beleuchtungslicht 16 über genau ein Paar oder auch über mehrere, aber in der Regel wenige Paare aus jeweils einer Feldfacette 25 und jeweils einer Pupillenfacette 28 geführt werden. Zur Ansteuerung jeweils vorgegebener Pupillenfacetten 28 sind die Feldfacettenspiegel 25 jeweils individuell verkippt.

Über den Pupillenfacettenspiegel 20 und die nachfolgende, aus den drei EUV-Spiegeln 22, 23, 24 bestehende Übertragungsoptik 21 werden die Feldfacetten 25 in das Beleuchtungs- bzw. Objektfeld 5 in der Retikel- bzw. Objektebene 6 der Projektionsoptik 10 der Projektionsbelichtungsanlage 1 abgebildet. Der EUV-Spiegel 24 ist als Spiegel für streifenden Einfall (grazing incidence-Spiegel) ausgeführt.

Aus der Sequenz der einzelnen Beleuchtungswinkel, die über die Ausleuchtungskanäle individueller Facettenpaare 25, 28 vorgegeben wird, ergibt sich über die Scanintegration aller Ausleuchtungskanäle, die über eine scannende Beleuchtung der Facetten 25 des Feldfacettenspiegels 19 mit Hilfe der Scan-Einrichtung 36 herbeigeführt wird, eine Beleuchtungswinkelverteilung der Beleuchtung des Objektfeldes 5 über die Beleuchtungsoptik 4.

Bei einer nicht dargestellten Ausführung der Beleuchtungsoptik 4, insbesondere bei einer geeigneten Lage einer Eintrittspupille der Projektionsoptik 10, kann auf die Spiegel 22, 23 und 24 auch verzichtet werden, was zu einer entsprechenden Transmissionserhöhung der Projektionsbelichtungsanlage für das Nutzstrahlungsbündel 16 führt.

Auf dem gesamten Objektfeld 5 kommt pro vollständigem Scan des Feldfacettenspiegels 19 eine Gesamtdosis von 49,2 J an. Diese Gesamtdosis ist noch mit der Gesamttransmission der Beleuchtungsoptik 4 einerseits und der Projektionsoptik 10 andererseits zu multiplizieren, um die Gesamtdosis im Bildfeld 11 zu erhalten. Diese beispielhaften Angaben gehen davon aus, dass ein vollständiger Scan des gesamten Feldfacettenspiegels 19 während des Zeitraums, den ein Punkt auf dem Wafer 13 benötigt, um das Bildfeld 11 zu durchlaufen, durchgeführt wird. Ein schnelleres Scannen des Beleuchtungslichts 16 über den Feldfacettenspiegel 19 ist grundsätzlich möglich. Der Zeitraum, den ein Punkt auf dem Wafer 13 benötigt, um bei der scannenden Belichtung das Bildfeld 11 zu durchlaufen, kann ein ganzteiliges Vielfaches des Zeitraums sein, welcher zum Scannen des gesamten Feldfacettenspiegels 19 mit dem Beleuchtungslicht 16 benötigt wird.

In der Objektebene 6 im Bereich des Objektfeldes 5 ist das das Nutzstrahlungsbündel 16 reflektierendes Retikels 7 angeordnet. Das Retikel 7 wird vom Retikelhalter 8 getragen, der über den Retikelverlagerungsantrieb 9 angesteuert verlagerbar ist.

Die Projektionsoptik 10 bildet das Objektfeld 5 in das Bildfeld 11 in der Bildebene 12 ab. In dieser Bildebene 12 ist bei der Projektionsbelichtung der Wafer 13 angeordnet, der eine lichtempfindliche Schicht trägt, die während der Projektionsbelichtung mit der Projektionsbelichtungsanlage 1 belichtet wird. Der Wafer 13 wird von einem Waferhalter 14 getragen, der wiederum über einen Waferverlagerungsantrieb 15 gesteuert verlagerbar ist.

Zur Erleichterung der Darstellung von Lagebeziehungen wird nachfolgend ein xyz-Koordinatensystem verwendet. Die x-Achse steht senkrecht auf der Zeichenebene der Fig. 9 und weist in diese hinein. Die y-Achse verläuft in der Fig. 9 nach rechts. Die z-Achse verläuft in der Fig. 9 nach unten.

Bei der Projektionsbelichtung werden sowohl das Retikel 7 als auch der Wafer 13 in der Fig. 9 in y-Richtung durch entsprechende Ansteuerung des Retikelverlagerungsantriebs 9 und des Waferverlagerungsantriebs 15 synchronisiert gescannt. Der Wafer wird während der Projektionsbelichtung mit einer Scangeschwindigkeit von typisch 600 mm/s in der y-Richtung gescannt. Das synchronisierte Scannen der beiden Verlagerungsantriebe 9, 15 kann unabhängig vom scannenden Betrieb der Scan-Einrichtung 36 erfolgen.

Die lange Seite der Feldfacetten 25 steht senkrecht auf einer Scanrichtung y. Das x/y-Aspektverhältnis der Feldfacetten 25 entspricht demjenigen des schlitzförmigen Objektfeldes 5, welches ebenfalls rechteckig oder gebogen ausgeführt sein kann.

Fig. 10 und 11 zeigen die Ausführungen der Scan-Einrichtung 36 für das Nutzstrahlungsbündel 16 stärker im Detail. Zur Erleichterung der Darstellung von Lagebeziehungen wird für die Scan-Einrichtung in der Fig. 10 ein x'-y'-Koordinatensystem verwendet. Die x'-Achse, die zur x-Achse parallel ist, verläuft in der Fig. 10 in die Zeichenebene hinein. Die y'-Achse, die in der yz-Ebene liegt, verläuft in der Fig. 10 schräg nach rechts oben.

Zur Darstellung von Lagebeziehungen in Bezug auf den Feldfacettenspiegel 19 wird entsprechend ein $x_{FF}$-$y_{FF}$-Koordinatensystem verwendet. Die $x_{FF}$-Achse verläuft parallel zur x-Achse, also in Richtung der längeren Seiten der rechteckigen Feldfacetten 25. Die $y_{FF}$-Richtung verläuft senkrecht hierzu in Richtung der kürzeren Seiten der rechteckigen Feldfacetten 25. In der $x_{FF}$-Richtung haben die Feldfacetten 25 eine Erstreckung von $X_{FF}$. In der $y_{FF}$- Richtung haben die Feldfacetten 25 eine Erstreckung von $Y_{FF}$. $X_{FF}/Y_{FF}$ ist das x/y-Aspektverhältnis der Feldfacetten 25.

Bei der Scan-Einrichtung 36 handelt es sich bei der Ausführung nach Fig. 10 um einen das Nutzstrahlungsbündel 16 streifend reflektierenden Scanspiegel, der um eine der y'-Achse zusammenfallende Zeilenscan-Achse 37 und um eine zur x'-Achse parallele Zeilenvorschub-Achse 38 verkippbar ist. Beide Achsen 37, 38 liegen in einer reflektierenden Spiegelfläche 39 der Scan-Einrichtung 36.

In der Fig. 11 ist der Feldfacettenspiegel 19 schematisch als 4 x 4-Array mit vier horizontalen Zeilen zu je vier Feldfacetten 25 dargestellt. Die nachfolgenden Frequenz- und Zeitdaten beziehen sich auf die Beleuchtung des im Zusammenhang mit der Fig. 10 bereits beschriebenen Feldfacettenspiegels 19 mit dem 6 x 75-Array. Die Verkippung um die Zeilenscan-Achse 37 zur Abrasterung einer Feldfacetten-Zeile längs der $x_{FF}$-Richtung erfolgt in der beschriebenen Ausführung mit einer der Zeilenfrequenz von 7,5 kHz. Dabei wird die Spiegelfläche 39 um +/- 4,5° verkippt, was zu einem Ablenkwinkel für das Nutzstrahlungsbündel 16 von +/- 9° führt. Entsprechend ist die Verweildauer des Nutzstrahlungsbündels 16 auf jeweils einer Zeile ($y_{FF}$=const.) des Feldfacettenspiegels 19 133,3 µs. Der Zeilenvorschub in $y_{FF}$-Richtung erfolgt durch synchronisierte Verkippung um die Zeilenvorschub-Achse 38, so dass die 75 Zeilen mit korrektem Zeilenabstand abgerastert werden, wobei die Verkippung um die Zeilenvorschub-Achse 38 auch für eine Rückkehr des Nutzstrahlungsbündels 16 von der letzten abgerasterten Feldfacette 25z hin zur ersten abzurastemden Feldfacette 25a sorgt. Um die Zeilenvorschub-Achse 38 wird die Spiegelfläche 39 daher zusätzlich mit einer Frequenz von 100 Hz verkippt. Die Verweildauer pro einzelner Feldfacette 25 beträgt 22,2 µs. Während der Verweildauer auf einer Feldfacette 25 treffen also 660 EUV-Strahlungsimpulse auf die Feldfacette 25.

Die Ausleuchtung auf den Feldfacettenspiegel 19 kann beim Abscannen des Feldfacettenspiegels 19 kontinuierlich in y-Richtung bewegt werden. Eine derartige Scanbewegung ist mit mechanisch vergleichsweise einfachen und haltbaren Komponenten erreichbar.

Auch eine höhere Zeilenfrequenz als die vorstehend beschriebene Zeilenfrequenz von 7,5 kHz ist möglich, beispielsweise eine Zeilenfrequenz von 10 kHz, von 15 kHz, von 20 kHz oder auch eine noch größere Zeilenfrequenz.

Der Abstand zwischen der Spiegelfläche 39 und dem Feldfacettenspiegel 19 beträgt etwa 1 m.

Anstelle einer Verkippung um die Zeilenscan-Achse 37 kann der Zeilenscan auch mit Hilfe eines Polygonscanners 40, der um die Zeilenscan-Achse 37 rotiert, erzeugt werden. Dies ist schematisch in der Fig. 11 dargestellt, die den Feldfacettenspiegel 19 in einer Aufsicht zeigt. Die $x_{FF}$-Achse verläuft in der Fig. 11 nach rechts und die $y_{FF}$-Achse verläuft in der Figur 11 senkrecht zur Zeichenebene auf den Betrachter zu.

Der Polygonscanner weist zum Zeilenscan einen Polygonspiegel 41 mit insgesamt sechs Polygonfacetten auf, ist also in Umfangsrichtung um seine Rotationsachse 37 als regelmäßiges Sechseck ausgebildet. Bei der Ausführung der Scan-Einrichtung 36 mit dem Polygonspiegel 41 ist diesem ein Kippspiegel vor- oder nachgeordnet, der, wie vorstehend beschrieben, um die Zeilenvorschub-Achse 38 verkippbar ist. Zusätzlich oder alternativ kann durch eine in Figur 11 nicht dargestellte Optik die Beleuchtungsstrahlung der Lichtquelle 2 in y-Richtung aufgeweitet sein. Die angegebenen Strahldurchmesser beziehen sich dann nur auf die x-Ausdehnung.

Das Nutzstrahlungsbündel 16 hat beim Auftreffen auf eine von insgesamt sechs Spiegelflächen 39 des Polygonspiegel 41 einen Durchmesser von etwa 5 mm.

Ein Abstand zwischen der Lichtquelle 2 und dem Polygonspiegel 41 beträgt etwa 1 m.

Beim Auftreffen auf den Feldfacettenspiegel 19, also nach der Reflexion am Polygonspiegel 41, hat das Nutzstrahlungsbündel 16 einen Durchmesser von etwa 10 mm.

Das Bildfeld 11 hat eine Schlitzweite parallel zur Scanrichtung y von 2 mm und eine Schlitzbreite senkrecht zur Scanrichtung, also in x-Richtung, von 26 mm. Bei einer angenommenen Dosis auf dem Wafer 13 von 30 mJ/cm$^2$, die sicherstellt, dass die lichtempfindliche Schicht reagiert, einer Scangeschwindigkeit von 600 mm/s am Retikel 7 und einer Bildfeldbreite von 26 mm muss der Ausgabestrahl 16 auf dem Wafer 13 mit einer Leistung von 5 W ankommen.

Die jeweilige Ausführung der Scan-Einrichtung 36 ist derart, dass sequentiell jeweils zusammenhängende Scanbereiche auf dem Feldfacettenspiegel 19 abgerastert werden, deren Scanbereichsfläche höchstens der Fläche der Feldfacetten 25 entspricht. Dies wird nachfolgend anhand der Fig. 12 ff. näher erläutert. Komponenten bzw. Funktionen, die denjenigen entsprechen, die jeweils unter Bezugnahme auf vorher bereits erläuterte Figuren beschrieben werden, tragen die gleichen Bezugsziffern und werden nicht nochmals im Einzelnen diskutiert.

Fig. 12 zeigt links in einer Aufsicht schematische eine Variante des Feldfacettenspiegels 19 mit gebogenen Feldfacetten 25. Dargestellt sind drei Spalten der Feldfacetten 25 und insgesamt zwanzig Feldfacetten 25. In der Realität ist die Anzahl der Feldfacetten 25 des Feldfacettenspiegels 19 nach Fig. 12 natürlich viel größer, wie vorstehend bereits erläutert.

In der Fig. 12 rechts ist das Beleuchtungsfeld 5 dargestellt, auf das die Feldfacetten 25 des Feldfacettenspiegels 19 einander überlagernd abgebildet werden.

Hervorgehoben ist in dem Beleuchtungsfeld 5 nach Fig. 12 ein Feldpunkt 42. Ebenfalls hervorgehoben sind in der Fig. 12 diejenigen Facettenpunkte 43, die über die Übertragungsoptik 21 genau auf den Feldpunkt 42 abgebildet werden (Urbilder des Feldpunktes 42). Aufgrund der räumlichen Verhältnisse der Abbildung der Facettenpunkte 43 auf den Feldpunkt 42 liegen die Facettenpunkte 43 innerhalb der jeweiligen Kontur der Feldfacetten 25 nicht alle exakt am gleichen relativen Ort, sondern können gegeneinander sowohl in der $x_{FF}$- als auch in der $y_{FF}$-Richtung leicht verschoben sein. Diese Verschiebung, für die beispielhaft eine Verschiebung $\Delta x_{FF}$ für die beiden obersten Feldfacetten 25 der linken Spalte des Feldfacettenspiegels 19 nach Fig. 12 angedeutet ist, ist klein gegenüber den Dimensionen der Feldfacetten 25 in der $x_{FF}$- und in der $y_{FF}$-Richtung. Analog zur Verschiebung $\Delta x_{FF}$ kann auch eine Verschiebung $\Delta y_{FF}$ entlang der $y_{FF}$-Richtung auftreten. Dies ist in der Fig. 12 anhand der Facettenpunkte 43 der beiden obersten Feldfacetten 25 der rechten Spalte dargestellt. Diese Facettenpunkte 43 haben in der $y_{FF}$-Richtung einen Abstand von $Y_{FF}$ plus $\Delta y_{FF}$ zueinander, sind also um $\Delta y_{FF}$ weiter voneinander beabstandet als die Erstreckung $Y_{FF}$ der Feldfacetten 25 in der $y_{FF}$-Richtung. Abhängig von der Wahl des Feldpunktes 42 und des jeweiligen zugehörigen Facettenpunktes 43 einer bestimmten Feldfacette 25 ergibt sich für jede der Feldfacetten 25 ein bestimmter Wert für $\Delta y_{FF}$. Bei Betrachtung aller möglichen Kombinationen aus Feldpunkten 42 und Facettenpunkten 43 der Feldfacetten 25 ergibt sich ein maximaler Wert $\Delta y_{FF,max}$, den $\Delta y_{FF}$ annehmen kann. Diese Größe $\Delta y_{FF,max}$ wird auch als maximale Urbild-Verschiebung eines Feldpunktes 42 auf dem Facettenspiegel 25 bezeichnet.

Fig. 13 zeigt in einer zur Fig. 12 ähnlichen Darstellung wiederum den Feldfacettenspiegel 19 und das Beleuchtungsfeld 5. Für den Feldpunkt 42 ist für eine der Feldfacetten 25, nämlich die drittunterste Feldfacette 25 der mittleren Spalte des Feldfacettenspiegels 19, der Facettenpunkt 43 angegeben, der über die Übertragungsoptik 21 auf den Feldpunkt 42 abgebildet wird.

Für die anderen Feldfacetten 25 ist in der Fig. 13 jeweils ein Facettenbereich 44 angegeben, der in Bezug auf die $x_{FF}$- und $y_{FF}$-Koordinate jeder einzelnen der Feldfacetten 25 genau am gleichen Ort auf der Reflexionsfläche jeder Feldfacette 25 liegt.

Die Facettenbereichsbilder 45 dieser Facettenbereiche 44 sind auf dem Beleuchtungsfeld 5 aufgrund der bereits erwähnten geometrischen Abweichung bei der Abbildung durch die Übertragungsoptik 21 und auch aufgrund der hieraus resultierenden, leicht unterschiedlichen Abbildungsmaßstäbe dieser Abbildung nicht identisch, sondern überlappen einander.

In der Fig. 13 rechts sind auf dem Beleuchtungsfeld 5 die Facettenbereichsbilder 45 der Facettenbereiche 44 dargestellt, die von der Übertragungsoptik 21 auf dem Beleuchtungsfeld 5 erzeugt werden. Der Feldpunkt 42 liegt in allen Facettenbereichsbildern 45. Sofern die Scan-Einrichtung 36 so angesteuert wird, dass die Facettenbereiche 44 zu einem gegebenen Zeitpunkt nicht ausgeleuchtet werden, kann zu diesem Zeitpunkt der Feldpunkt 42 über den Facettenpunkt 43 beleuchtet werden, ohne dass aus einer Beleuchtung dieses Feldpunktes 42 über die anderen Facetten 25 eine störende Interferenz resultiert.

Der Feldpunkt 42 in der Fig. 13 rechts wird dann ausschließlich über eine der Facetten 25, nämlich über die drittunterste Facette 25 der mittleren Spalte des Feldfacettenspiegels 19 in der Fig. 13 links, beleuchtet.

Fig. 14 zeigt ebenfalls eine Aufsicht des Feldfacettenspiegels 19. In der Fig. 14 ist eine Variante einer Ansteuerung der Scan-Einrichtung 36 dargestellt, bei der sequentiell ein zusammenhängender Scanbereich 46 auf dem Feldfacettenspiegel 19 abgerastert wird, dessen Scanbereichsfläche kleiner ist als die Reflexionsfläche einer der Feldfacetten 25. Bei der Ansteuerungsvariante nach Fig. 14 ist der Scanbereich 46 wie die Feldfacetten 25 gebogen. In der $x_{FF}$-Richtung hat der Scanbereich 46 die gleiche Erstreckung wie die Feldfacetten 25. In $y_{FF}$-Richtung ist die Erstreckung des Scanbereiches 46 etwas geringer als die Erstreckung der Feldfacetten 25. Die $y_{FF}$-Erstreckung der Feldfacetten 25 ist in der Fig. 14 zum Vergleich durch zwei gestrichelte Begrenzungslinien 47 angedeutet. Eine Berandungsform des Scanbereichs 46 entspricht der Berandungsform der Feldfacetten 25.

Eine Scanbereichsfläche S des Scanbereichs 46 ist um mindestens das Verhältnis aus der maximalen Urbild-Verschiebung $\Delta y_{FF,max}$ eines Feldpunktes 42, also eines Objektpunktes des Beleuchtungsfeldes 5, auf dem Feldfacettenspiegel 19 einerseits und der hierzu parallelen Facettenausdehnung $Y_{FF}$ andererseits geringer als die Fläche $F = X_{FF} \cdot Y_{FF}$ einer der Feldfacetten 25. Es gilt also:

$$S = F \cdot \left(1 - \left(\Delta y_{FF,max} \,/\, Y_{FF}\right)\right)$$

Bei der Variante nach Fig. 14 wird die Scan-Einrichtung 36 so angesteuert, dass immer der zusammenhängende Scanbereich 46 auf den Feldfacettenspiegel 19 abgerastert wird, wobei dieser zusammenhängende Scanbereich 46 sich dann entsprechend einem zeitlichen Verlauf der Ansteuerung der Scan-Einrichtung 36 spaltenweise in $y_{FF}$-Richtung über den Feldfacettenspiegel 19 verlagert.

Es werden also zwei Scanschritte bei der Ansteuerung der Scan-Einrichtung 36 überlagert. Zum einen wird immer eine Fläche entsprechend dem Scanbereich 46 abgerastert und dieser Scanbereich wird zum anderen spaltenweise über die Feldfacetten 25 des Feldfacettenspiegels 19 gescannt. Nach dem Ende einer der Spalten des Feldfacettenspiegels 19 wird das Scannen bei der benachbarten Spalte fortgesetzt.

Die Größenwahl des Scanbereichs 46 führt dazu, dass kein Feldpunkt des Beleuchtungsfeldes 5 gleichzeitig über zwei verschiedene Feldfacetten 25 beleuchtet wird. Störende Interferenzen des Beleuchtungslichts auf den Beleuchtungsfeldpunkten sind somit ausgeschlossen.

Während der Scanbereich 46 über den Facettenspiegel 19 wandert, werden, wie in der Momentaufnahme nach Fig. 14 gezeigt, mitunter zwei benachbarte Feldfacetten 25 gleichzeitig mit dem Beleuchtungslicht 16 beaufschlagt. Da gleichzeitig ausschließlich Teilbereiche dieser beiden benachbarten Feldfacetten 25 beaufschlagt werden, die unterschiedliche Bereiche des Beleuchtungsfeldes 5 mit dem Beleuchtungslicht 16 beaufschlagen, liegt dennoch keine Beleuchtungslicht-Interferenz im Beleuchtungsfeld 5 vor.

Fig. 15 zeigt eine weitere Variante einer Ansteuerung der Scan-Einrichtung 36 zur sequentiellen Beleuchtung des gesamten Feldfacettenspiegels 19. Komponenten und Funktion, die denjenigen entsprechen, die vorstehend unter Bezugnahme auf die anderen Figuren bereits erläutert wurden, tragen die gleichen Bezugsziffern und werden nicht nochmals im Einzelnen diskutiert.

Bei der Ausführung nach Fig. 15 ist der Scanbereich 46 rechteckig. Eine Fläche des Scanbereichs 46 ist kleiner als die Fläche einer der Feldfacetten 25. Die $y_{FF}$-Erstreckung des Scanbereichs 46 nach Fig. 15 ist wiederum etwas kleiner als die $y_{FF}$-Erstreckung der Feldfacetten 25, wie im Zusammenhang mit der Fig. 14 bereits erläutert. Bei der Ausführung nach Fig. 15 entspricht die Berandungsform des Scanbereichs 46 also nicht der Berandungsform der Feldfacetten 25.

Der Scanbereich 46 ist nicht notwendigerweise in eine der Feldfacetten 25 einschreibbar.

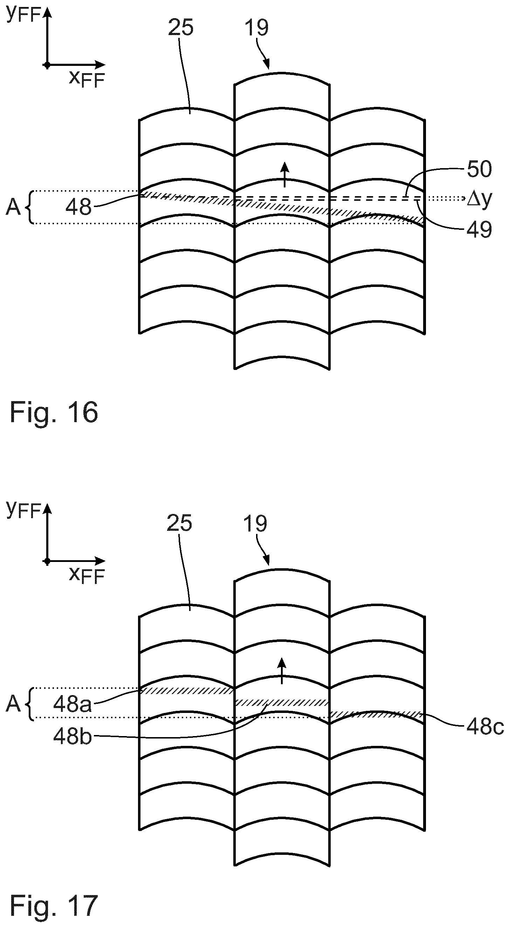

Anhand der Fig. 16 und 17 werden zwei weitere Beispiele einer Scanbereichs-Gestaltung erläutert, über die jeweils ein Feldpunkt im Beleuchtungsfeld 5 ausschließlich über jeweils höchstens eine der Facetten 25 des Feldfacettenspiegels 19 beleuchtet wird. Komponenten und Funktion, die denjenigen entsprechen, die vorstehend in Bezugnahme auf die anderen Figuren bereits erläutert wurden, tragen die gleichen Bezugsziffern und werden nicht nochmals im Einzelnen diskutiert.

Bei den Ausführungen nach den Fig. 16 und 17 ist die Scan-Einrichtung 36 zur Ausleuchtung des Feldfacettenspiegels 19 so ausgelegt, dass ein Scanbereich 48 sich über mehrere der Facetten 25 erstreckt.

Bei der Variante nach Fig. 16 ist der Scanbereich 48 zusammenhängend in Form eines sich über drei Facetten-Spalten erstreckenden Scanbereich-Streifens ausgebildet. Dieser Scanbereichs-Streifen verläuft bei der Ausführung nach Fig. 16 schräg über alle drei Facetten-Spalten. Die Steigung dieses Schrägverlaufs muss so groß sein, dass ein $y_{FF}$-Versatz zwischen benachbarten, beleuchteten Facetten-Spalten größer ist als eine $y_{FF}$-Erstreckung des Scanbereichs 48. Der Versatz ist in der Fig. 16 durch eine gestrichelte Linie 49 und die $y_{FF}$-Erstreckung des Scanbereichs 48 ist in der Fig. 16 durch eine weitere gestrichelte Linie 50 angedeutet. Eine Differenz $\Delta y$ in der $y_{FF}$-Richtung zwischen dem Versatz 49 und der $y_{FF}$-Erstreckung 50 des Scanbereichs 48 ist größer als die maximale Urbild-Verschiebung $\Delta y_{FF,max}$, die vorstehend im Zusammenhang mit der Fig. 12 bereits erläutert wurde. Gleichzeitig muss der Verlauf des Scanbereichs 48 nach Fig. 16 so sein, dass eine gesamte $y_{FF}$-Erstreckung A des Scanbereichs 48 höchstens so groß ist wie die $y_{FF}$-Erstreckung $Y_{FF}$ der einzelnen Feldfacetten 25. Die Differenz zwischen den $y_{FF}$-Erstreckungen A und $Y_{FF}$ ist dabei wiederum mindestens so groß wie die maximale Urbild-Verschiebung $\Delta y_{FF,max}$. Durch Einhalten dieser Randbedingungen ist gewährleistet, dass auch bei einer Ansteuerung, die zu einem Scanbereich 48 nach Fig. 16 führt, jeweils ein Feldpunkt im Beleuchtungsfeld 5 ausschließlich über jeweils höchstens eine der Feldfacetten 25 beleuchtet wird.

Bei der Beleuchtung des Feldfacettenspiegels 19 wird der Scanbereich 48 in $y_{FF}$-Richtung über den Feldfacettenspiegel 19 gescannt, sodass jede der Feldfacetten 25 innerhalb einer Scanperiode ausgeleuchtet wird.

Bei der Ansteuerungsvariante nach Fig. 17 werden mehrere Scanbereiche 48a, 48b, 48c, deren $x_{FF}$-Erstreckung jeweils einer Feldfacetten-Spaltenbreite entspricht, in y-Richtung über die verschiedenen Spalten des Feldfacettenspiegels 19 gescannt. In der $y_{FF}$-Richtung weisen die Scanbereiche 48a, 48b und 48c jeweils zueinander einen $y_{FF}$-Versatz auf, der größer ist als 0. Ein y-Versatz zwischen den Scanbereichen 48a, 48b und 48c kann größer sein als eine y-Erstreckung des jeweiligen Scanbereichs 48a bis 48c zuzüglich der maximalen Urbild-Verschiebung $\Delta y_{FF,max}$. Eine Gesamterstreckung A des aus den Teilbereichen 48a bis 48c gebildeten Scanbereichs 48 nach Fig. 17 beträgt wiederum höchstens die $y_{FF}$-Erstreckung der einzelnen Feldfacetten 25. Der Unterschied zwischen der Gesamterstreckung A und der $y_{FF}$-Erstreckung der einzelnen Feldfacetten 25 kann dabei wiederum in der Größenordnung der maximalen Urbild-Verschiebung $\Delta y_{FF,max}$ liegen.

Ein Versatz des Scanbereichs 48 zwischen zwei spaltenweise benachbarten Feldfacetten 25 beträgt mindestens die Summe aus der $y_{FF}$-Ausdehnung des Scanbereichs 48 und der maximalen Urbild-Verschiebung $\Delta y_{FF,max}$, die vorstehend im Zusammenhang mit der Fig. 12 bereits erläutert wurde.

Ist die Fläche des Scanbereichs 46 bzw. 48 klein, so ist auch die Fläche des gleichzeitig ausgeleuchteten Bereichs des Beleuchtungsfeldes 5 klein. Die Gesamtdauer, während der ein Punkt des Wafers 13 mit Nutzlicht 16 beaufschlagt wird, hängt neben der Größe des Bildfeldes 11 und der durch den Waferverlagerungsantrieb 15 gesteuerten Scangeschwindigkeit des Wafers auch vom Verhältnis der Gesamtgröße des Beleuchtungsfeldes 5 zur Größe des gleichzeitig ausgeleuchteten Bereichs des Beleuchtungsfeldes ab. Je länger diese Gesamtdauer ist, desto kleiner ist der Effekt, der räumlich und zeitlich lokalisierte Störungen haben können.

Die Fläche des Scanbereichs 46 bzw. 48 kann möglichst groß sein, ohne dabei aber die bisher beschriebenen Bedingungen an die Ausgestaltung des Scanbereichs zu verletzen. Der Scanbereich 46 bzw. 48 kann so gewählt werden, dass seine Fläche größer als 20 % einer Reflexionsfläche einer der Feldfacetten. Die Fläche des Scanbereichs 46 bzw. 48 kann größer sein als ein Drittel der Fläche einer der Feldfacetten 25, kann größer sein als die Hälfte der Fläche einer der Feldfacetten 25, größer sein als 75% der Fläche einer der Feldfacetten 25 oder kann größer sein als 90% der Fläche einer der Feldfacetten 25.

In einer nicht zeichnerisch dargestellten Ausführung einer Projektionsbelichtungsanlage betragen alle Laufzeitdifferenzen entlang von Paaren von Ausleuchtungskanälen $27_i$, die zu Feldfacetten 25 innerhalb der derselben Zeile des Feldfacettenspiegels 19 gehören, mehr als die Kohärenzzeit des Beleuchtungslichts 16. Die Laufzeitdifferenzen entlang von Paaren von Ausleuchtungskanälen $27_i$, die zu Feldfacetten 25 innerhalb verschiedener Zeilen des Feldfacettenspiegels 19 gehören, sind unter Umständen jedoch kleiner als die Kohärenzzeit des Beleuchtungslichts 16. Der Scanbereich 46 besitzt eine y-Ausstreckung, wie er im Zusammenhang mit den Figuren 14 und 15 beschrieben worden ist. Die x-Ausstreckung umfaßt den gesamten Feldfacettenspiegel, so daß die Fläche des Scanbereichs 46 jetzt größer als die Fläche einer Feldfacette 25 ist.

Nachfolgend wird eine weitere Ausführung einer Projektionsbelichtungsanlage für die Mikrolithographie erläutert. Komponenten und Funktionen, die vorstehend bereits erläutert wurden, tragen die gleichen Bezugsziffern und werden nachfolgend nur dort erläutert, wo dies zum Verständnis abweichender Komponenten bzw. Funktionen erforderlich ist.

Die Projektionsbelichtungsanlage 1 für die Mikrolithographie in der weiteren Ausführung nach Fig. 18 dient ebenfalls zur Herstellung eines mikro- bzw. nanostrukturierten elektronischen Halbleiter-Bauelements.

Das Nutzstrahlungsbündel 16 wird innerhalb des Öffnungswinkels 35, der an die Beleuchtungsoptik 4 der Projektionsbelichtungsanlage 1 angepasst ist, mit Hilfe einer noch zu beschreibenden Strahlformungs-Einrichtung 51 ausgeleuchtet. Die Strahlformungs-Einrichtung 51 ist als elliptischer Spiegel ausgebildet. Das Nutzstrahlungsbündel 16 hat, ausgehend von der Lichtquelle 2, eine Divergenz, die kleiner ist als 1 mrad. Die Strahlformungs-Einrichtung 51 ist in der Zwischenfokusebene 18 der Beleuchtungsoptik 4 angeordnet. Nach der Strahlformungs-Einrichtung 51 trifft das Nutzstrahlungsbündel 16 zunächst auf den Feldfacettenspiegel 19.

Das Nutzstrahlungsbündel 16 hat bei der Ausführung nach Fig. 18 insbesondere eine Divergenz, die kleiner ist als 500 μrad und bevorzugt kleiner ist als 150 μrad. Der Durchmesser des Nutzstrahlungsbündels 16 auf der Strahlformungs-Einrichtung 51 beträgt etwa 5 mm. Beim Austritt aus der Lichtquelle 2 hat das Nutzstrahlungsbündel 16 einen fast verschwindenden Durchmesser, der kleiner ist als 1 mm und auch kleiner sein kann als 500 μm oder kleiner sein kann als 250 μm.

Der Feldfacettenspiegel 19 weist ein nicht näher dargestelltes Feldfacetten-Array auf. Dargestellt ist in der Fig. 18 beispielhaft nur ein Teil der tatsächlich vorhandenen Feldfacetten 25. Die Feldfacetten 25 sind auf einer Haupt-Spiegelfläche des Feldfacettenspiegels 19 angeordnet.

Die Pupillenfacetten 28 sind auf einer Haupt-Spiegelfläche des Pupillenfacettenspiegels 20 angeordnet.

Der Pupillenfacettenspiegel 20 ist im Bereich einer Lage einer Eintrittspupille der Projektionsoptik 10 angeordnet. Die Ausleuchtungskanäle für die einzelnen Beleuchtungslicht-Teilbündel führen von den Feldfacetten 25 bis zum Beleuchtungsfeld 5.

Aus den einzelnen Beleuchtungswinkeln, die über jedes Facettenpaar 25, 28 vorgegeben werden, ergibt sich über die Integration aller Ausleuchtungskanäle, die über eine Beleuchtung der Facetten 25 des Feldfacettenspiegels 19 mit Hilfe der Strahlformungs-Einrichtung 51 herbeigeführt wird, eine Beleuchtungswinkelverteilung der Beleuchtung des Objektfeldes 5, die über die Beleuchtungsoptik 4 herbeigeführt wird.

Die Eintrittspupille der Projektionsoptik 10 befindet sich, ggf. nach Abbildung durch einige oder alle der Spiegel 22, 23 und 24, in der Nähe des Pupillenfacettenspiegels 20.

Soweit Einzelkomponenten der Projektionsbelichtungsanlage 1 beschrieben werden, kommt ein lokales xy-Koordinatensystem zum Einsatz, welches die Haupt-Reflexionsfläche bzw. Haupt-Spiegelfläche dieser Komponente aufspannt. Die x-Richtungen des globalen Koordinatensystems und der lokalen Koordinatensysteme fallen in der Regel zusammen bzw. sind zueinander parallel.

Bei der Strahlformungs-Einrichtung 51 handelt es sich um einen elliptisch geformten Spiegel, der streifend vom Nutzstrahlungsbündel 16 getroffen wird. Der Abstand zwischen der Lichtquelle 2 und der Strahlformungs-Einrichtung 51 beträgt beispielsweise 25 m, 50 m oder auch 100 m. Der Abstand kann insbesondere von der Divergenz der Lichtquelle 2 abhängen. Hierdurch ergibt sich auf der Strahlformungs-Einheit 51 ein Spot mit einer Größe von beispielsweise 5 mm.

Der elliptisch geformte Spiegel der Strahlformungs-Einheit 51 führt zu einer Abbildung einer Strahlführungs-Objektebene, die in der Zeichnung nicht näher dargestellt ist, in eine Strahlführungs-Bildebene. Die Strahlführungs-Bildebene stimmt im Wesentlichen mit dem Feldfacettenspiegel 19 überein. Aufgrund der kleinen Divergenz des Nutzstrahlenbündels 16 der Lichtquelle 2 ist die genaue Lage der Strahlführungs-Objektebene nicht relevant, und in der Strahlführungs-Objektebene formt das Nutzlicht 16 einen Spot mit einer Größe, die nur unwesentlich von der Spotgröße auf der Strahlformungs-Einheit 51 abweicht. Der elliptisch geformte Spiegel der Strahlformungs-Einheit 51 führt zu einer optischen Abbildung mit dem Abbildungsmaßstab $|\beta| = 60$, sodass das Nutzstrahlenbündel 16 den gesamten Feldfacettenspiegel 19 ausleuchtet.

Der Abstand zwischen der Strahlformungs-Einheit 51 und dem Feldfacettenspiegel 19 beträgt etwa 2 m.

Fig. 19 zeigt schematisch Hauptkomponenten der Projektionsbelichtungsanlage 1. Die Lichtquelle 2 wird mit dem Kollektor 17, der in der Fig. 18 nicht dargestellt ist, zunächst in die Zwischenfokusebene 18 abgebildet. Im Falle einer Lichtquelle 2 mit kleinem Lichtleitwert, insbesondere im Falle einer elektronenstrahlbasierten Lichtquelle 2 wie z. B. einem FEL-Laser kann auf den Kollektor 17 auch verzichtet werden. Der Pupillenfacettenspiegel 20 mit den Pupillenfacetten 28 ist so angeordnet, dass am Ort der Pupillenfacetten 28 Bilder der Lichtquelle 2 zu liegen kommen. Im Bereich jeder beleuchteten Pupillenfacetten 28 liegt also ein Bild der Lichtquelle 2. Der Pupillenfacettenspiegel 20 bildet, ggf. zusammen mit weiteren Komponenten der Übertragungsoptik 21 (vgl. Fig. 18), die Feldfacetten 25 des Feldfacettenspiegels 19 einander überlagernd in das Beleuchtungsfeld bzw. Objektfeld 5 ab. Die optische Weglänge aller Strahlen des Beleuchtungslichtes 16, die eine bestimmte Pupillenfacette 28 treffen, ist am Ort dieser Pupillenfacette 28 konstant, d.h., die optische Weglänge hängt nicht davon ab, welches der Strahlen des Beleuchtungslichts 16, die diese Pupillenfacette 28 erreichen, betrachtet wird.

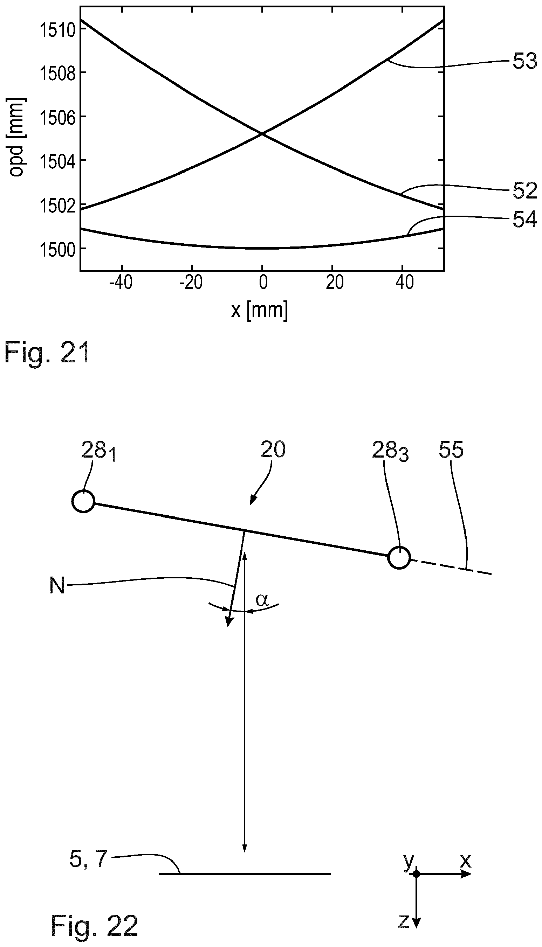

Anhand der Fig. 20 und 21 wird nachfolgend ein Feldverlauf einer optischen Weglänge opd (optical path distance) zwischen Pupillenfacetten 28 des Pupillenfacettenspiegels 20 und dem Retikel 7 diskutiert. Herausgegriffen werden hierzu beispielhaft drei Pupillenfacetten $28_1$, $28_2$ und $28_3$ des Pupillenfacettenspiegels 20, die alle drei in der gleichen xz-Ebene liegen. Benachbarte dieser drei Pupillenfacetten $28_1$ bis $28_3$ haben einen Abstand von 125 mm zueinander. Der Pupillenfacettenspiegel 20 hat in z-Richtung zum Retikel 7 einen Abstand von 1.500 mm. Ein in der Fig. 20 betrachteter Abschnitt des Retikels 7 hat in der x-Richtung eine Erstreckung von 104 mm. Die mittlere der drei betrachteten Pupillenfacetten, also die Pupillenfacette $28_2$, liegt in der x-Richtung auf Höhe der Mitte des Retikels 7 (x = 0).

Das Diagramm nach Fig. 21 verdeutlicht eine Abhängigkeit einer optischen Weglänge zwischen den Pupillenfacetten $28_1$ bis $28_3$ von der x-Koordinate des Retikels 7. Vom linken Rand des Retikels 7 (x = - 52 mm) hat die in der Fig. 20 ganz rechts dargestellte Pupillenfacette $28_3$ den größten Abstand, der sich zum rechten Rand des Retikels 7 (x = + 52 mm) kontinuierlich verringert. Dies ist anschaulich über eine Weglängenkurve 52 in der Fig. 21 dargestellt. Eine entsprechend gespiegelte Weglängenkurve 53 ergibt sich für die in der Fig. 20 links dargestellte Pupillenfacette $28_1$. Für die mittig über dem Retikels 7 angeordnete dritte Pupillenfacette $28_2$ ergibt sich die Weglängenkurve 54 mit geringstem Abstand zur Mitte des Retikels 7 (x = 0), der zu den beiden Rändern des Retikels 7 (x = +/- 52 mm) kontinuierlich ansteigt.

Zur Mitte des Retikels 7 (x = 0) haben die beiden äußeren Pupillenfacetten $28_1$ und $28_3$ exakt den gleichen Abstand. Dort schneiden sich die beiden Weglängenkurven 52 und 53. Soweit ausgehend von der Lichtquelle 2 die Ausleuchtungskanäle für die jeweiligen Beleuchtungslicht-Teilbündel, die zu den Pupillenfacetten $28_1$ und $28_3$ geführt haben, ausgehend von der Lichtquelle 2 bis zu den Pupillenfacetten $28_1$ und $28_3$ gleich lang waren, folgt aus der nachfolgenden Weglängengleichheit für x = 0 eine störende Interferenz, was durch eine entsprechende Anordnung des Pupillenfacettenspiegels 20, wie nachfolgend erläutert wird, vermieden wird.

Fig. 22 zeigt in einer zu Fig. 20 ähnlichen Darstellung den Pupillenfacettenspiegel 20, der nun so verkippt angeordnet ist, dass dessen Normale N auf eine Haupt-Spiegelfläche 55 des Pupillenfacettenspiegels 20 gegenüber der yz-Ebene, also gegenüber einer Einfallsebene der Beleuchtungslicht-Teilbündel auf einer Haupt-Spiegelfläche 56 des Feldfacettenspiegels 19, um einen Kippwinkel $\alpha$ = 10° verkippt ist. Diese Verkippung führt dazu, dass diejenigen Teilbündel, die bis zum Pupillenfacettenspiegel 20 in der yz-Ebene verlaufen, anschließend entsprechend diesem Kippwinkel aus der yz-Ebene abgelenkt werden.

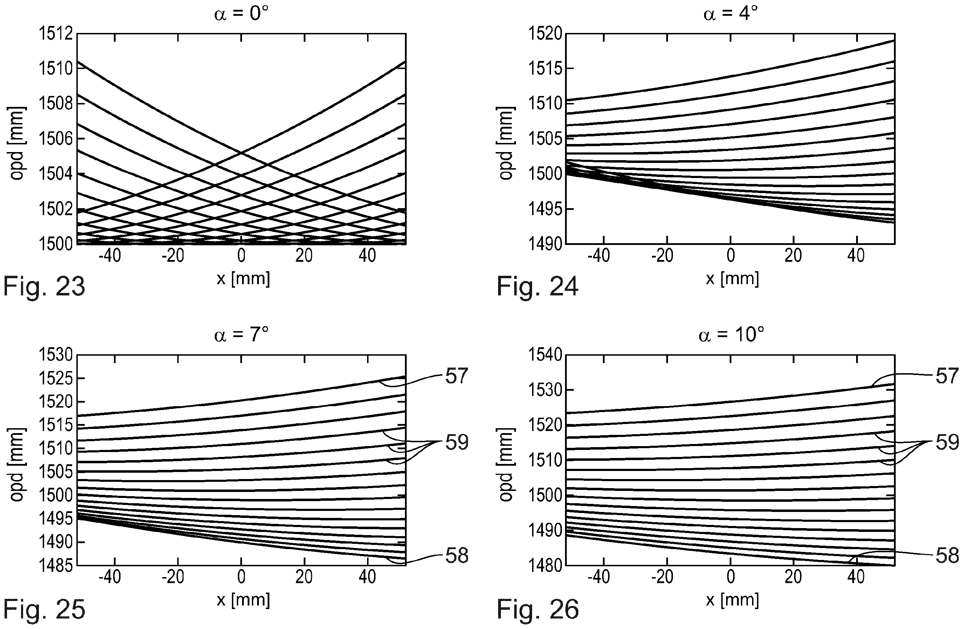

Fig. 26 zeigt für die Pupillenfacetten $28_1$ und $28_3$ sowie für vierzehn äquidistant zwischen diesen beiden Pupillenfacetten $28_1$, $28_3$ angeordnete weitere Pupillenfacette 28 den Feldverlauf der Weglängen in Bezug auf das Retikel 7 in einer der Fig. 21 entsprechenden Darstellung für diesen Kippwinkel 10° des Pupillenfacettenspiegels 20. Die Pupillenfacette $28_1$ hat zum Retikel 7 immer den größten Abstand, was über die in der Fig. 26 oberste Weglängenkurve 57 dargestellt ist. Die Pupillenfacette $28_3$ hat über die gesamte x-Dimension des Retikels 7 zu diesem immer den kleinsten Abstand, was über die in der Fig. 26 unterste Weglängenkurve 58 dargestellt ist. Die vierzehn zwischenliegenden Pupillenfacetten 28 haben Feldverläufe, die über zwischen den Weglängenkurven 57, 58 liegende Weglängenkurven 59 dargestellt sind. Beim Kippwinkel $\alpha$ = 10° schneiden sich diese Weglängenkurven 57 bis 59 über die gesamte x-Dimension des Retikels 7 nicht. Es kommt daher nicht zu der eine unerwünschte Interferenz ermöglichenden Situation, die vorstehend im Zusammenhang mit der Fig. 21 erläutert wurde. Die Verkippung des Pupillenfacettenspiegels 20 entsprechend Fig. 22 führt also dazu, dass die verschiedenen Ausleuchtungskanäle, über die jeder der Feldpunkte des Beleuchtungsfeldes 5 mit den Teilbündeln des Beleuchtungslichts 16 beaufschlagbar ist, zwischen der Lichtquelle 2 und jeweils einem der Feldpunkte, also bei zur Projektionsbelichtung angeordnetem Retikel jeweils einem der Punkte auf dem Retikel 7, jeweils unterschiedliche Kanallängen aufweisen.

Fig. 23 bis 25 zeigen entsprechend Fig. 26 die Weglängenabhängigkeiten für die sechzehn vorstehend im Zusammenhang mit den Fig. 22 und 26 diskutierten Pupillenfacetten von der x-Dimension des Retikels 7. Bei einem Kippwinkel $\alpha$ = 7° schneiden sich die Weglängenkurven 57 bis 59 ebenfalls nicht, sodass auch hier eine eine störende Interferenz vermeidende Anordnung des Pupillenfacettenspiegels 20 vorliegt. Beim Kippwinkel $\alpha$ von 4° schneiden sich die Weglängenkurven 58 und 59 für diejenigen Pupillenfacetten 28 im Bereich der in den Fig. 20 und 22 rechts außen dargestellten Pupillenfacette $28_3$. Fig. 23 zeigt die Situation bei unverkipptem Pupillenfacettenspiegel 20 ($\alpha$ = 0°), die der Situation nach den Fig. 20 und 21 entspricht.

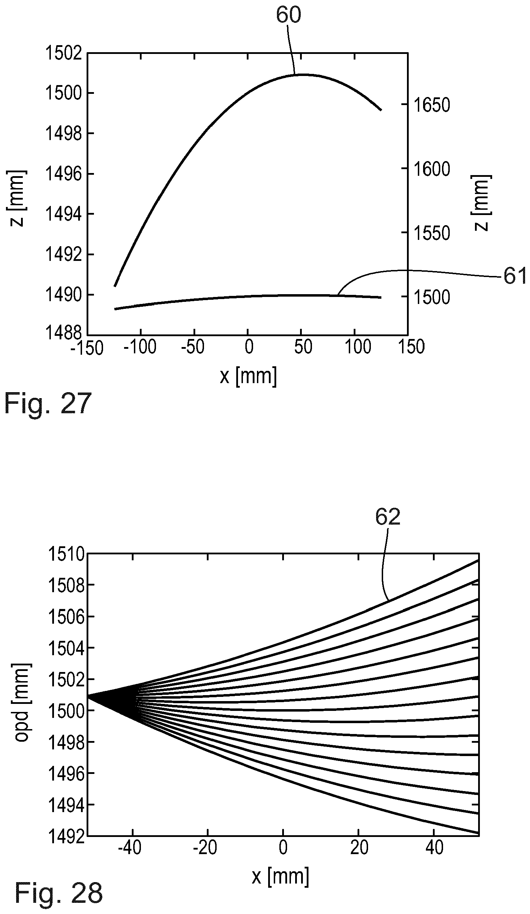

Eine weitere, alternativ oder zusätzlich einsetzbare Maßnahme, den Pupillenfacettenspiegel 20 so anzuordnen, dass es nicht zu einer unerwünscht identischen optischen Weglänge opd der Ausleuchtungskanäle für die Beleuchtungslicht-Teilbündel kommt, ist das Vorsehen einer definierten Krümmung der Haupt-Spiegelfläche 55 des Pupillenfacettenspiegels 20. Diese Maßnahme wird nachfolgend anhand der Fig. 19, 27 und 28 erläutert. Bei dieser Variante liegt eine gekrümmte Haupt-Spiegelfläche 55' vor, die in der Fig. 19 strichpunktiert angedeutet ist. Fig. 27 zeigt in einem vergrößerten Maßstab einen Krümmungsverlauf 60 der Haupt-Spiegelfläche 55' des Pupillenfacettenspiegels 20 in der xz-Ebene (y = const.). Hier gilt die linke Skalierung im Diagramm nach Fig. 27. Gleichzeitig zeigt das Diagramm nach Fig. 27 einen Krümmungsverlauf 61 der gekrümmten Haupt-Spiegelfläche 55' in einem für die horizontale (x) und vertikale (z) Achse identischen Maßstab. Hier gilt die rechte Skalierung des Diagrammes nach Fig. 27.

Der Krümmungsverlauf der Haupt-Spiegelfläche 55' ist parabolisch.

Fig. 28 zeigt die bei diesem gekrümmten Verlauf der Haupt-Spiegelfläche 55' resultierende Abhängigkeit der optischen Weglänge opd für fünfzehn äquidistant zwischen den Positionen der Pupillenfacetten $28_1$ und $28_3$ der Anordnung nach Fig. 20 aufgereihte Pupillenfacetten 28, also den Feldverlauf (Verlaufskurven 62) der optischen Weglängen dieser fünfzehn Pupillenfacetten 28.

Die Krümmung der Haupt-Spiegelfläche 55' ist so, dass die fünfzehn Pupillenfacetten 28 zum linken Rand des Retikels 7 (x = - 52 mm) praktisch den gleichen Abstand aufweisen. Ein kleiner Abstandsunterschied, der zu klein ist, um ihn in der Figur erkennen zu können, ist auch hier vorhanden und verhindert, dass es am linken Rand des Retikels 7 zu einer störenden Gleichheit der optischen Weglängen kommt. Zwischen x = - 52 und x = + 52 mm, also über den gesamten genutzten Bereich des Retikels 7, schneiden sich die Verlaufskurven 62 nicht. Es ergibt sich also auch hier wieder die Situation, bei der eine störende Gleichheit der optischen Weglängen von den verschiedenen Pupillenfacetten 28 zu bestimmten Punkten auf dem Retikel 7 vermieden ist.

Die Haupt-Spiegelfläche 55' des Pupillenfacettenspiegels 20 weicht also so von einer ebenen Fläche (Referenzfläche 55) ab, dass die verschiedenen Ausleuchtungskanäle, über die jeder der Feldpunkte des Beleuchtungsfeldes 5 mit den Teilbündeln des Beleuchtungslichts 16 beaufschlagbar ist, zwischen der Lichtquelle 2 und jeweils einem der Feldpunkte des Beleuchtungsfeldes 5 jeweils unterschiedliche Kanallängen aufweisen.

Eine weitere Ausführung zur Vermeidung störender Interferenzen zwischen Beleuchtungslicht-Teilbündeln, die über verschiedene Ausleuchtungskanäle hin zum Beleuchtungsfeld 11 geführt werden, wird nachfolgend anhand der Fig. 29 bis 31 erläutert. Diese zeigen stark vergrößert jeweils eine der Feldfacetten 25, diesmal in einer bogenförmigen bzw. teilringförmigen Ausgestaltung. Für die horizontale Achse ist ein anderer Zeichenmaßstab als für die vertikale Achse verwendet. Die y-Ausdehnung der Feldfacette 25 beträgt ein Zehntel ihrer x-Ausdehnung.

Die Feldfacette 25 nach Fig. 29 ist optimiert für einen Betrieb der Projektionsbelichtungsanlage 1 mit einem Beleuchtungssetting, also einer Verteilung der Beleuchtungswinkel, mit der Objektfeldpunkte beleuchtet werden, in der Ausführung "y-Dipol". Bei diesem Beleuchtungssetting "y-Dipol" wird das Beleuchtungs- bzw. Objektfeld 5 aus Richtung zweier in y-Richtung voneinander beabstandeter Beleuchtungslicht-Pole beleuchtet. In einer Pupillenebene der Beleuchtungsoptik 4 bzw. 26 liegt bei diesem Beleuchtungssetting eine Intensitätsverteilung in Form zweier in der y-Richtung voneinander beabstandeter Intensitätspole vor. Beispiele für derartige sowie für weitere Beleuchtungssettings sind diskutiert in der DE 10 2008 021 833 B4.

Die Feldfacette 25 nach Fig. 29 trägt Blockungs-Bereiche 63 auf ihrer Reflexionsfläche 64. Die Blockungs-Bereiche 63 sind linienhaft ausgeführt. Die Blockungs-Bereiche 63 blocken auf die Reflexionsfläche 64 der Feldfacette 25 auftreffendes Beleuchtungslicht 16, sodass dieses nicht zur Beleuchtung des Beleuchtungsfeldes 5 beiträgt.

Die Blockungs-Bereiche 63 haben senkrecht zu ihrer Längserstreckung eine sehr geringe Ausdehnung im Bereich von beispielsweise 100 $\mu$m oder noch weniger. Die Blockungs-Bereiche 63 sind auf der Feldfacette 25 dort aufgebracht, wo über diese Feldfacette 25 für einen bestimmten Objektfeldpunkt Beleuchtungslicht, das über den Ausleuchtungskanal, zu dem diese Feldfacette 25 gehört, geführt wird, mit Beleuchtungslicht eines weiteren Ausleuchtungskanals, zu dem eine andere Feldfacette 25 gehört, störend interferieren würde. Senkrecht zur jeweiligen Längsstreckung der Blockungs-Bereiche 63 haben diese eine Ausdehnung, die beispielsweise maximal 1 mm beträgt und regelmäßig deutlich kleiner ist, z.B. 800 $\mu$m, 700 $\mu$m, 600 $\mu$m, 500 $\mu$m, 400 $\mu$m oder noch kleiner sein kann. Auch eine Ausdehnung der Blockungs-Bereiche 63 senkrecht zu deren Erstreckungsrichtung, die größer ist als 1 mm, ist möglich. Alle Blockungs-Bereiche 63 einer Feldfacette 25 zusammengenommen blocken also weniger als 10% der gesamten Reflexionsfläche 64 dieser Feldfacette 25.

Die Blockungs-Bereiche 63 blocken einen entsprechenden Anteil des Querschnitts des auf die Feldfacette 25 auftreffenden Beleuchtungslicht-Teilbündels $16_i$.

Die Blockungs-Bereiche 63 wirken also derart, dass bei Ausleuchtungskanal-Paaren, für die gilt, dass im Betrieb der Beleuchtungsoptik 4 bzw. 26 zu irgendeinem Zeitpunkt an irgendeinem einem jeweils betrachteten Punkt des Beleuchtungsfeldes 5 das entsprechende Paar von Beleuchtungslicht-Teilbündeln 16, die über die Ausleuchtungskanäle des Ausleuchtungskanal-Paars geführt werden, einen Laufzeitunterschied von der Quelle ab gerechnet kleiner als die Kohärenzdauer $\tau_K$ des Beleuchtungslichts 16 besitzt, aufgrund der Blockungs-Bereiche 63 ein Querschnittsbereich mindestens eines der Ausleuchtungskanäle dieser Ausleuchtungskanal-Paare nicht zur Beleuchtung des Beleuchtungsfeldes 5 beiträgt. Störende Interferenzanteile werden also durch die Blockungs-Bereiche 63 unterdrückt.

Bei entsprechend mit derartigen Blockungs-Bereichen 63 ausgerüsteten Feldfacetten 25 des gesamten Feldfacettenspiegels 19 ergibt sich für jede der Feldfacetten 25 abhängig von deren Anordnung auf dem Feldfacettenspiegel 19 abhängig von der Geometrie der Beleuchtungsoptik 4 sowie abhängig vom Beleuchtungssetting jeweils ein individuelles Muster an Blockungs-Bereichen 63 auf der Reflexionsfläche 64. Dieses individuelle Muster kann beispielsweise über ein Ray-Tracing-Programm berechnet werden. Abhängig vom Ergebnis dieser Rechnung kann das Muster dann, beispielsweise durch entsprechende Beschichtung, auf den Reflexionsflächen 64 der Feldfacetten 25 aufgebracht werden.

Ein integraler Lichtverlust aufgrund der Blockungs-Bereiche 63, also ein Durchsatzverlust für das Beleuchtungslicht 16, ist kleiner als 10% und kann im Bereich von 2% liegen.

Grundsätzlich kann der Feldfacetten-Spiegel 25 auch aus einer Vielzahl einzelner Mikrospiegel 65 aufgebaut sein. Eine entsprechende zeilen- und spaltenweise Array-Struktur derartiger Mikrospiegel 65 ist in der Fig. 29 abschnittsweise angedeutet. Bei einer solchen alternativen Mikrospiegel-Gestaltung können anstelle der Blockungs-Bereiche 63 Bereiche von Mikrospiegeln 65 vorliegen, die so verkippt sind, dass dort auftreffendes Beleuchtungslicht 16 nicht zur Beleuchtung des Objektfeldes 5 beiträgt.

Die Mikrospiegel 65 sind Bestandteil einer MEMS-Array-Anordnung. Eine entsprechende MEMS-Array-Anordnung ist dem Fachmann beispielsweise aus der WO 2009/100 856 A1 bekannt. Die Mikrospiegel 65 sind unabhängig voreinander um mindestens zwei Kipp-Freiheitsgrade verkippbar, sodass über die Kippstellung der Mikrospiegel 65 eine reflektierende Führung des auf eine derartige Mikrospiegel-Feldfacette 25 auftreffenden Beleuchtungslicht-Teilbündels 16 vorgegeben werden kann.

Fig. 30 zeigt eine weitere Feldfacette 25 in einer zu Fig. 29 ähnlichen Darstellung. Die Feldfacette 25 nach Fig. 30 trägt ebenfalls Blockungs-Bereiche 63. Die Anordnung der Blockungs-Bereiche 63 ist bei der Feldfacette 25 nach Fig. 30 optimiert für ein Beleuchtungssetting "x-Dipol". Diese Anordnung der Blockungs-Bereiche 63 unterscheidet sich qualitativ und quantitativ von derjenigen nach Fig. 29.

Fig. 31 zeigt eine weitere Ausführung einer Feldfacette 25, wiederum in einer Darstellung, die derjenigen nach den Fig. 29 und 30 entspricht.

Bei der Feldfacette 25 nach Fig. 31 sind Blockungs-Bereiche 63 für eine Mehrzahl verschiedener Beleuchtungssettings aufgetragen, die bei einer Projektionsbelichtungsanlage 1 zum Einsatz kommen können. Hierunter sind die Beleuchtungssettings "y-Dipol" und "x-Dipol", sodass alle Blockungs-Bereiche 63 der Fig. 29 und 30 auch bei der Feldfacette 25 nach Fig. 31 vorliegen.

Bei einer Mikrospiegel-Ausführung der Feldfacette 25 lassen sich die verschiedenen Blockungs-Bereich-Konfigurationen nach den Fig. 29 bis 31 durch entsprechende Kipp-Ansteuerung der Mikrospiegel 65 einstellen.

Anhand der Fig. 32 bis 34 wird eine weitere Ausführung einer Beleuchtungsoptik 4 zur Vermeidung störender Interferenzen der Beleuchtungslicht-Teilbündel $16_i$ im Objektfeld 5 beschrieben. Komponenten und Funktionen, die denjenigen entsprechen, die vorstehend unter Bezugnahme auf die Fig. 1 bis 31 bereits erläutert wurden, tragen die gleichen Bezugsziffern und werden nicht nochmals im Einzelnen diskutiert.

Der Feldfacettenspiegel 19 nach den Fig. 32 bis 34 hat wiederum bogenförmige Feldfacetten 25, die in vier Spalten $25_I$, $25_{II}$, $25_{III}$ und $25_{IV}$ nebeneinander angeordnet sind.

Der Feldfacettenspiegel 19 stellt gleichzeitig die optische Verzögerungskomponente 29 bzw. 33 der Beleuchtungsoptik 4 dar.

Die Facettenspalten $25_I$ bis $25_{IV}$ sind in Bezug auf eine Haupt-Reflexionsebene 66 des Feldfacettenspiegels in z-Richtung, also senkrecht zu der Haupt-Reflexionsebene 66, gegeneinander versetzt. Der Versatz benachbarter der Facettenspalten $25_I$ bis $25_{IV}$ beträgt dabei, wie in der Fig. 33 angedeutet $\Delta 1/2$, beträgt also mindestens die Hälfte der Kohärenzdauer $\tau_K$. Für diese Weglängendifferenz gilt, was vorstehend insbesondere im Zusammenhang mit der Ausführung nach Fig. 4 bereits erläutert wurde. Alternativ kann ein Stufenabstand zwischen den Feldfacettenspalten $25_I$ bis $25_{IV}$ auch $\delta l/2$ betragen. Hier gilt, was vorstehend im Zusammenhang mit der Ausführung nach Fig. 7 bereits erläutert wurde.

Der Feldfacettenspiegel wird simultan über einen Scanbereich 67 mit dem Beleuchtungslicht 16 der EUV-Lichtquelle 2 beleuchtet, wie vorstehend beispielsweise im Zusammenhang mit den Scanbereichen 46 und 48 der Ausführungen nach den Fig. 14 bis 17 erläutert wurde. Der Scanbereich 67 hat in der x-Richtung eine Ausdehnung, die der x-Ausdehnung des gesamten Feldfacettenspiegels 19 entspricht. In der y-Richtung hat der Scanbereich 67 eine Ausdehnung, die der y-Ausdehnung jeweils einer der Feldfacetten 25 entspricht.

Aufgrund der Stufenanordnung der Facettenspalten $25_I$ bis $25_{IV}$ ist gewährleistet, dass Beleuchtungslicht-Teilbündel 16;, die über Ausleuchtungskanäle 27 zu verschiedenen Feldfacettenspalten $25_I$ bis $25_{IV}$ geführt werden, nicht störend miteinander interferieren.

Fig. 34 zeigt beispielhaft eine Zuordnung von vier Ausleuchtungskanälen 27 zu den in der Fig. 34 jeweils obersten Feldfacetten 25 der vier Facettenspalten $25_I$ bis $25_{IV}$. Bei der stark schematischen Darstellung nach Fig. 34 sind der Feldfacettenspiegel 19 und der Pupillenfacettenspiegel 20 jeweils in einer Aufsicht dargestellt. Nur diejenigen Pupillenfacetten 28 des Pupillenfacettenspiegels 20 sind in der Fig. 34 gezeigt, die zu den beispielhaft gezeigten vier Ausleuchtungskanälen 27 gehören. Die Kippwinkel der vier diesen Ausleuchtungskanälen 27 zugeordneten Feldfacetten sind so, dass eine punktsymmetrische Anordnung von Pupillenfacetten 28 im Bereich der Anordnungsebene des Pupillenfacettenspiegels 20 ausgeleuchtet wird. Die Zuordnung der Pupillenfacetten 28 zu den Feldfacetten 25 ist zudem derart, dass die den Feldfacetten 25 einer der Feldfacettenspalten $25_I$ bis $25_{IV}$ über jeweilige Ausleuchtungskanäle 27 zugeordnete Pupillenfacetten 28 symmetrisch und gleich verteilt in der Anordnungsebene des Pupillenfacettenspiegels 20 entsprechend dem jeweils gewünschten Beleuchtungssetting angeordnet sind. Eine unerwünschte negative Beeinflussung von Beleuchtungsparametern aufgrund des z-Versatzes der Feldfacettenspalten $25_I$ bis $25_{IV}$ insbesondere auf eine Telezentrie und eine Elliptizität der Beleuchtung kann dann vermindert oder ganz vermieden werden. Definitionen dieser Beleuchtungsparameter Telezentrie und Elliptizität finden sich in der US 8,174,677.

Das Anordnungsbeispiel der Ausleuchtungskanäle 27 nach Fig. 34 gehört zu einem annularen Beleuchtungssetting oder einem Quadrupol-Beleuchtungssetting.

Aufgrund des im Vergleich zu den Ausführungen nach den Fig. 14 bis 17 größeren Scanbereichs 67 ergibt sich ein höherer Durchsatz der Beleuchtungsoptik 4. Zudem können Auswirkungen von Lichtquellenschwankungen auf Beleuchtungsgrößen verringert werden.

**Patentansprüche**

1. Beleuchtungsoptik (4; 26) für die EUV-Projektionslithografie zur Führung von Beleuchtungslicht (16) hin zu einem Beleuchtungsfeld (5), in dem eine Lithografiemaske (7) anordenbar ist,

   - mit einem ersten Facettenspiegel (19) mit einer Mehrzahl von ersten Facetten (25) zur Führung des Beleuchtungslichts (16) hin zum Beleuchtungsfeld (5),
   - wobei jeweils ein Ausleuchtungskanal ($27_i$), der ein Beleuchtungslicht-Teilbündel ($16_i$) führt, durch eine der ersten Facetten (25) vorgegeben ist,
   - wobei über jeweils eine der ersten Facetten (25) genau ein Ausleuchtungskanal ($27_i$) geführt ist,
   - wobei die Beleuchtungsoptik (4;26) derart ausgebildet ist, dass im Betrieb der Beleuchtungsoptik (4;26) beliebige Paare von über verschiedene Ausleuchtungskanäle ($27_i$) geführten Beleuchtungslicht-Teilbündeln ($16_i$), die zum selben Zeitpunkt am selben Punkt des Beleuchtungsfeldes (5) auftreffen, einen gegenseitigen Laufzeitunterschied größer als eine Kohärenzdauer $\tau_K$ des Beleuchtungslichts (16) besitzen,
   - mit einem zweiten Facettenspiegel (20), der dem ersten Facettenspiegel (19) im Strahlengang des Beleuchtungslichts (16) nachgeordnet ist und eine Mehrzahl von zweiten Facetten (28) aufweist, wobei die ersten und zweiten Facetten (25, 28) derart angeordnet sind, dass jeweils ein Ausleuchtungskanal (27), der ein Beleuchtungslicht-Teilbündel ($16_i$) führt, durch eine erste Facette (25) und eine zugeordnete zweite Facette (28) vorgegeben ist, wobei über jeweils eine der Facetten (25, 28) genau ein Ausleuchtungskanal (27) geführt ist.

2. Beleuchtungsoptik nach Anspruch 1, **gekennzeichnet durch** eine Ausführung derart, dass sich abhängig von den Unterschieden in den Weglängen von Strahlengängen der Ausleuchtungskanäle (27) Laufzeit-Differenzen zwischen den Beleuchtungslicht-Teilbündeln ($16_i$) ergeben,

   - wobei für jeden Ort im Beleuchtungsfeld (5) jede Differenz ($\Delta t$) zwischen den Laufzeiten zweier verschiedener Beleuchtungslicht-Teilbündel ($16_i$), gemessen zwischen einem Ort (18) im Strahlengang des Beleuchtungslichts (16) vor dessen Aufteilung in die Beleuchtungslicht-Teilbündel ($16_i$) und dem Beleuchtungsfeld (5), immer größer als eine Kohärenzdauer ($\tau_K$) des Beleuchtungslichts (16) ist.

3. Beleuchtungsoptik nach einem der Ansprüche 1 bis 2, **gekennzeichnet durch** eine

   - optische Verzögerungskomponente (29; 33) zur Aufteilung mindestens eines Beleuchtungslicht-Teilbündels ($16_k$) in eine Mehrzahl von Teilbündel-Komponenten ($16_k^l$), wobei die Teilbündel-Komponenten ($16_k^l$) derartige paarweise Laufzeit-Differenzen untereinander aufweisen, dass jede Differenz ($\Delta t$) zwischen den Laufzeiten der Teilbündel-Komponenten ($16_k^l$) beliebiger Beleuchtungslicht-Teilbündel ($16_k$), gemessen zwischen einem Ort (18) im Strahlengang des Beleuchtungslichts (16), der sowohl vor dessen Aufteilung in die Beleuchtungslicht-Teilbündel ($16_i$) als auch vor der Verzögerungskomponente liegt, und dem Beleuchtungsfeld (5) immer größer ist als die Kohärenzdauer ($\tau_K$) des Beleuchtungslichts (16).

4. Beleuchtungsoptik nach einem der Ansprüche 1 bis 3, wobei der erste Facettenspiegel als Feldfacettenspiegel (19) und der zweite Facettenspiegel als Pupillenfacettenspiegel (20) ausgebildet ist,

- mit einer mit einer Übertragungsoptik (21) zur überlagernden Abbildung der Feldfacetten (25) in das Beleuchtungsfeld (14), die den dem ersten Feldfacettenspiegel (19) nachgeordneten Pupillenfacettenspiegel (20) mit einer Mehrzahl von Pupillenfacetten (28) zur Reflexion jeweils eines der Teilbündel des Beleuchtungslichts (16) aufweist,
- wobei die Beleuchtungsoptik so anordenbar ist, dass am Ort der Pupillenfacetten (28) des Pupillenfacettenspiegels (20) Bilder der Beleuchtungs-Lichtquelle (2) zu liegen kommen,
- wobei der Pupillenfacettenspiegel (20) so verkippt angeordnet ist, dass die verschiedenen Ausleuchtungskanäle, über die jeder der Feldpunkte des Beleuchtungsfeldes (5) mit den Teilbündeln des Beleuchtungslichts (16) beaufschlagbar ist, zwischen der Lichtquelle (2) und jeweils einem der Feldpunkte des Beleuchtungsfeldes (5) jeweils unterschiedliche Ausleuchtungskanallängen aufweisen.

5.  Beleuchtungsoptik nach einem der Ansprüche 1 bis 4, wobei der erste Facettenspiegel als Feldfacettenspiegel (19) und der zweite Facettenspiegel als Pupillenfacettenspiegel (20) ausgebildet ist,

    - mit einer Übertragungsoptik (21) zur überlagernden Abbildung der Feldfacetten (25) in das Beleuchtungsfeld (5), die den dem ersten Feldfacettenspiegel (19) nachgeordneten Pupillenfacettenspiegel (20) mit einer Mehrzahl von Pupillenfacetten (28) zur Reflexion jeweils eines der Teilbündel des Beleuchtungslichts (16) aufweist,
    - wobei die Beleuchtungsoptik so anordenbar ist, dass am Ort der Pupillenfacetten (28) des Pupillenfacettenspiegels (20) Bilder der Beleuchtungs-Lichtquelle (2) zu liegen kommen,
    - wobei eine Haupt-Spiegelfläche (55') des Pupillenfacettenspiegels (20) so von einer ebenen Referenzfläche (55) abweicht, dass die verschiedenen Ausleuchtungskanäle, über die jeder der Feldpunkte des Beleuchtungsfeldes (5) mit den Teilbündeln des Beleuchtungslichtes (16) beaufschlagbar ist, zwischen der Lichtquelle (2) und jeweils einem der Feldpunkte des Beleuchtungsfeldes (5) jeweils unterschiedliche Ausleuchtungskanallängen aufweisen.

6.  Beleuchtungsoptik nach einem der Ansprüche 1 bis 5

    - mit einer Scan-Einrichtung (36), die einen Beleuchtungs-Strahl (16), dessen gesamter Strahlquerschnitt beim Auftreffen auf dem ersten Facettenspiegel (19) größer ist als 20 % einer Reflexionsfläche einer der Facetten (25), über die Facetten (25) des ersten Facettenspiegels (19) derart scannt, dass das Beleuchtungslicht (16) das Beleuchtungsfeld (5) beleuchtet,
- wobei die Scan-Einrichtung (36) derart ausgeführt ist, dass zu jedem gegebenen Zeitpunkt jeweils ein Feldpunkt (42) im Beleuchtungsfeld (5) ausschließlich über jeweils höchstens eine der Facetten (25) beleuchtet wird.

7.  Beleuchtungsoptik nach Anspruch 6, **dadurch gekennzeichnet dass** die Scan-Einrichtung (36) derart ausgeführt ist, dass ein Scanbereich (48; 67) auf dem ersten Facettenspiegel (19) abgerastert wird, der sich über mehrere Facetten (25) erstreckt.

8.  Beleuchtungsoptik nach einem der Ansprüche 1 bis 5,

    - mit einer Scan-Einrichtung (36), die einen Beleuchtungs-Strahl (16), dessen gesamter Strahlquerschnitt beim Auftreffen auf dem ersten Facettenspiegel (19) größer ist als 200 % einer Reflexionsfläche einer der Facetten (25), über die Facetten (25) des ersten Facettenspiegels (19) derart scannt, dass das Beleuchtungslicht (16) das Beleuchtungsfeld (5) beleuchtet,
    - wobei die Scan-Einrichtung (36) derart ausgeführt ist, dass zu jedem gegebenen Zeitpunkt jeweils ein Feldpunkt (42) im Beleuchtungsfeld (5) ausschließlich über Facetten (25) beleuchtet werden, bei denen der optischen Weglängenunterschied sich jeweils um mindestens eine Kohärenzlänge unterscheidet.

9.  Beleuchtungsoptik nach einem der Ansprüche 1 bis 8, **dadurch gekennzeichnet, dass** bei Ausleuchtungskanal-Paaren ($27_i$, $27_j$), für die gilt, daß entlang von ihnen geführtes Beleuchtungslicht an mindestens einem Punkt des Beleuchtungsfeldes (5) so auftritt, daß die zeitliche Differenz ($\Delta t$) kleiner ist als eine Kohärenzdauer ($\tau_K$) des Beleuchtungslichts (16), ein Querschnittsbereich mindestens eines der Ausleuchtungskanäle (27) dieser Ausleuchtungskanal-Paare ($27_i$, $27_j$) nicht zur Beleuchtung des Beleuchtungsfeldes (5) beiträgt.

10. Optisches System mit einer Beleuchtungsoptik nach einem der Ansprüche 1 bis 9 und mit einer EUV-Lichtquelle (2).

11. Projektionsbelichtungsanlage (1) mit einem optischen System nach Anspruch 10 und mit einer Projektionsoptik (10) zur Abbildung eines Objektfeldes, welches im Beleuchtungsfeld (5) angeordnet ist, in ein Bildfeld (11).

12. Verfahren zur Projektionsbelichtung mit folgenden Schritten:

- Bereitstellen einer Projektionsbelichtungsanlage (1) nach Anspruch 11,
- Bereitstellen eines Wafers (13),
- Bereitstellen einer Lithografiemaske (7),
- Projizieren wenigstens eines Teils der Lithografiemaske (7) auf einen Bereich einer lichtempfindlichen Schicht des Wafers (13) mithilfe der Projektionsoptik (10) der Projektionsbelichtungsanlage (1).

**Claims**

1.  Illumination optical unit (4; 26) for EUV projection lithography for guiding illumination light (16) towards an illumination field (5), in which a lithography mask (7) is able to be arranged,

    - comprising a first facet mirror (19) having a plurality of first facets (25) for guiding the illumination light (16) towards the illumination field (5),
    - wherein respectively one illumination channel (27$_i$) which guides an illumination light partial beam (16$_i$) is predefined by one of the first facets (25),
    - wherein exactly one illumination channel (27$_i$) is guided via respectively one of the first facets (25),
    - wherein the illumination optical unit (4; 26) is embodied in such a way that, during the operation of the illumination optical unit (4; 26), any pairs of illumination light partial beams (16$_i$) guided via different illumination channels (27$_i$) which are incident at the same point of the illumination field (5) at the same point in time have a mutual propagation time difference which is greater than a coherence duration $\tau_K$ of the illumination light (16),
    - comprising a second facet mirror (20), which is disposed downstream of the first facet mirror (19) in the beam path of the illumination light (16) and has a plurality of second facets (28), wherein the first and second facets (25, 28) are arranged in such a way that respectively one illumination channel (27) which guides an illumination light partial beam (16$_i$) is predefined by a first facet (25) and an assigned second facet (28), wherein exactly one illumination channel (27) is guided via respectively one of the facets (25, 28).

2.  Illumination optical unit according to Claim 1, **characterized by** an embodiment such that propagation time differences between the illumination light partial beams (16$_i$) arise depending on the differences in the path lengths of beam paths of the illumination channels (27),

    - wherein, for each location in the illumination field (5), each difference ($\Delta t$) between the propagation times of two different illumination light partial beams (16$_i$), measured between a location (18) in the beam path of the illumination light (16) upstream of the splitting thereof into the illumination light partial beam (16$_i$) and the illumination field (5), is always greater than a coherence duration ($\tau_K$) of the illumination light (16).

3.  Illumination optical unit according to either of Claims 1 and 2, **characterized by** an

    - optical retardation component (29; 33) for splitting at least one illumination light partial beam (16$_k$) into a plurality of partial beam components (16$_k^l$), wherein the partial beam components (16$_k^l$) have such pairwise propagation time differences among one another that each difference ($\Delta t$) between the propagation times of the partial beam components (16$_k^l$) of any illumination light partial beams (16$_k$), measured between a location (18) in the beam path of the illumination light (16) which lies both upstream of the splitting thereof into the illumination light partial beams (16$_i$), and upstream of the retardation component, and the illumination field (5) is always greater than the coherence duration ($\tau_K$) of the illumination light (16).

4.  Illumination optical unit according to any of Claims 1 to 3, wherein the first facet mirror is embodied as a field facet mirror (19) and the second facet mirror is embodied as a pupil facet mirror (20),

    - comprising a transfer optical unit (21) for the superposing imaging of the field facets (25) into the illumination field (14), which transfer optical unit comprises the pupil facet mirror (20) disposed downstream of the first field facet mirror (19) and having a plurality of pupil facets (28) for reflecting respectively one of the partial beams of the illumination light (16),
    - wherein the illumination optical unit is able to be arranged in such a way that images of the illumination light source (2) become situated at the location of the pupil facets (28) of the pupil facet mirror (20),
    - wherein the pupil facet mirror (20) is arranged in a tilted manner such that the various illumination channels via which each of the field points of the illumination field (5) is able to be impinged on by the partial beams of the illumination light (16) respectively have different illumination channel lengths between the light source (2) and respectively one of the field points of the illumination field (5).

**5.** Illumination optical unit according to any of Claims 1 to 4, wherein the first facet mirror is embodied as a field facet mirror (19) and the second facet mirror is embodied as a pupil facet mirror (20),

- comprising a transfer optical unit (21) for the superposing imaging of the field facets (25) into the illumination field (5), which transfer optical unit comprises the pupil facet mirror (20) disposed downstream of the first field facet mirror (19) and having a plurality of pupil facets (28) for reflecting respectively one of the partial beams of the illumination light (16),
- wherein the illumination optical unit is able to be arranged in such a way that images of the illumination light source (2) become situated at the location of the pupil facets (28) of the pupil facet mirror (20),
- wherein a main mirror surface (55') of the pupil facet mirror (20) deviates from a plane reference surface (55) such that the various illumination channels via which each of the field points of the illumination field (5) is able to be impinged on by the partial beams of the illumination light (16) respectively have different illumination channel lengths between the light source (2) and respectively one of the field points of the illumination field (5).

**6.** Illumination optical unit according to any of Claims 1 to 5,

- comprising a scanning device (36), which scans an illumination beam (16), the entire beam crosssection of which when incident on the first facet mirror (19) is greater than 20% of a reflection surface of one of the facets (25), over the facets (25) of the first facet mirror (19) in such a way that the illumination light (16) illuminates the illumination field (5),
- wherein the scanning device (36) is embodied in such a way that at any given point in time respectively one field point (42) in the illumination field (5) is illuminated exclusively via at most one of the facets (25) in each case.

**7.** Illumination optical unit according to Claim 6, **characterized in that** the scanning device (36) is embodied in such a way that a scanning region (48; 67) which extends over a plurality of facets (25) is scanned on the first facet mirror (19).

**8.** Illumination optical unit according to any of Claims 1 to 5,

- comprising a scanning device (36), which scans an illumination beam (16), the entire beam crosssection of which when incident on the first facet mirror (19) is greater than 200% of a reflection surface of one of the facets (25), over the facets (25) of the first facet mirror (19) in such a way that the illumination light (16) illuminates the illumination field (5),
- wherein the scanning device (36) is embodied in such a way that at any given point in time respectively one field point (42) in the illumination field (5) is illuminated exclusively via facets (25) in which the optical path length difference respectively differs by at least one coherence length.

**9.** Illumination optical unit according to any of Claims 1 to 8, **characterized in that,** in the case of illumination channel pairs ($27_i$, $27_j$) for which it holds true that illumination light guided along them is incident at at least one point of the illumination field (5) in such a way that the temporal difference ($\Delta t$) is less than a coherence duration ($\tau_K$) of the illumination light (16), a cross-sectional area of at least one of the illumination channels (27) of said illumination channel pairs ($27_i$, $27_j$) does not contribute to the illumination of the illumination field (5).

**10.** Optical system comprising an illumination optical unit according to any of Claims 1 to 9 and comprising an EUV light source (2).

**11.** Projection exposure apparatus (1) comprising an optical system according to Claim 10 and comprising a projection optical unit (10) for imaging an object field, which is arranged in the illumination field (5), into an image field (11).

**12.** Method for projection exposure, comprising the following steps:

- providing a projection exposure apparatus (1) according to Claim 11,
- providing a wafer (13),
- providing a lithography mask (7),
- projecting at least one part of the lithography mask (7) onto a region of a light-sensitive layer of the wafer (13) with the aid of the projection optical unit (10) of the projection exposure apparatus (1).

**Revendications**

**1.** Optique d'éclairage (4 ; 26) pour la lithographie par projection EUV destinée à guider une lumière d'éclairage (16) vers un champ d'éclairage (5) dans lequel un masque lithographique (7) peut être disposé,

- comportant un premier miroir à facettes (19) pourvu d'une pluralité de premières facettes (25) destinées à guider la lumière d'éclairage (16) en direction du champ d'éclairage (5),

- dans laquelle un canal d'éclairage ($27_i$) qui guide un faisceau partiel de lumière d'éclairage ($16_i$) est respectivement prédéfini par l'une des premières facettes (25),

- dans laquelle exactement un canal d'éclairage ($27_i$) est guidé par l'intermédiaire de l'une respective des premières facettes (25),

- dans laquelle l'optique d'éclairage (4 ; 26) est conçue de telle manière que, lors du fonctionnement de l'optique d'éclairage (4 ; 26), des paires quelconques de faisceaux partiels de lumière d'éclairage ($16_i$) guidés par l'intermédiaire de différents canaux d'éclairage ($27_i$) , qui sont incidents au même instant au même point du champ d'éclairage (5), possèdent une différence de temps de propagation mutuelle supérieure à une durée de cohérence $\tau_K$ de la lumière d'éclairage (16),

- comportant un deuxième miroir à facettes (20) qui est disposé en aval du premier miroir à facettes (19) sur le trajet de faisceau de la lumière d'éclairage (16) et qui présente une pluralité de deuxièmes facettes (28), dans laquelle les premières et deuxièmes facettes (25, 28) sont disposées de telle manière qu'un canal d'éclairage (27) qui guide un faisceau partiel de lumière d'éclairage ($16_i$) soit respectivement prédéfini par une première facette (25) et une deuxième facette (28) associée, dans laquelle exactement un canal d'éclairage (27) est guidé par l'intermédiaire de l'une respective des facettes (25, 28) .

2. Optique d'éclairage selon la revendication 1, **caractérisée par** une forme de réalisation telle qu'il en résulte des différences de temps de propagation entre les faisceaux partiels de lumière d'éclairage ($16_i$) en fonction des différences de longueur de trajet de faisceau des canaux d'éclairage (27),

- dans laquelle, pour chaque emplacement dans le champ d'éclairage (5), chaque différence ($\Delta t$) entre les temps de propagation de deux faisceaux partiels de lumière d'éclairage ($16_i$) différents, mesurés entre un emplacement (18) sur le trajet de faisceau de la lumière d'éclairage (16) avant sa division en faisceaux partiels de lumière d'éclairage ($16_i$) et le champ d'éclairage (5), est toujours supérieure à une durée de cohérence ($\tau_K$) de la lumière d'éclairage (16).

3. Optique d'éclairage selon l'une des revendications 1 à 2, **caractérisée par**

- un composant de retard optique (29 ; 33) destiné à diviser au moins un faisceau partiel de lumière d'éclairage ($16_k$) en une pluralité de composantes de faisceau partiel ($16_k{}^1$), dans laquelle les composantes de faisceaux partiels ($16_k{}^1$) présentent entre elles des différences de temps de propagation par paires telles que chaque différence ($\Delta t$) entre les temps de propagation des composantes de faisceaux partiels ($16_k{}^1$) de faisceaux partiels de lumière d'éclairage ($16_k$) quelconques, mesurés entre un emplacement (18) dans le trajet de faisceau de la lumière d'éclairage (16), qui se situe aussi bien avant sa division en faisceaux partiels de lumière d'éclairage ($16_i$) qu'avant le composant de retard, et le champ d'éclairage (5) soit toujours supérieure à la durée de cohérence ($\tau_K$) de la lumière d'éclairage (16) .

4. Optique d'éclairage selon l'une des revendications 1 à 3, dans laquelle le premier miroir à facettes est conçu sous la forme d'un miroir à facettes de champ (19) et le deuxième miroir à facettes est conçu sous la forme d'un miroir à facettes de pupille (20),

- comportant une optique de transmission (21) destinée à former une image superposée des facettes de champ (25) dans le champ d'éclairage (14), qui présente le miroir à facettes de pupille (20) disposé en aval du premier miroir à facettes de champ (19) pourvu d'une pluralité de facettes de pupille (28) destinées à réfléchir respectivement l'un des faisceaux partiels de la lumière d'éclairage (16),

- dans laquelle l'optique d'éclairage peut être disposée de telle manière que des images de la source lumineuse d'éclairage (2) viennent se placer à l'endroit des facettes de pupille (28) du miroir à facettes de pupille (20),

- dans laquelle le miroir à facettes de pupille (20) est disposé de façon basculée de telle manière que les différents canaux d'éclairage, par l'intermédiaire desquels les faisceaux partiels de la lumière d'éclairage (16) peuvent être appliqués à chacun des points de champ du champ d'éclairage (5), présentent des longueurs de canaux d'éclairage respectivement différentes entre la source lumineuse (2) et l'un respectif des points de champ du champ d'éclairage (5).

5. Optique d'éclairage selon l'une des revendications 1 à 4, dans laquelle le premier miroir à facettes est conçu sous la forme d'un miroir à facettes de champ (19) et le deuxième miroir à facettes est conçu sous la forme d'un miroir à facettes de pupille (20),

- comportant une optique de transmission (21) destinée à former une image superposée des facettes de champ (25) dans le champ d'éclairage (5), qui présente le miroir à facettes de pupille (20) disposé en aval du premier miroir à facettes de champ (19) pourvu d'une pluralité de facettes de pupille (28) destinées à réfléchir respectivement l'un des faisceaux partiels de la lumière d'éclairage (16),

- dans laquelle l'optique d'éclairage peut être disposée de telle manière que des images de la source lumineuse d'éclairage (2) viennent se placer à l'endroit des facettes de pupille (28) du miroir à facettes de pupille (20),
- dans laquelle une surface réfléchissante principale (55') du miroir à facettes de pupille (20) s'écarte d'une surface de référence plane (55) de telle manière que les différents canaux d'éclairage, par l'intermédiaire desquels les faisceaux partiels de la lumière d'éclairage (16) peuvent être appliqués à chacun des points de champ du champ d'éclairage (5), présentent des longueurs de canaux d'éclairage respectivement différentes entre la source lumineuse (2) et l'un respectif des points de champ du champ d'éclairage (5).

6. Optique d'éclairage selon l'une des revendications 1 à 5,

- comportant un dispositif de balayage (36) qui anime d'un mouvement de balayage un faisceau d'éclairage (16), dont la section transversale totale est supérieure à 20 % d'une surface de réflexion de l'une des facettes (25), lors de son incidence sur le premier miroir à facettes (19), par l'intermédiaire des facettes (25) du premier miroir à facettes (19), de telle manière que la lumière d'éclairage (16) éclaire le champ d'éclairage (5),
- dans laquelle le dispositif de balayage (36) est conçu de telle manière qu'à chaque instant donné, un point de champ (42) dans le champ d'éclairage (5) soit respectivement éclairé exclusivement par l'intermédiaire d'au plus l'une des facettes (25).

7. Optique d'éclairage selon la revendication 6, **caractérisée en ce que** le dispositif de balayage (36) est conçu de telle manière qu'une zone de balayage (48 ; 67) qui s'étend sur plusieurs facettes (25) soit balayée sur le premier miroir à facettes (19).

8. Optique d'éclairage selon l'une des revendications 1 à 5,

- comportant un dispositif de balayage (36) qui anime d'un mouvement de balayage un faisceau d'éclairage (16), dont la section transversale totale est supérieure à 200 % d'une surface de réflexion de l'une des facettes (25), lors de son incidence sur le premier miroir à facettes (19), par l'intermédiaire des facettes (25) du premier miroir à facettes (19), de telle manière que la lumière d'éclairage (16) éclaire le champ d'éclairage (5),
- dans laquelle le dispositif de balayage (36) est conçu de telle manière qu'à chaque instant donné, un point de champ (42) dans le champ d'éclairage (5) soit respectivement éclairé exclusivement par l'intermédiaire de facettes (25) pour lesquelles la différence de longueur de trajet optique se différencie respectivement d'au moins une longueur de cohérence.

9. Optique d'éclairage selon l'une des revendications 1 à 8, **caractérisée en ce que**, pour des paires de canaux d'éclairage ($27_i$, $27_j$) pour lesquelles il est considéré que la lumière d'éclairage guidée le long de celles-ci est incidente en au moins un point du champ d'éclairage (5) de telle manière que la différence temporelle ($\Delta t$) soit inférieure à une durée de cohérence ($\tau_\kappa$) de la lumière d'éclairage (16), une zone de section transversale d'au moins l'un des canaux d'éclairage (27) de ces paires de canaux d'éclairage ($27_i$, $27_j$) ne contribue pas à l'éclairage du champ d'éclairage (5).

10. Système optique comportant une optique d'éclairage selon l'une des revendications 1 à 9 et comportant une source lumineuse EUV (2).

11. Installation d'exposition par projection (1) comportant un système optique selon la revendication 10 et comportant une optique de projection (10) destinée à former l'image d'un champ objet, qui est disposé dans le champ d'éclairage (5), dans un champ image (11).

12. Procédé d'exposition par projection comprenant les étapes consistant à :

- mettre à disposition une installation d'exposition par projection (1) selon la revendication 11,
- mettre à disposition une plaquette (13),
- mettre à disposition un masque lithographique (7),
- projeter au moins une partie du masque lithographique (7) sur une zone d'une couche photosensible de la plaquette (13) à l'aide de l'optique de projection (10) de l'installation d'exposition par projection (1).

Fig. 1

Fig. 2

EP 2 823 360 B1

Fig. 3

Fig. 4

Fig. 5

$16_1$   $16_2$   $16_5$   $16_4$   $16_6$   $16_3$

t

Fig. 6

EP 2 823 360 B1

33

$16_i$

$\delta l/2$

$31_4$

$31_3$

N

$\alpha$

16

30  $31_1$  $31_2$

Fig. 7

Fig. 8

$16_1^1$ $16_1^2$ $16_1^3$ $16_1^4$ $16_2^1$ $16_2^2$ $16_2^3$ $16_2^4$ $16_5^1$ $16_5^2$ $16_5^3$ $16_5^4$ $16_4^1$ $16_4^2$ $16_4^3$ $16_4^4$ $16_6^1$ $16_6^2$ $16_6^3$ $16_6^4$ $16_3^1$ $16_3^2$ $16_3^3$ $16_3^4$

$\delta l'$

$\Delta t, \delta l'$

$\tau_K$

$t$

EP 2 823 360 B1

35

Fig. 9

EP 2 823 360 B1

Fig. 10

Fig. 11

Fig. 12

Fig. 13

Fig. 14

Fig. 15

Fig. 16

Fig. 17

Fig. 18

Fig. 19

Fig. 20

Fig. 21

Fig. 22

Fig. 24

Fig. 26

Fig. 23

Fig. 25

Fig. 27

Fig. 28

Fig. 29

EP 2 823 360 B1

Fig. 30

Fig. 31

EP 2 823 360 B1

$25_I$　$25$　$25_{II}$　$25_{III}$　$25_{IV}$　$\begin{matrix}19,\\29\\(33)\end{matrix}$

67

Fig. 32

XXXIII

$66$　$25_I$　$25_{II}$　$25_{III}$　$25_{IV}$　$19$

$\Delta l/2$
$(\delta l/2)$

Fig. 33

$25$　$25_I$　$25_{II}$　$25_{III}$　$25_{IV}$　$19$　$\begin{matrix}16_j,\\27\end{matrix}$　$4$　$20$　$28$

Fig. 34

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- EP 1451629 B1
- US 6069739 A
- EP 1521111 A1
- DE 10345430 A1
- WO 2009121438 A1
- DE 10358225 B3
- US 20030043359 A1
- US 5896438 A
- EP 1793278 A2
- US 20070295919 A1
- WO 03048839 A1
- US 20060132747 A1
- EP 1614008 B1
- US 6573978 B
- US 2011001947 A1
- EP 1072957 A2
- US 6859515 B2
- EP 1225481 A
- DE 102008021833 B4
- WO 2009100856 A1
- US 8174677 B

### In der Beschreibung aufgeführte Nicht-Patentliteratur

- **JOSEPH W. GOODMAN.** Speckle Phenomena in Optics. Roberts & Company, 2010